(19) **Europäisches Patentamt European Patent Office Office européen des brevets**

(11) **EP 1 743 340 B1**

(12) **EUROPEAN PATENT SPECIFICATION**

(45) Date of publication and mention
of the grant of the patent:
**23.06.2010 Bulletin 2010/25**

(51) Int Cl.:
***G11C 11/15*** (2006.01)

(21) Application number: **04822056.0**

(22) Date of filing: **03.05.2004**

(86) International application number:
**PCT/US2004/013836**

(87) International publication number:
**WO 2005/117021 (08.12.2005 Gazette 2005/49)**

(54) **NON-VOLATILE PROGRAMMABLE MEMORY**

NICHTFLÜCHTIGER PROGRAMMIERBARER SPEICHER

MEMOIRE PROGRAMMABLE REMANENTE

(84) Designated Contracting States:
**AT BE BG CH CY CZ DE DK EE ES FI FR GB GR HU IE IT LI LU MC NL PL PT RO SE SI SK TR**

(43) Date of publication of application:
**17.01.2007 Bulletin 2007/03**

(60) Divisional application:
**10160690.3**

(73) Proprietor: **Unity Semiconductor Corporation Sunnyvale, CA 94085-4511 (US)**

(72) Inventors:
• **CHEVALLIER, Christophe, J.**
  **Palo ALto, California 94301 (US)**
• **KINNEY, Wayne, I.**
  **Emmett, Idaho 83617 (US)**
• **LONGCOR, Steven, W.**
  **Mountain View, California 94040 (US)**
• **RINERSON, Darrell**
  **Cupertino, California 95014 (US)**
• **SANCHAEZ, John, E. JR.**
  **Palo ALto, California 94306 (US)**
• **SWAB, Philip**
  **Santa Rosa, California 95405 (US)**
• **WARD, Edmond, R.**
  **Monte Sereno, California 95030 (US)**

(74) Representative: **Brown, George Laurence et al Urquhart-Dykes & Lord LLP Tower North Central Merrion Way Leeds LS2 8PA (GB)**

(56) References cited:
**EP-A- 1 376 598    US-A1- 2003 003 675**

• **ZHUANG W W ET AL: "Novel colossal magnetoresistive thin film nonvolatile resistance random access memory (RRAM)" INTERNATIONAL ELECTRON DEVICES MEETING 2002. IEDM. TECHNICAL DIGEST. SAN FRANCISCO, CA, DEC. 8 - 11, 2002, NEW YORK, NY : IEEE, US, 8 December 2002 (2002-12-08), pages 193-196, XP010626021 ISBN: 0-7803-7462-2**

**Description**

Field of the Invention

The present invention relates generally to memory, and more specifically to re-writable non-volatile memory.

Description of the Related Art

Memory can either be classified as volatile or nonvolatile. Volatile memory is memory that loses its contents when the power is turned off. In contrast, non-volatile memory does not require a continuous power supply to retain information. Most non-volatile memories use solid-state memory devices as memory elements.

Certain conductive metal oxides (CMOs), for example, can be used as solid-state memory devices. The CMOs can retain a resistive state after being exposed to an electronic pulse, which can be delivered through two terminals. U.S. Pat. No. 6,204,139, issued March 20, 2001 to Liu et al. describes some perovskite materials that exhibit such characteristics. The perovskite materials are also described by the same researchers in "Electric-pulse-induced reversible resistance change effect in magnetoresistive films," Applied Physics Letters, Vol. 76, No. 19, 8 May 2000, and "A New Concept for Non-Volatile Memory: The Electric-Pulse Induced Resistive Change Effect in Colossal Magnetoresistive Thin Films," in materials for the 2001 Non-Volatile Memory Technology Symposium. However, the materials described in the 6,204,139 patent are not generally applicable to RAM memory because the resistance of the material, when scaled to small dimensions, is considered to be too large to make a memory with fast access times.

In US Pat. No. 6,531,371 entitled "Electrically programmable resistance cross point memory" by Hsu et al. resistive cross point memory devices are disclosed along with methods of manufacture and use. The memory device comprises an active layer of perovskite material interposed between upper electrodes and lower electrodes.

Similarly, the IBM Zurich Research Center has also published three technical papers that discuss the use of metal oxide material for memory applications: "Reproducible switching effect in thin oxide films for memory applications," Applied Physics Letters, Vol. 77, No. 1, 3 July 2000, "Current-driven insulator-conductor transition and nonvolatile memory in chromium-doped SrTi03 single crystals," Applied Physics Letters, Vol. 78, No. 23, 4 June 2001, and "Electric current distribution across a metal-insulator-metal structure during bistable switching," Journal of Applied Physics, Vol. 90, No. 6, 15 September 2001.

The discovery of the resistance-changing property of certain CMOs, however, is relatively recent and has not yet been implemented in a commercial memory product. There are continuing efforts to bring a true non-volatile RAM (nvRAM) to market.

EP-A-1376598 discusses a memory cell and memory device. The memory cell has a variable resister as a memory element. The variable resister is made of a thin-film material such as PCMO. A current controlling device is connected in series with the variable register.

US-A-2003/003675 relates to a shared bit line cross point memory array. A bit line is interposed between top and bottom word lines so that first and second cross points are formed between the bit line and the top and bottom word lines. A material having a property, for example, resistance, that can be changed in response to an input voltage is provided at each cross point.

The paper "Novel Colossal Magnetoresistive Thin Film Nonvolatile Resistance Random Access Memory (RRAM)" by Zhuang et al discusses an RRAM Memory Cell comprising a memory resister having a PCMO resister film and Pt bottom and top electrodes.

According to the present invention there is provided a non-volatile memory as defined in appended claim 1.

BRIEF DESCRIPTION OF THE DRAWINGS

The invention may best be understood by reference to the following description taken in conjunction with the accompanying drawings, in which:

FIG. 1 depicts a perspective view of an exemplary cross point memory array employing a single layer of memory;
FIG. 2 depicts a plan view of selection of a memory cell in the cross point array depicted in FIG.1;
FIG. 3 depicts a perspective view of the boundaries of the selected memory cell depicted in FIG. 2;
FIG. 4A depicts a perspective view of an exemplary stacked cross point memory array employing a four memory layers;
FIG. 4B depicts a schematic diagram of the exemplary stacked cross point memory array depicted in FIG. 4A;
FIG. 5 depicts a schematic diagram of an exemplary stacked cross point memory array employing eight memory layers;
FIG. 6A depicts a schematic diagram of x-direction driver sets in conjunction with the stacked cross point memory of FIG. 4A;

FIG. 6B depicts a schematic diagram of y-direction driver sets in conjunction with the stacked cross point memory of FIG. 4A;

FIG. 7A depicts the general layout of the x-direction and y-direction driver sets depicted in

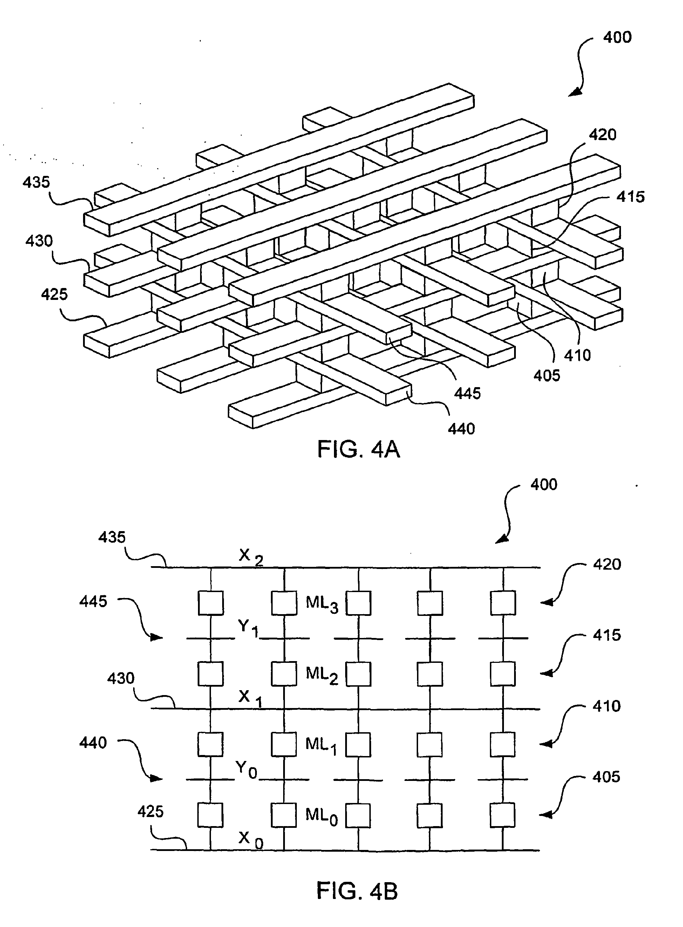

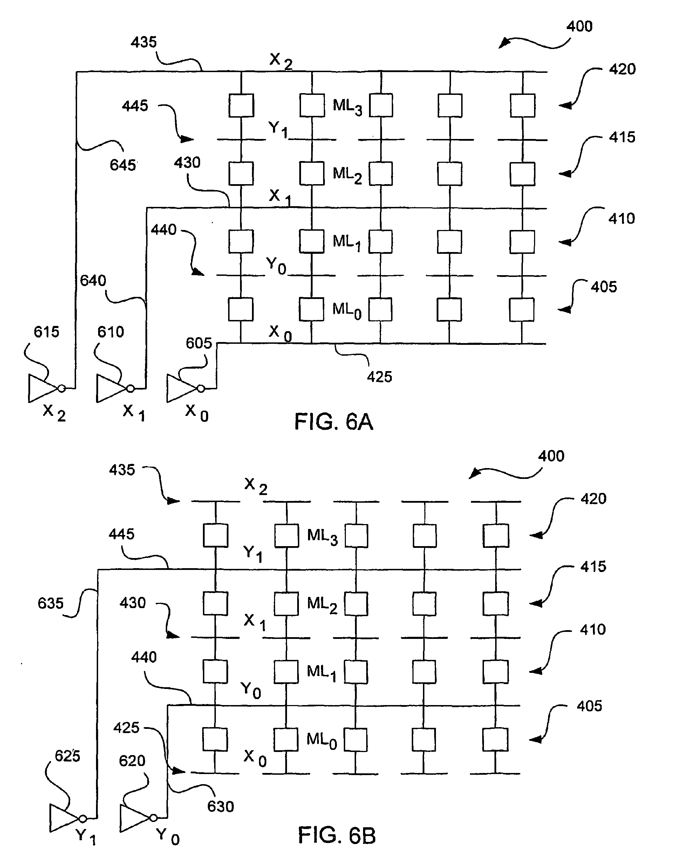

FIG. 6A and FIG. 6B in relation to the stacked cross point array depicted in FIG. 4A;

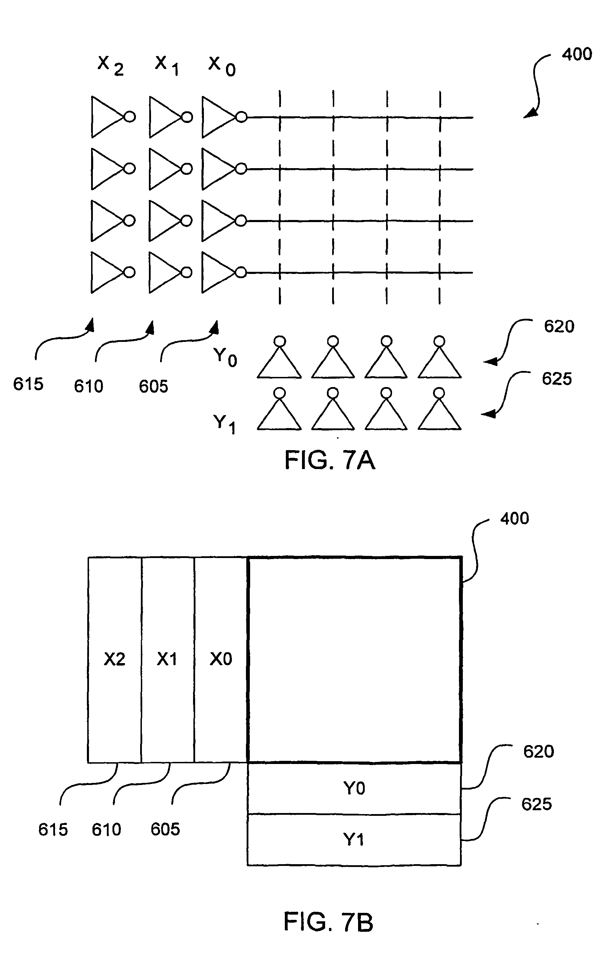

FIG. 7B depicts an abstracted representation of FIG. 7A;

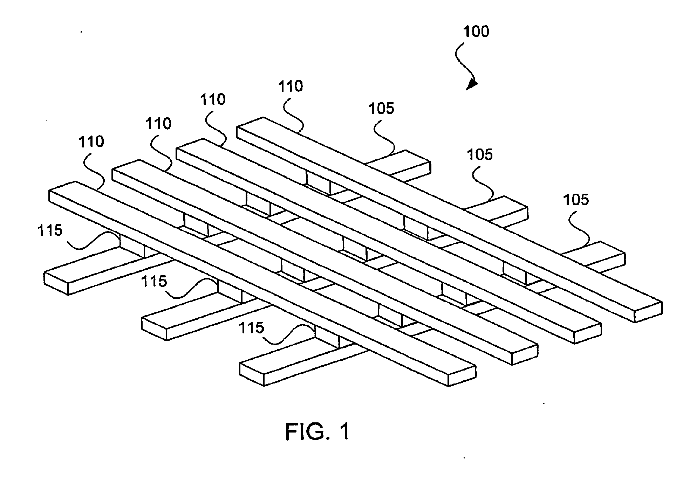

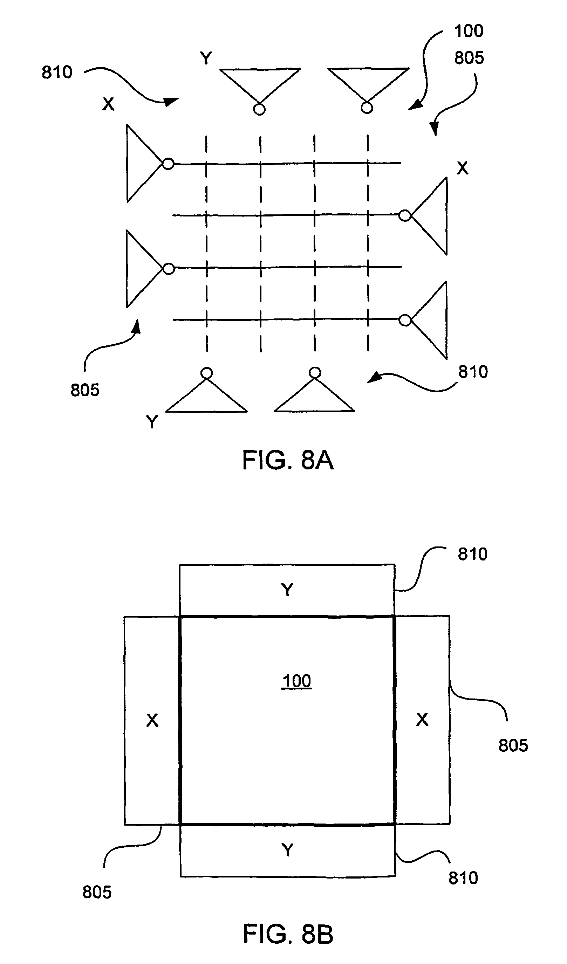

FIG. 8A depicts the general layout of interdigitated x-direction and y-direction driver in relation to the single layer cross point array depicted in FIG.1;

FIG. 8B depicts an abstracted representation of FIG. 8A;

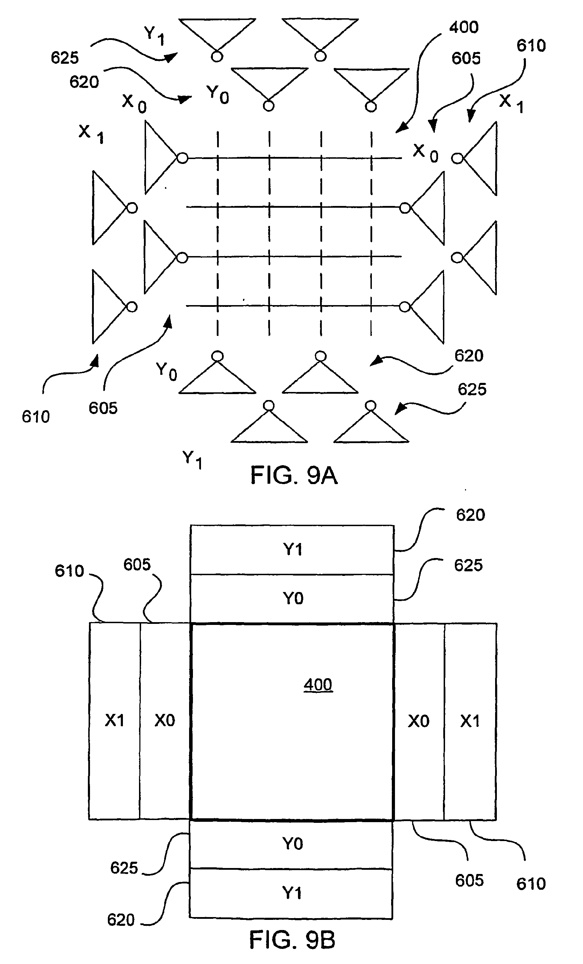

FIG. 9A depicts the general layout of interdigitated x-direction and y-direction driver in relation to the stacked cross point array depicted in FIG. 4A;

FIG. 9B depicts an abstracted representation of FIG. 9A;

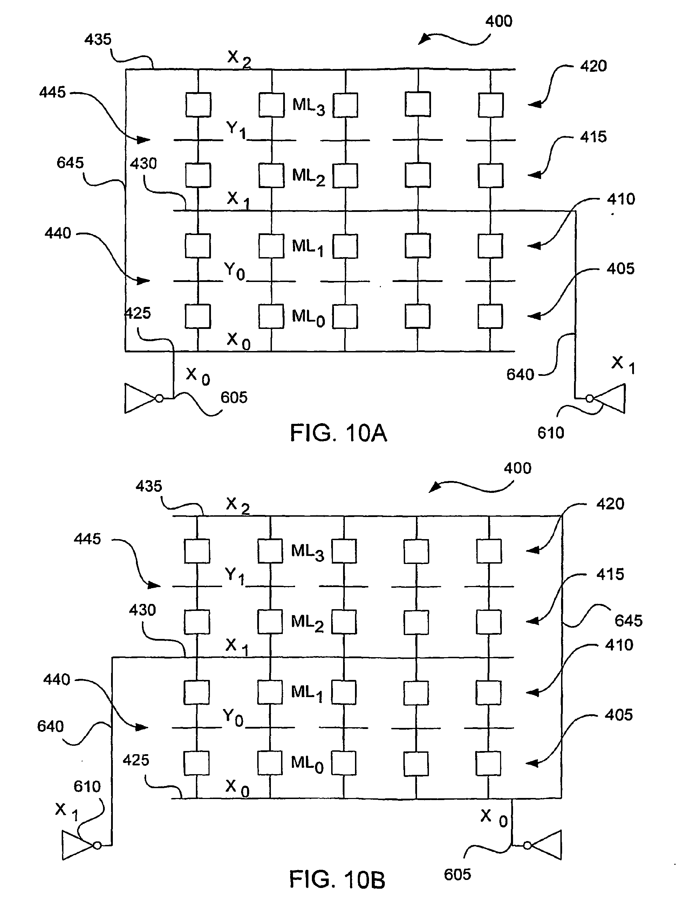

FIG. 10A and FIG. 10B depicts a schematic diagram of alternating x-direction driver sets in conjunction with the stacked cross point memory of FIG. 4A;

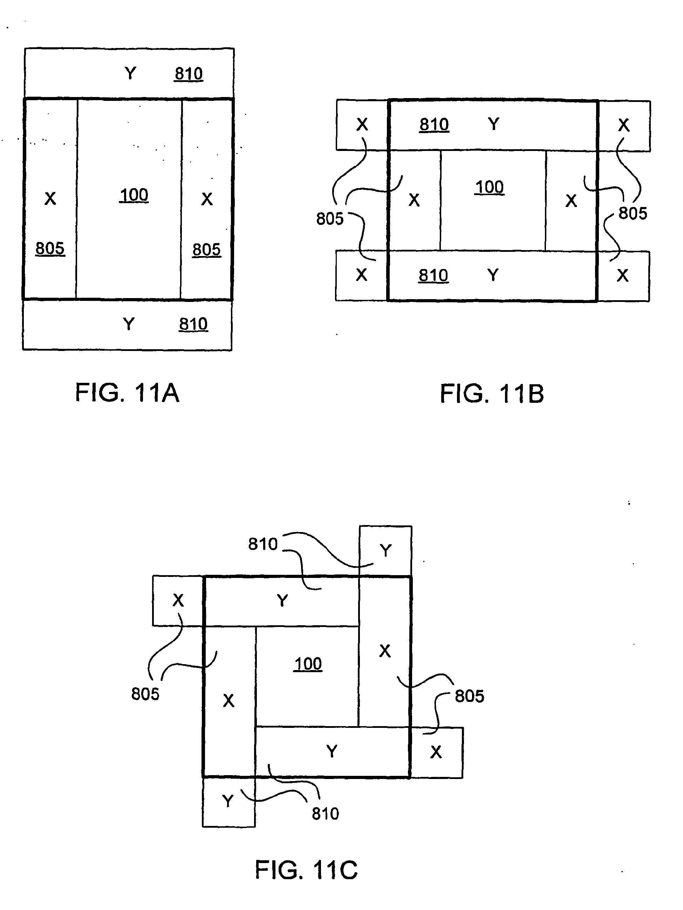

FIGs. 11A through 11C depict various layouts of the x-direction and y-direction driver sets that have some drivers underneath the single-layer cross point array depicted in FIG. 1;

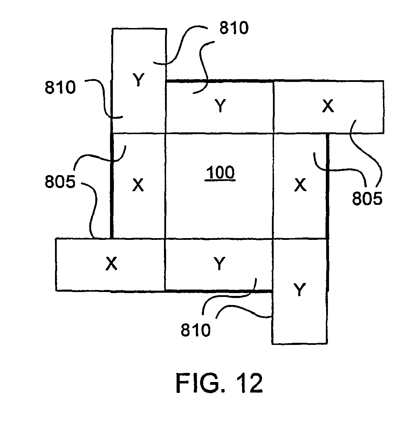

FIG. 12 depicts a layout of the x-direction and y-direction driver sets that interdigitate some drivers but not others such that some drivers are underneath the single-layer cross point array depicted in FIG. 1;

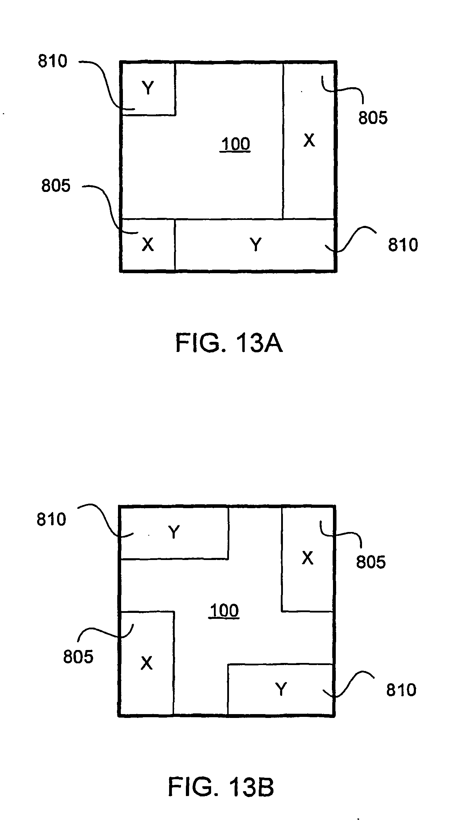

FIG. 13A depicts a layout of an x-direction driver set and a y-direction driver set that completely fits underneath the single-layer cross point array depicted in FIG. 1;

FIG. 13B depicts another layout of an x-direction driver set and a y-direction driver set that completely fits underneath the single-layer cross point array depicted in FIG. 1;

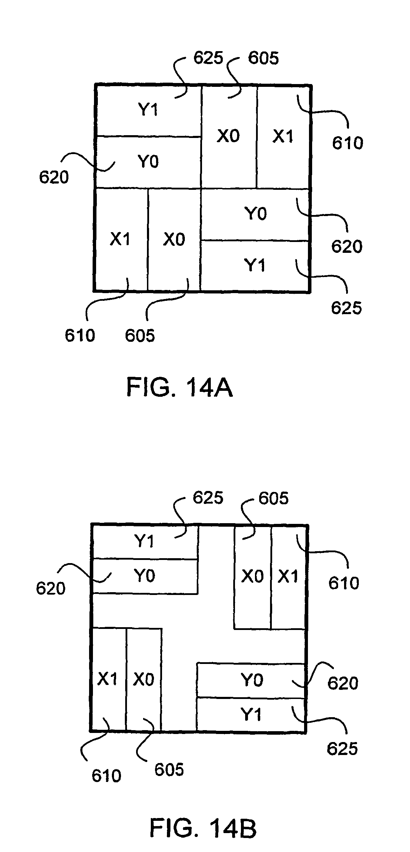

FIG. 14A depicts a layout of x-direction driver sets and a y-direction driver sets that completely fits underneath the stacked cross point array depicted in FIG. 4A;

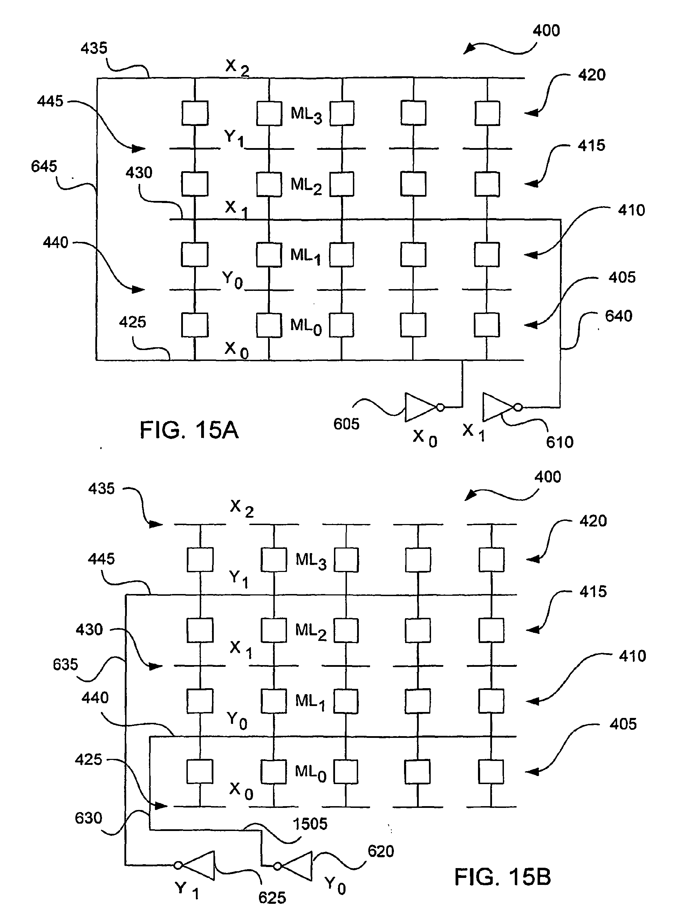

FIG. 14B depicts a layout of x-direction driver sets and a y-direction driver sets that leaves empty gaps underneath the single-layer cross point array depicted in FIG. 4A; FIG. 15A depicts a schematic diagram of x-direction driver sets in conjunction with the stacked cross point memory of FIG. 4A;

FIG. 15B depicts a schematic diagram of y-direction driver sets in conjunction with the stacked cross point memory of FIG. 4A;

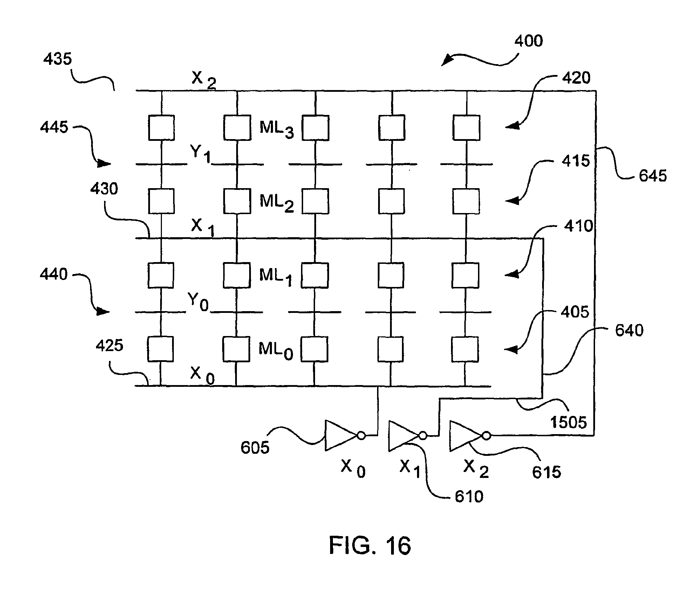

FIG. 16 depicts an alternative schematic diagram of x-direction driver sets in conjunction with the stacked cross point memory of FIG. 4A that uses separate drivers that operate on identical logic;

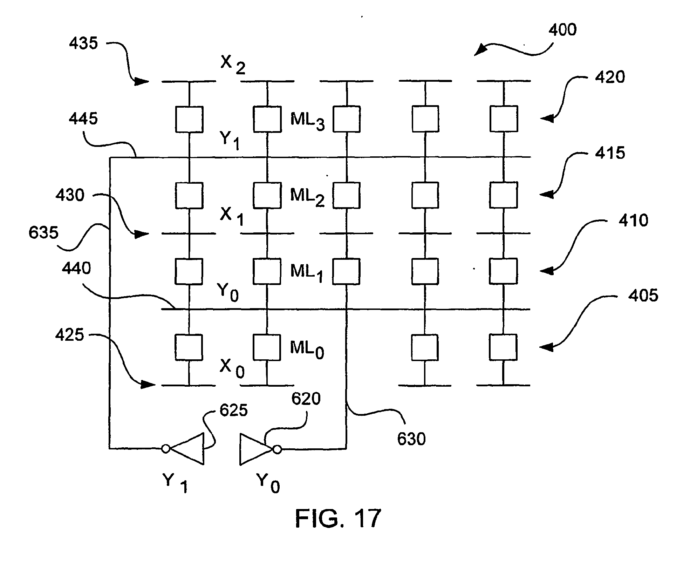

FIG. 17 depicts an alternative schematic diagram of y-direction driver sets in conjunction with the stacked cross point memory of FIG. 4A that eliminates the need for additional metal layers;

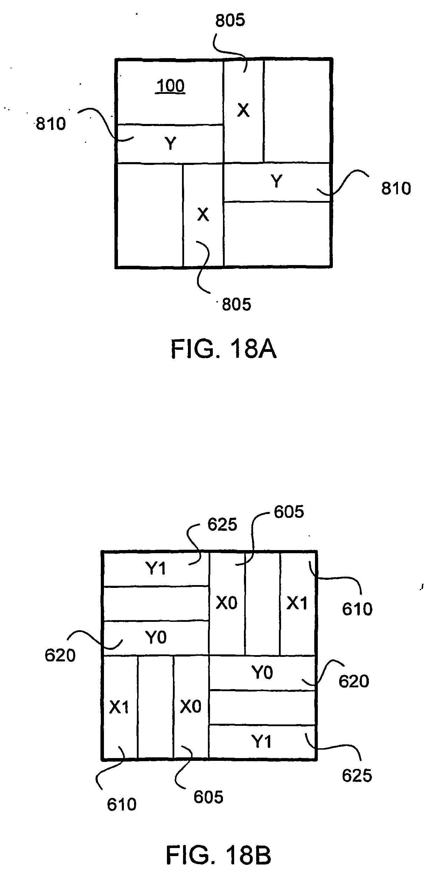

FIG. 18A depicts a layout of an x-direction driver set and a y-direction driver set that connects to the single-layer cross point array depicted in FIG. 1;

FIG. 18B depicts a layout of multiple x-direction driver sets and y-direction driver sets that connects to the stacked cross point array depicted in FIG. 4A;

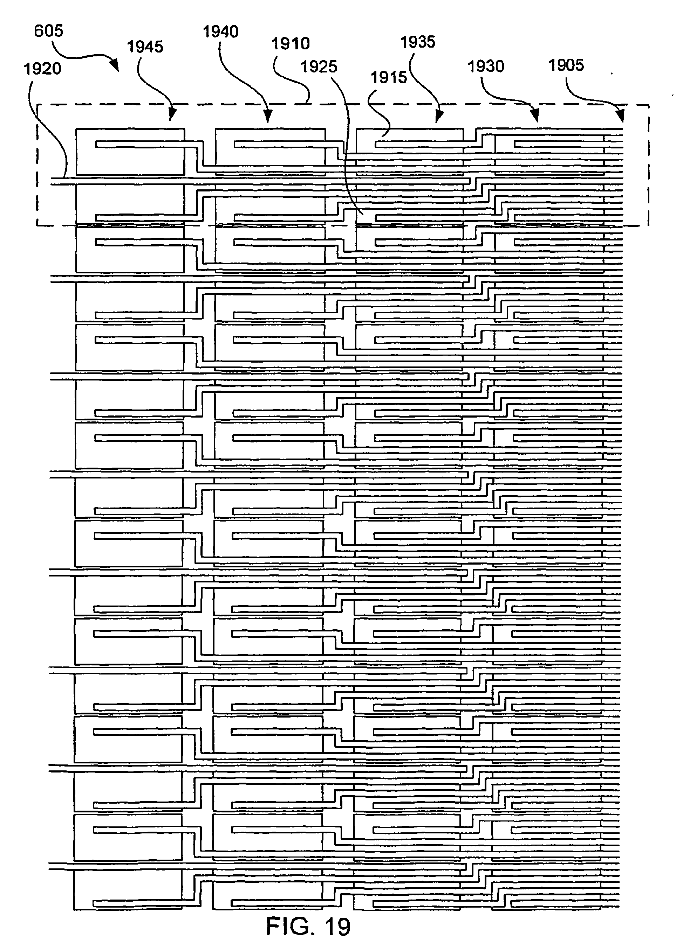

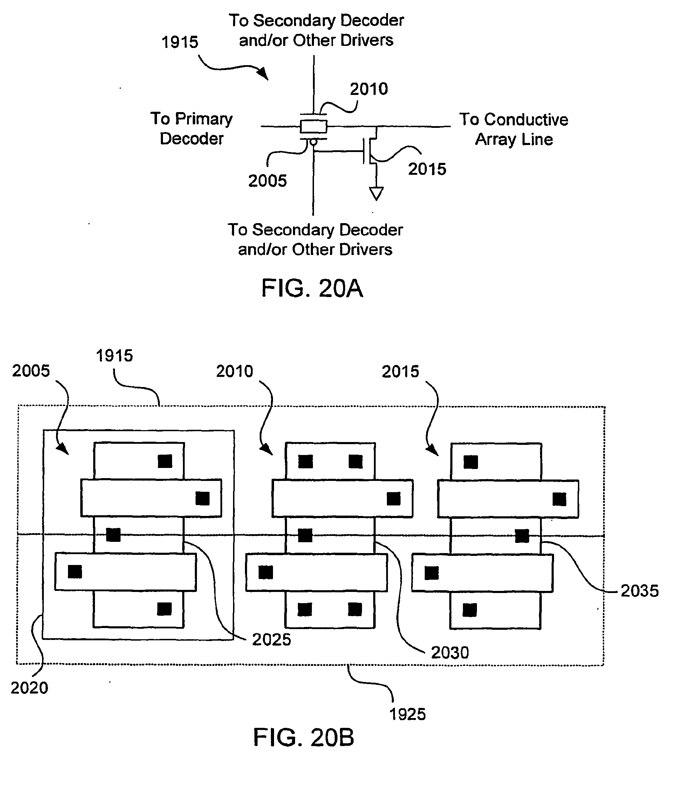

FIG. 19 depicts a layout of the X0 driver set that fit within the necessary line pitch; FIG. 20A depicts a driver schematic in which the driver requires access to a primary decoder, a secondary decoder, and a reference voltage;

FIG. 20B depicts a layout of the three transistors depicted in FIG. 20A;

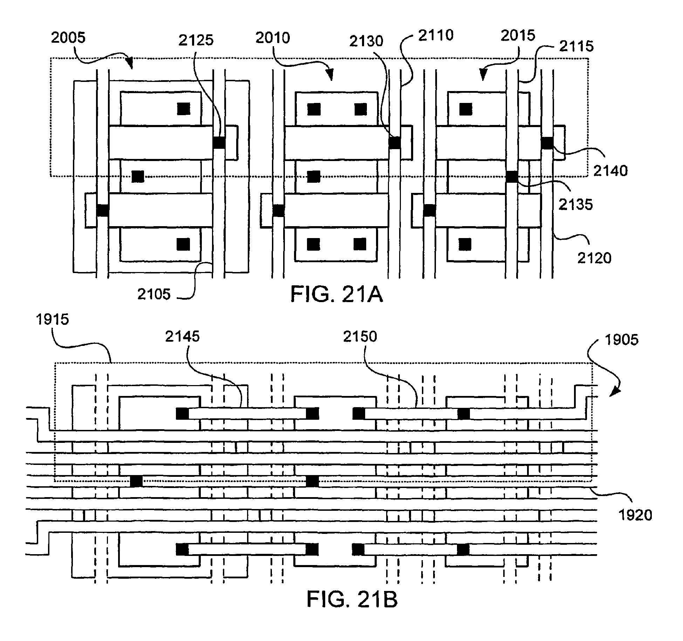

FIG. 21A depicts the driver depicted in FIG. 20B after a first metal layer is deposited; FIG. 21B depicts the driver depicted in FIG. 21A after a second metal layer is deposited;

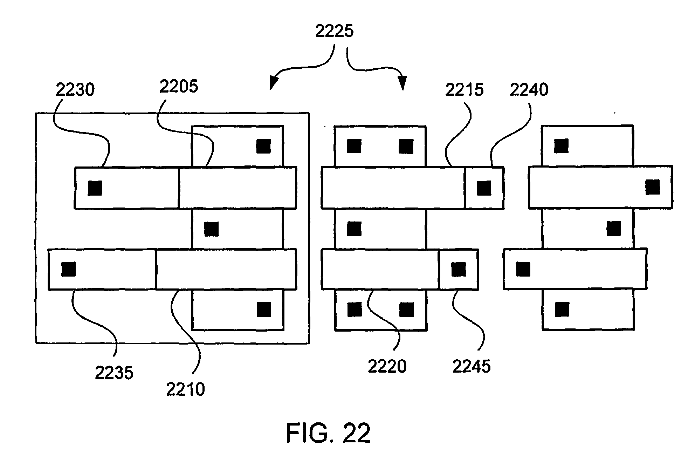

FIG. 22 depicts a layout of the last stage of drivers;

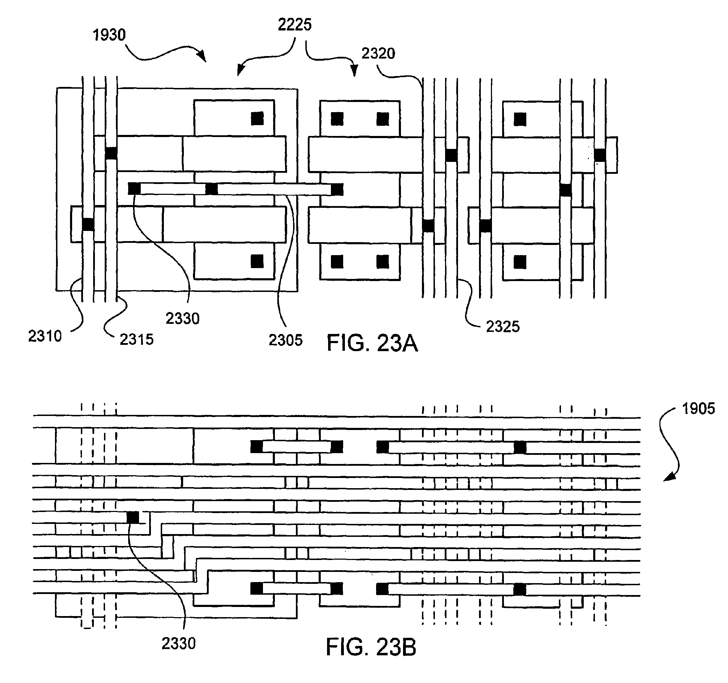

FIG. 23A depicts the driver depicted in FIG. 22 after a first metal layer is deposited; FIG. 23B depicts the driver depicted in FIG. 23A after a second metal layer is deposited;

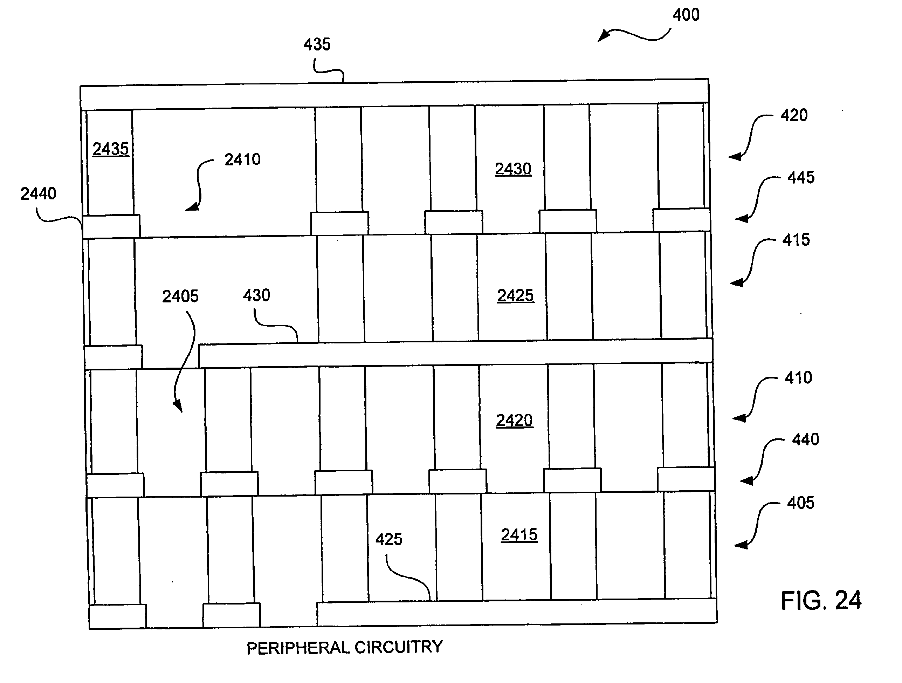

FIG. 24 depicts a cross section of the stacked cross point array of FIG. 4A;

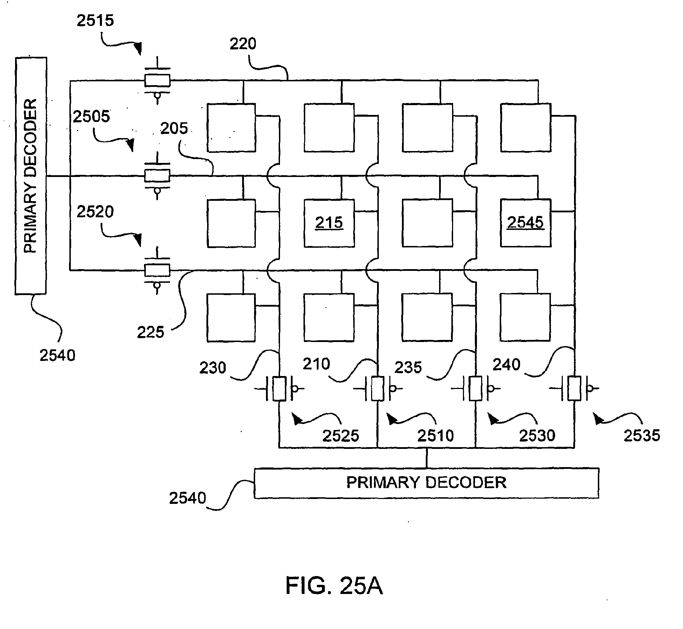

FIG. 25A depicts a block diagram depicting the logical connections of various systems that contribute to selecting a memory plug;

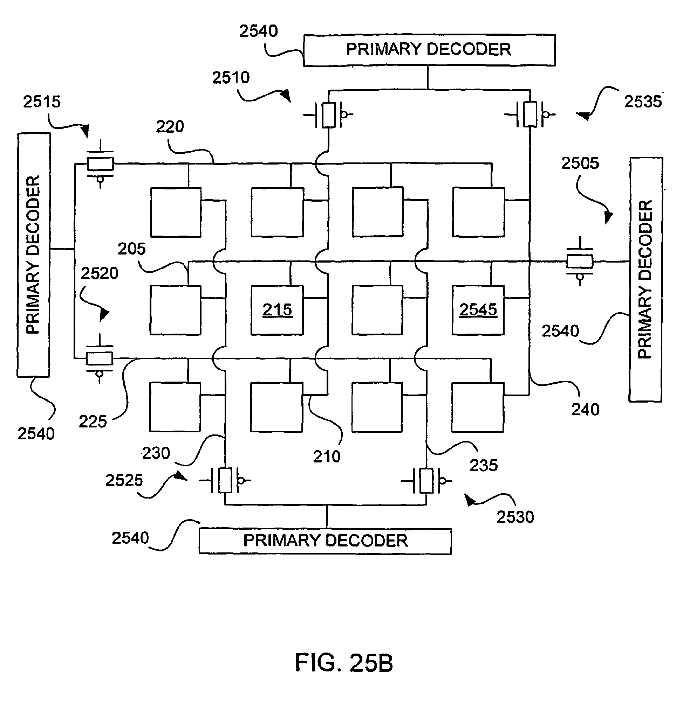

FIG. 25B depicts a block diagram depicting the physical connections of the various systems that contribute to selecting a memory plug;

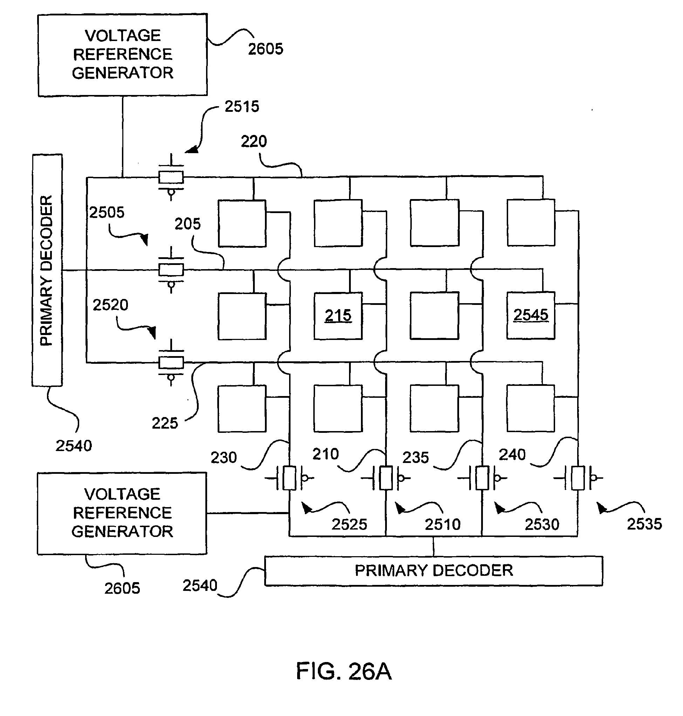

FIG. 26A depicts a block diagram depicting one mechanism for preventing the unselected conductive array lines from floating to an undesired voltage;

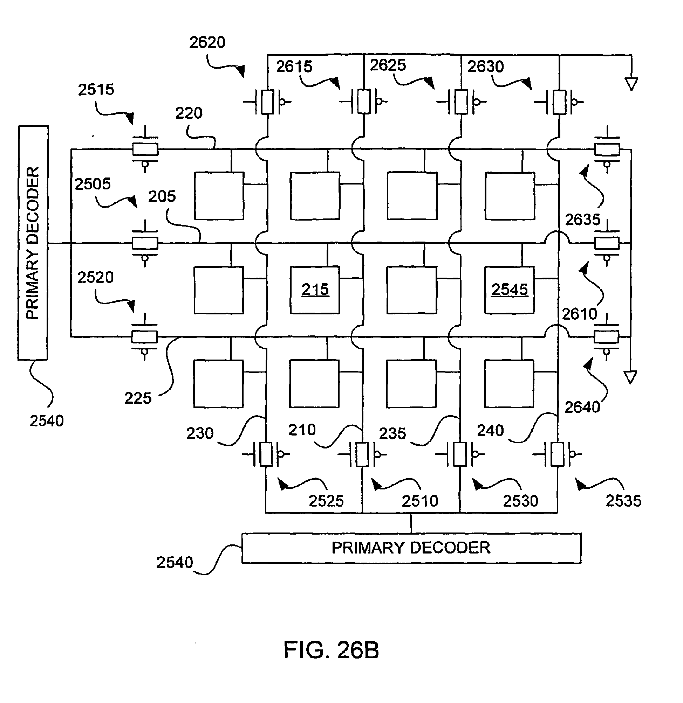

FIG. 26B depicts a block diagram depicting another mechanism for preventing the unselected conductive array lines from floating to an undesired voltage;

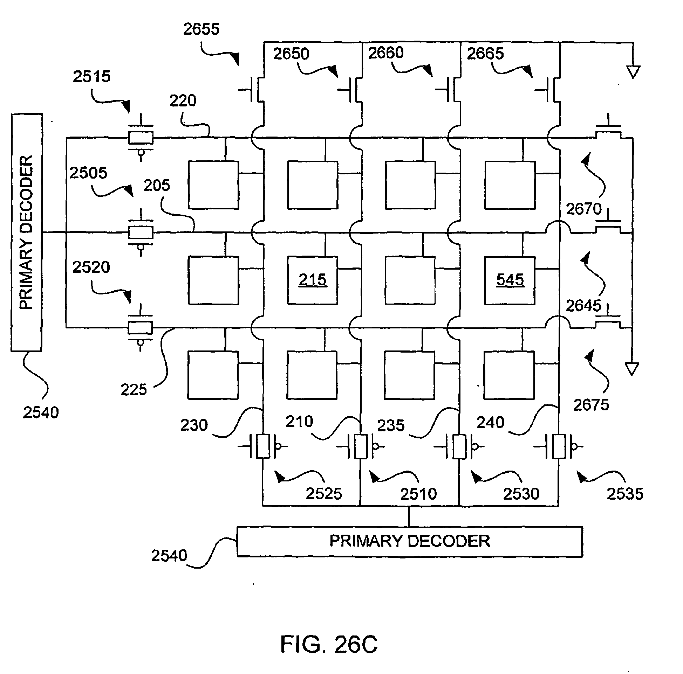

FIG. 26C depicts a block diagram depicting an improvement on the mechanism for preventing the unselected conductive array lines from floating to an undesired voltage depicted in FIG. 26B;

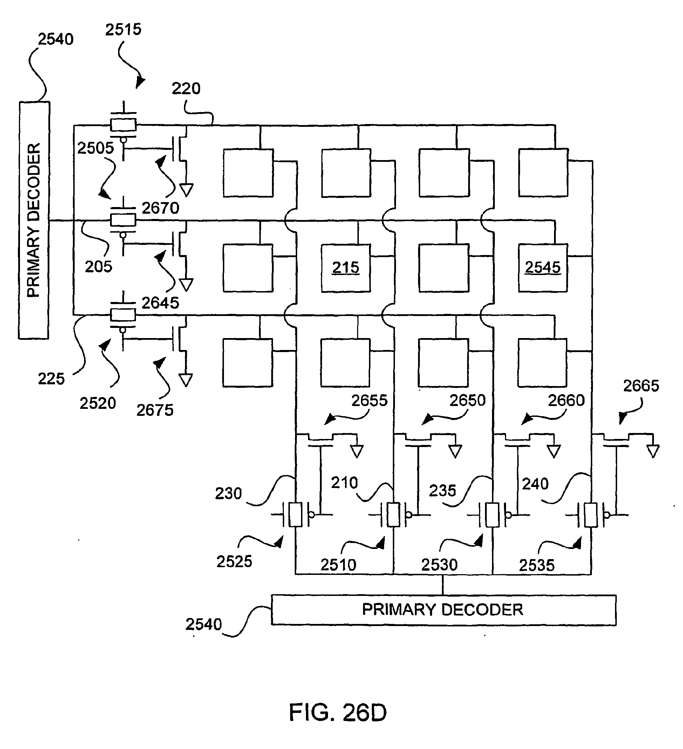

FIG. 26D depicts a block diagram depicting an improvement on the mechanism for preventing the unselected conductive array lines from floating to an undesired voltage depicted in FIG. 26C;

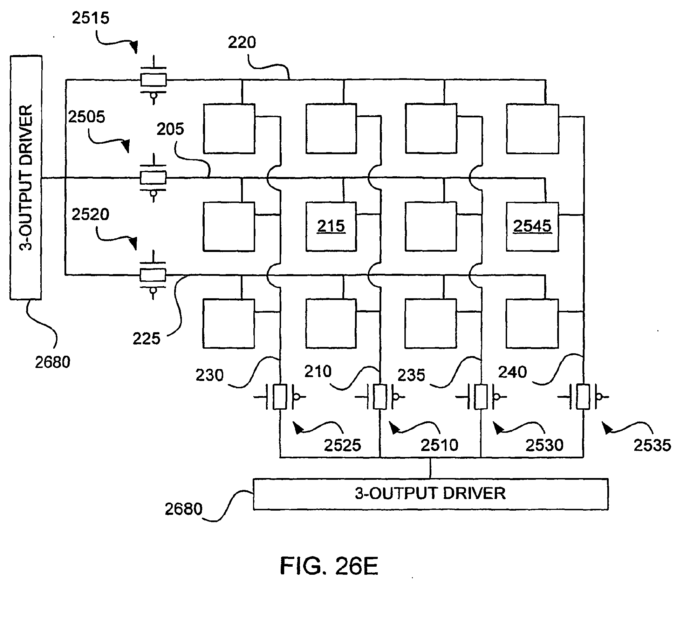

FIG. 26E depicts a block diagram depicting yet another mechanism for preventing the unselected conductive array lines from floating to an undesired voltage by using a 3-output driver;

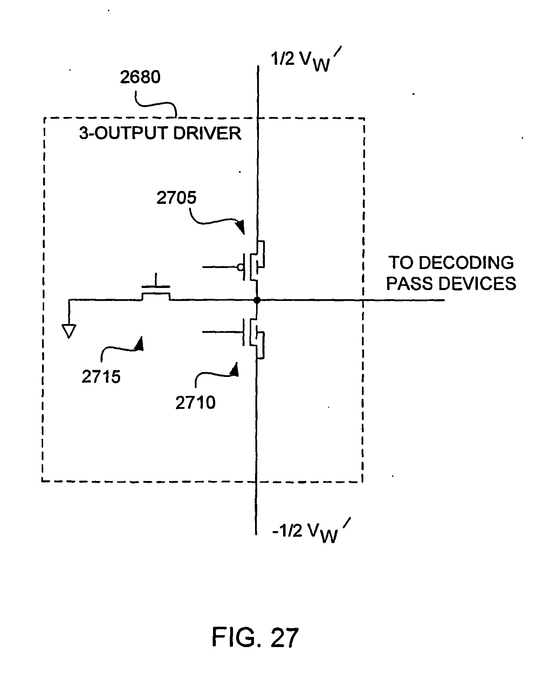

FIG. 27 depicts a block diagram depicting one possible configuration of a 3-output driver;

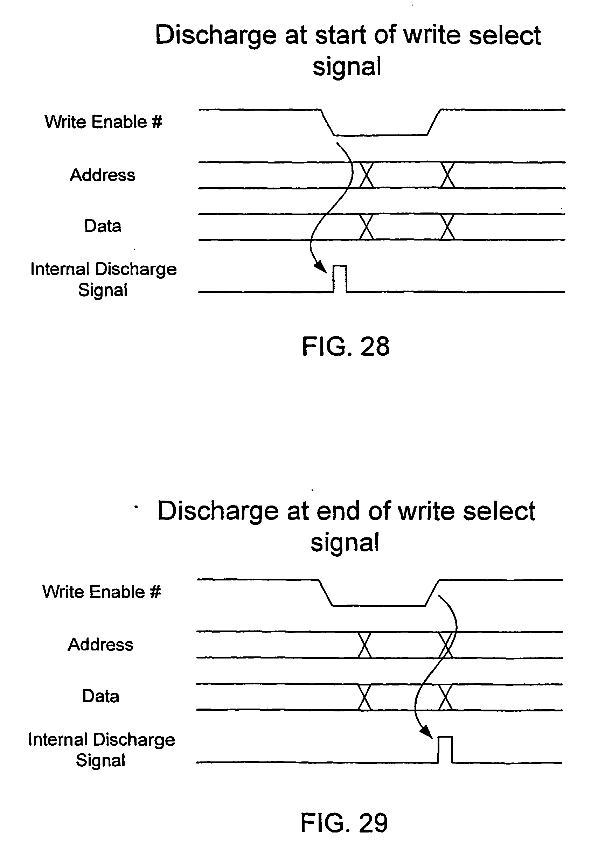

FIG. 28 depicts a timing diagram showing the falling edge of the write select signal being used to discharge the array lines;

FIG. 29 depicts a timing diagram showing the falling edge of the write select signal being used to discharge the conductive array lines;

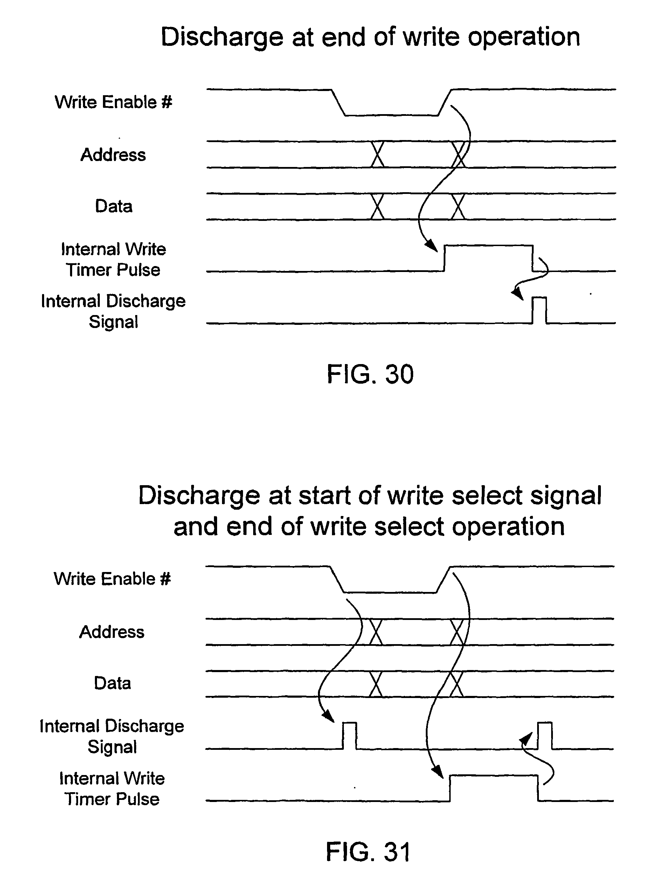

FIG. 30 depicts a timing diagram showing the conductive array lines being discharged at the end of a write operation;

FIG. 31 depicts a timing diagram showing the array lines being discharged both as the write mode is selected and at the end of the write operation, as defined by an internal write timer pulse;

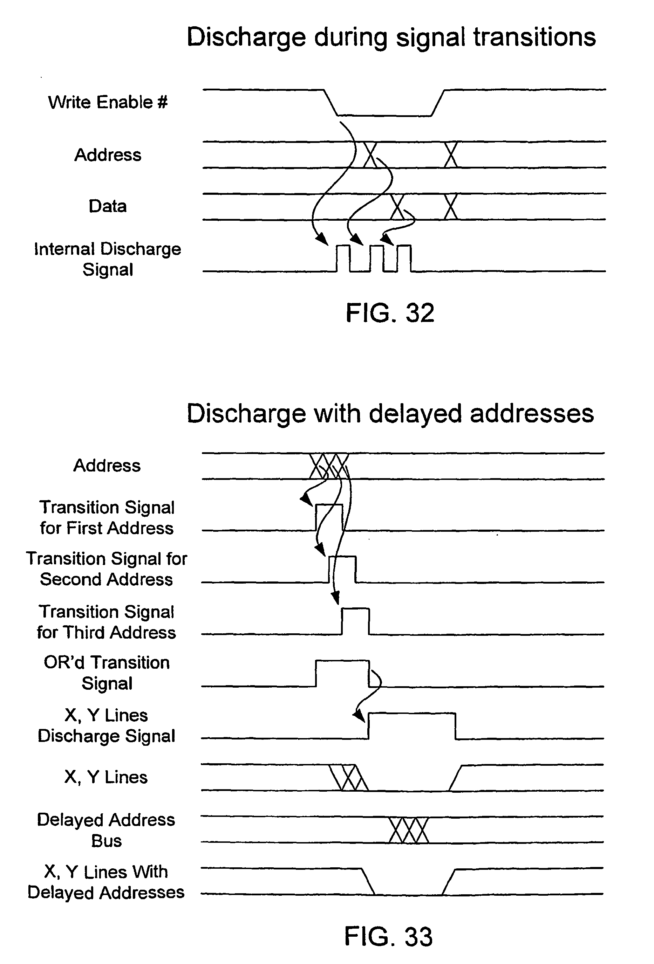

FIG. 32 depicts a timing diagram showing the array lines being discharged by the write select signal falling edge, data or address transitions;

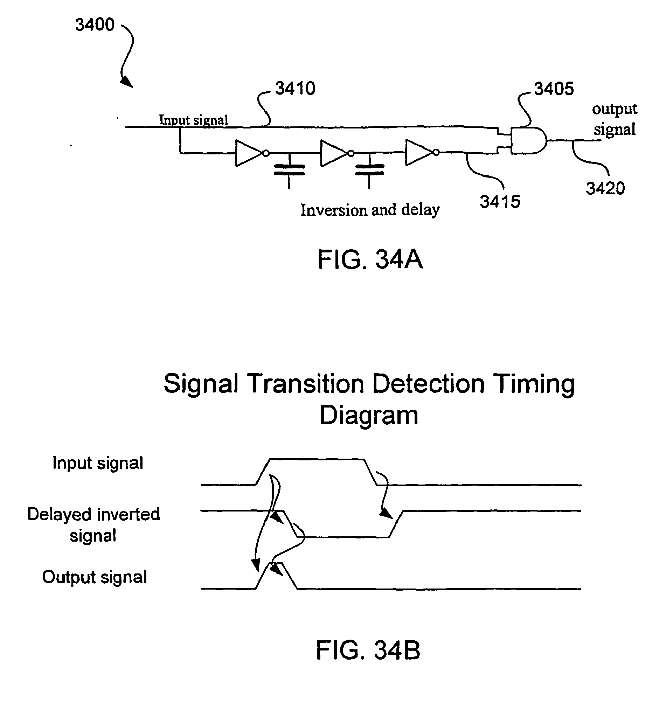

FIG. 33 depicts a timing diagram with multiple addresses switching at different times; FIG. 34A depicts an exemplary schematic of a detection circuit;

FIG. 34B depicts the timing of the detection circuit of FIG. 34A;

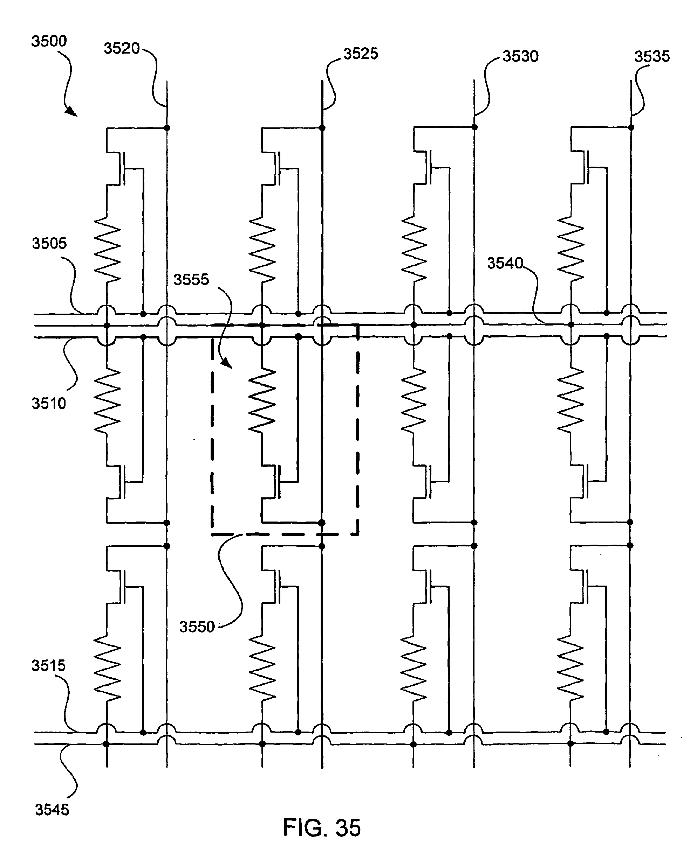

FIG. 35 depicts a schematic representation of memory cells laid out in a two-dimensional transistor memory array;

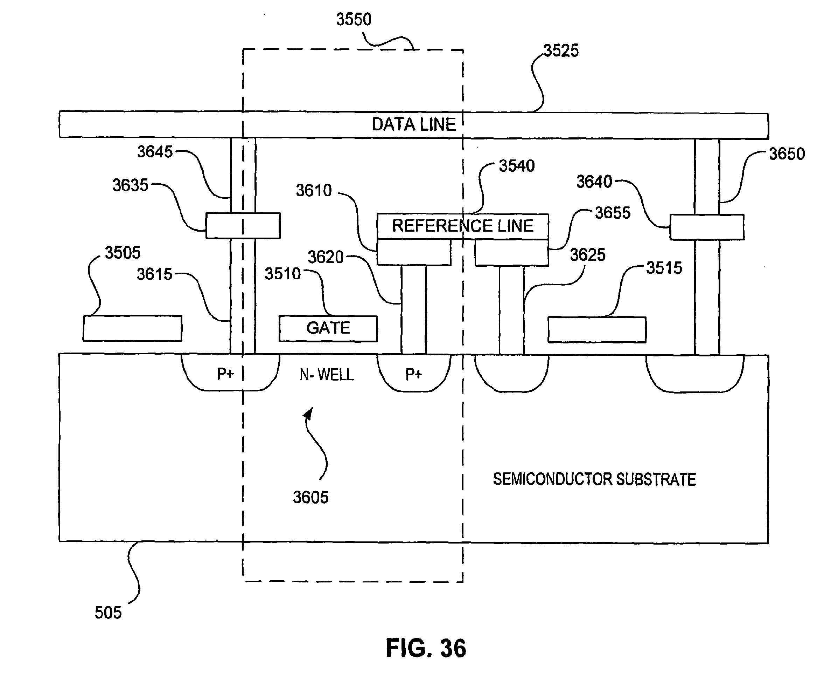

FIG. 36 depicts a diagrammatic cross sectional representation of a memory cell that can be used in the transistor memory array of FIG. 35;

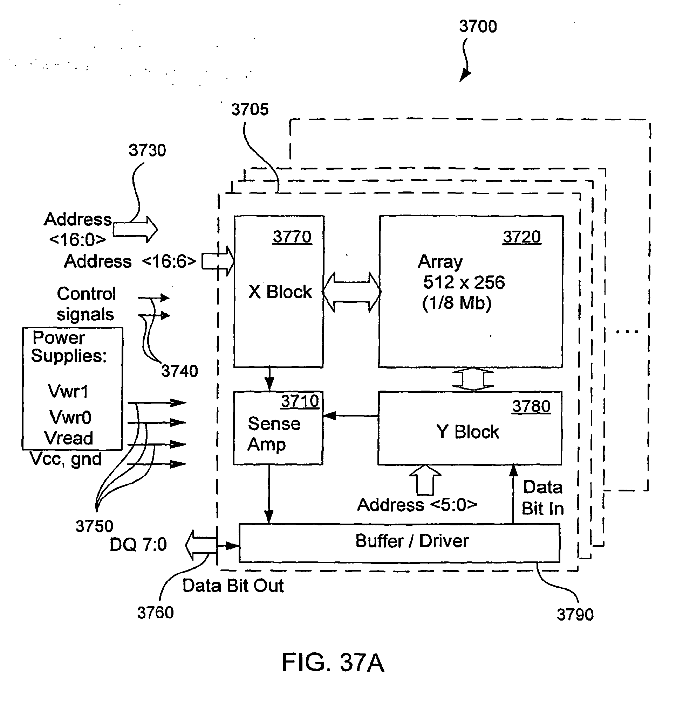

FIG. 37A depicts a block diagram of a representative implementation of an exemplary 1 MB memory;

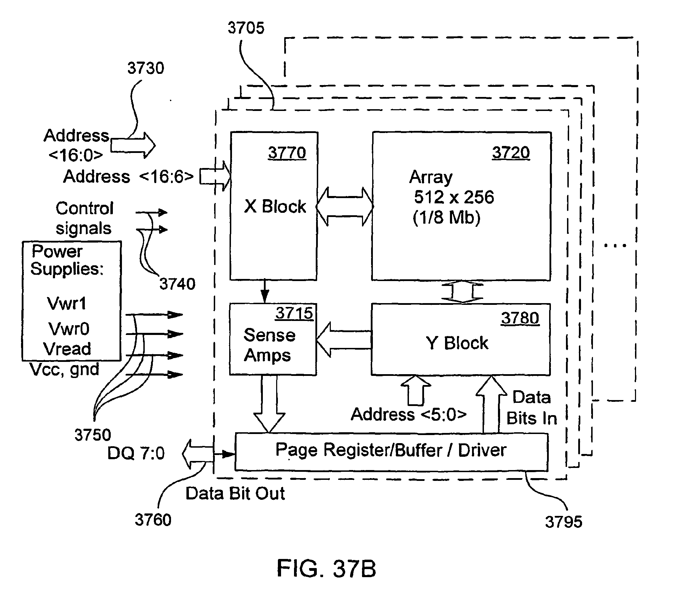

FIG. 37B depicts a block diagram of an exemplary memory that includes sensing circuits that are capable of reading multiple bits;

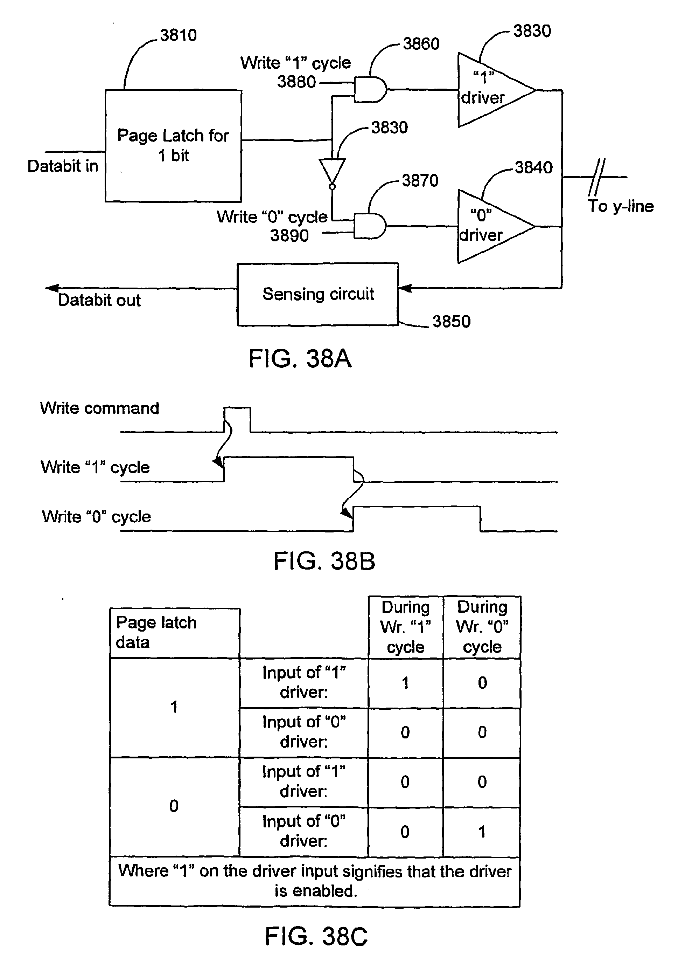

FIG. 38A depicts a page latch circuit for writing information in page mode and burst mode in accordance with an embodiment of the invention;

FIG. 38B depicts write command signals for writing information in page mode and burst mode in accordance with an embodiment of the invention;

FIG. 38C depicts a diagram of write signal input and corresponding output when writing information in page mode and burst mode in accordance with an embodiment of the invention;

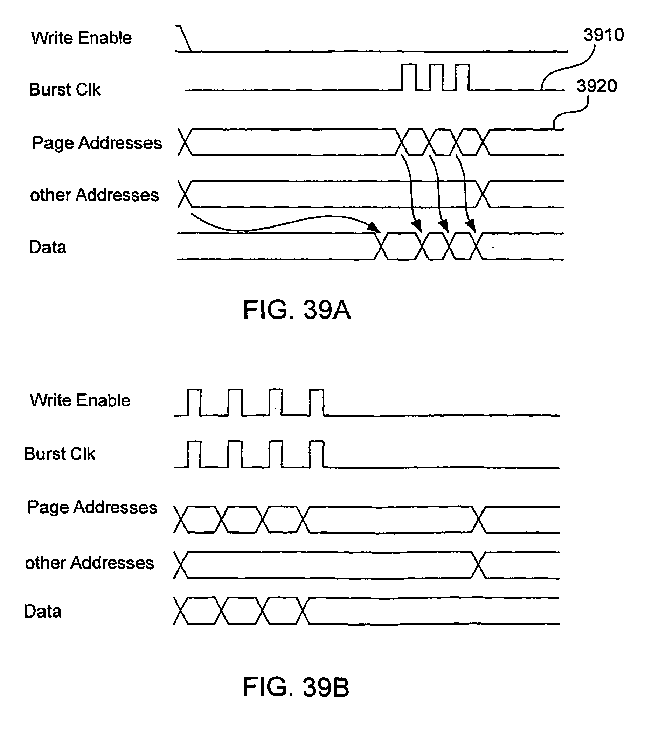

FIG. 39A depicts input and data signals for reading information in page or burst mode;

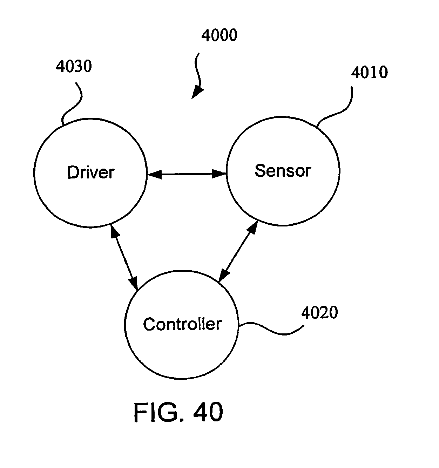

FIG. 39B depicts input and data signals for writing information in page or burst mode; FIG. 40 depicts a high-level conceptual diagram of an adaptive programming circuit of the present invention;

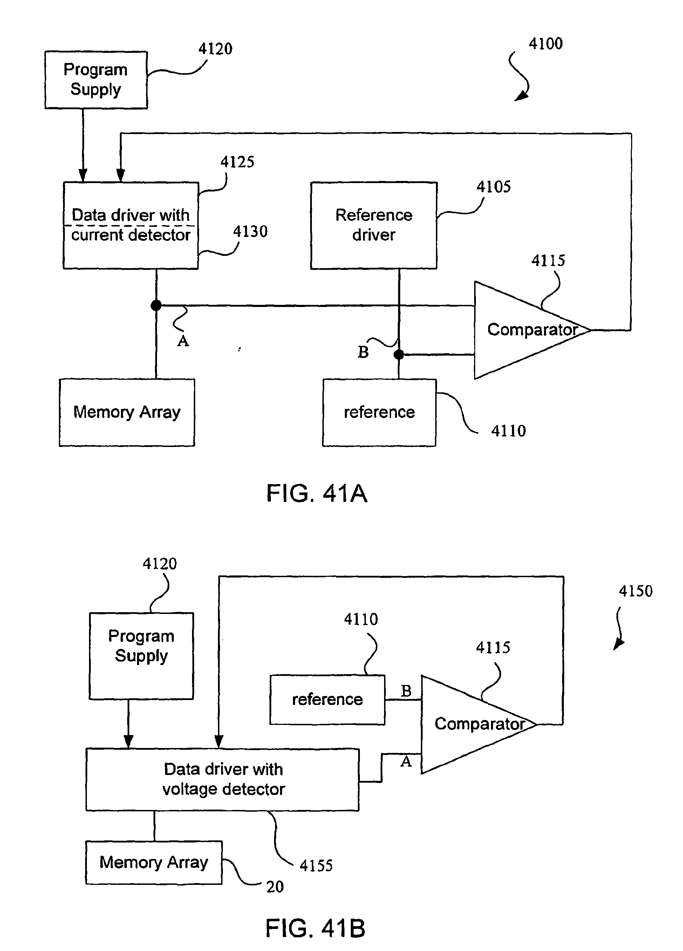

FIG. 41A depicts a first more detailed embodiment of the adaptive programming circuit using a comparator;

FIG. 41B depicts a second more detailed embodiment of the adaptive programming circuit using a comparator;

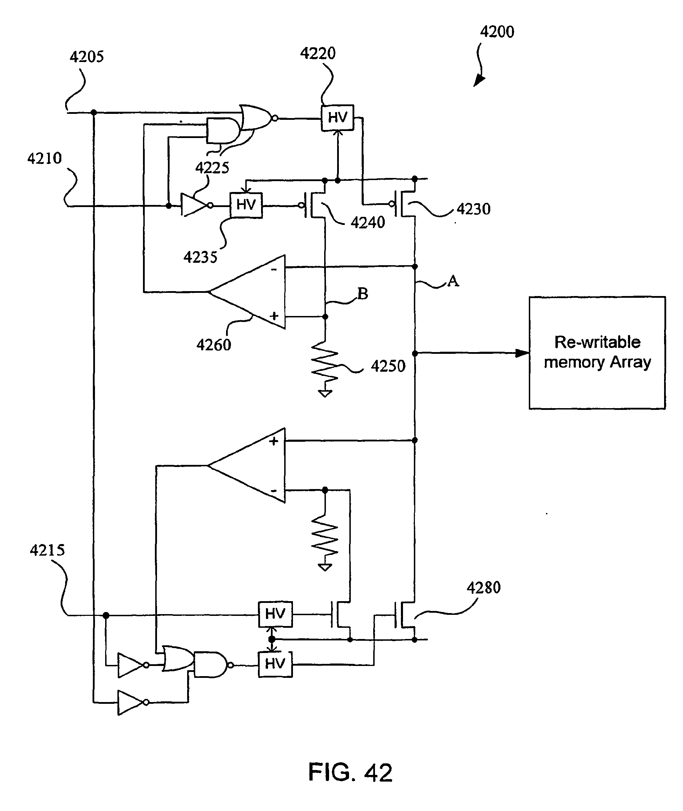

FIG. 42 depicts a third circuit schematic level embodiment of the adaptive programming circuit with a bipolar voltage drive, a current comparison circuitry and an activating logic;

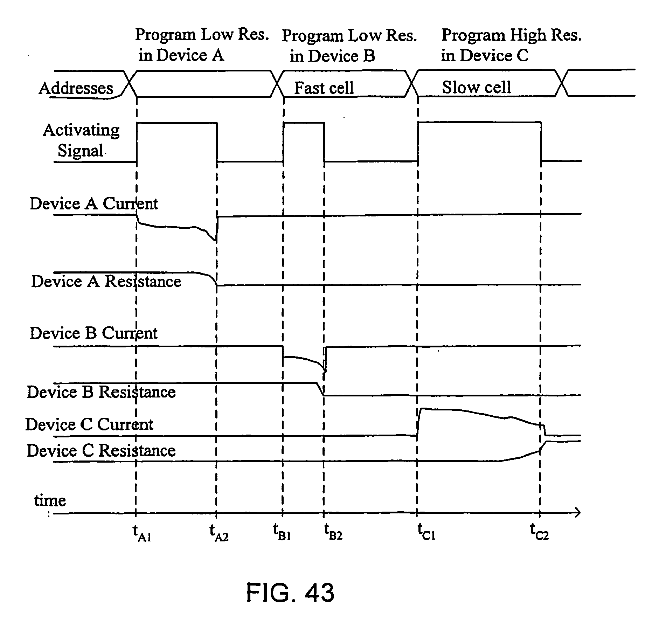

FIG. 43 depicts an exemplary timing diagram of signals and device currents during an application of the present invention in a re-writable memory array;

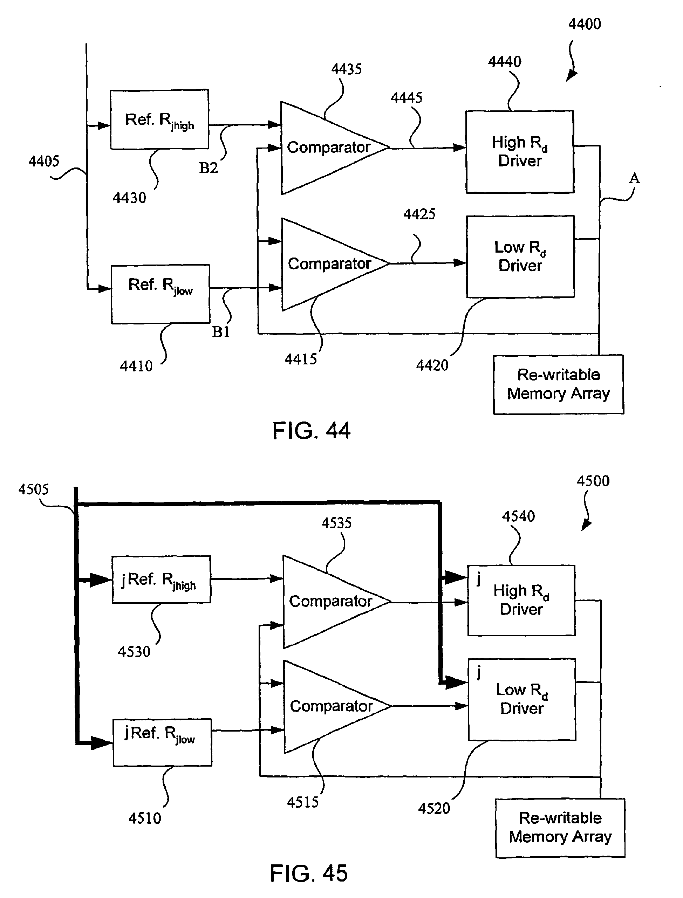

FIG. 44 depicts another embodiment of the adaptive programming circuit that can be used with a multi-level memory;

FIG. 45 depicts yet another embodiment of the adaptive programming circuit;

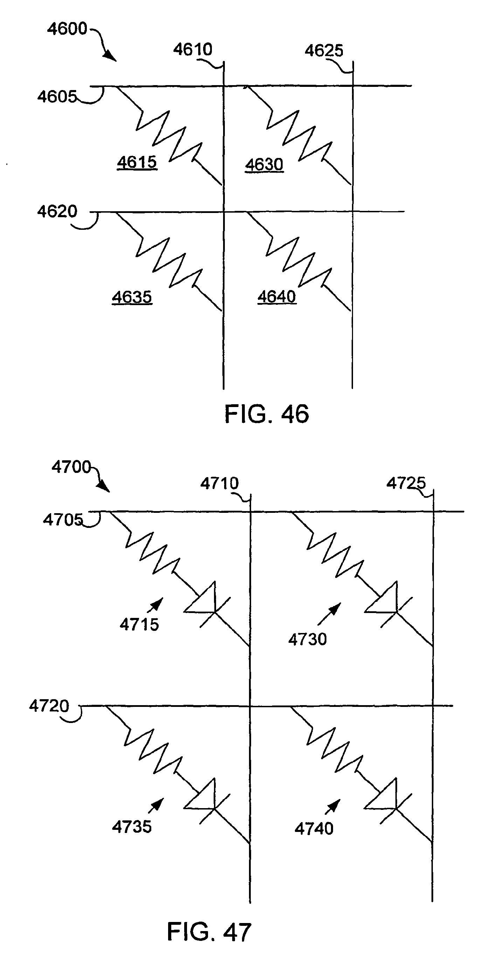

FIG. 46 depicts a simplified representation of a cross point memory array;

FIG. 47 depicts an exemplary cross point array where each memory cell includes a diode;

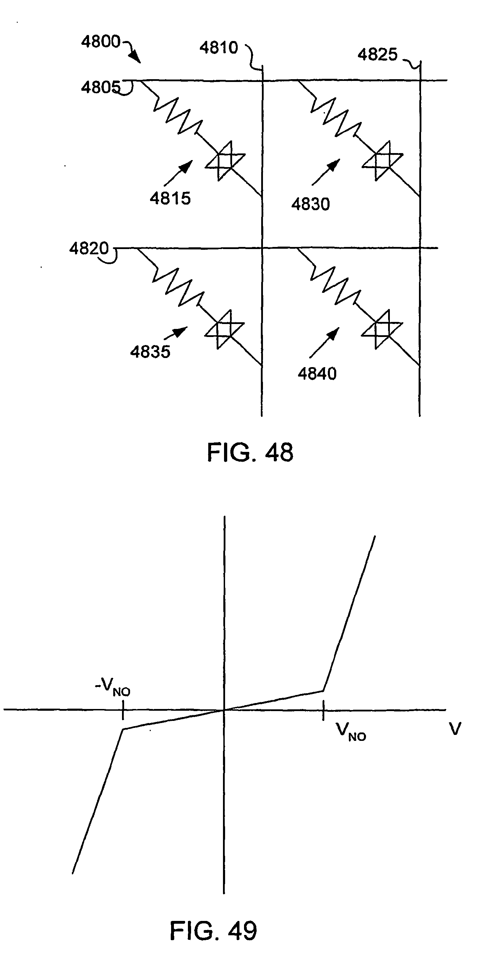

FIG. 48 depicts an exemplary cross point memory array where each memory cell includes a back to back diode;

FIG. 49 depicts the current-voltage, or "IV" characteristic of a back to back diode device;

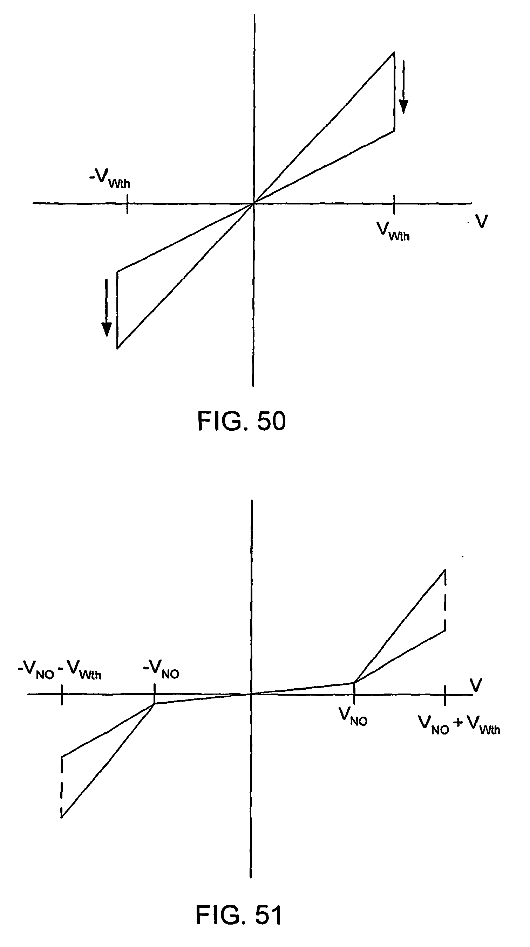

FIG. 50 depicts the IV characteristic of one type of linear memory element;

FIG. 51 depicts the typical IV characteristics of both a memory element and a back to back diode in series;

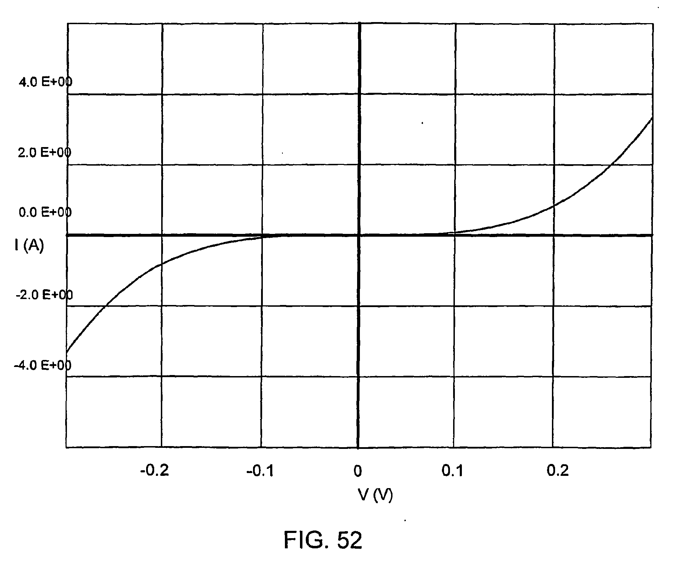

FIG. 52 depicts an representative IV curve of a stack that exhibits non-ohmic behavior;

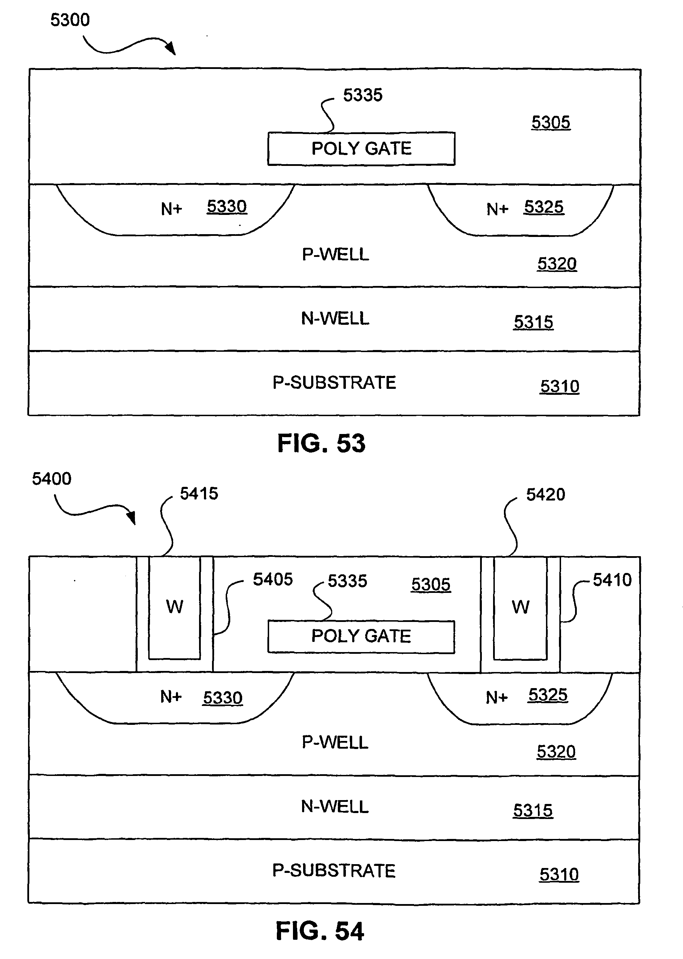

FIG. 53 depicts a cross sectional view of a partially processed integrated circuit up to the completion of a bottom front end of line section;

FIG. 54 depicts a cross sectional view of a further processed integrated circuit from FIG. 53 after the formation of a plurality of conductive plugs;

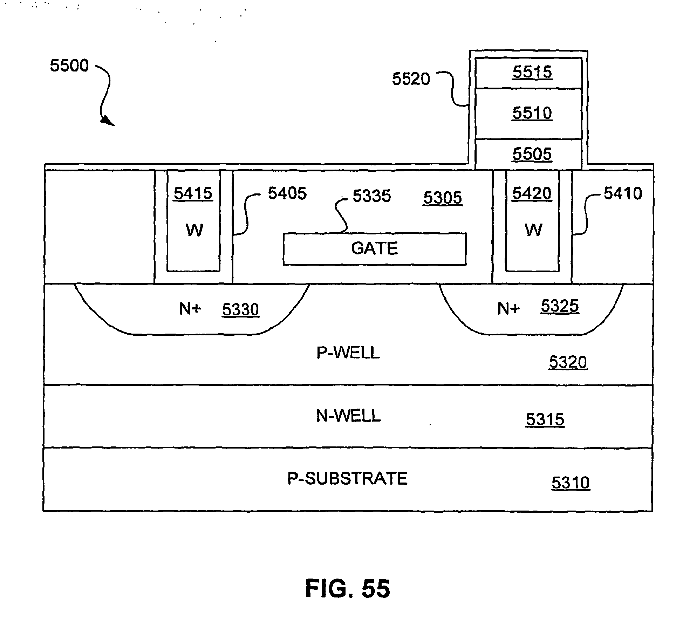

FIG. 55 depicts a cross sectional view of a further processed integrated circuit from FIG. 54 after the partial formation of a middle memory plug section atop the front end of line section;

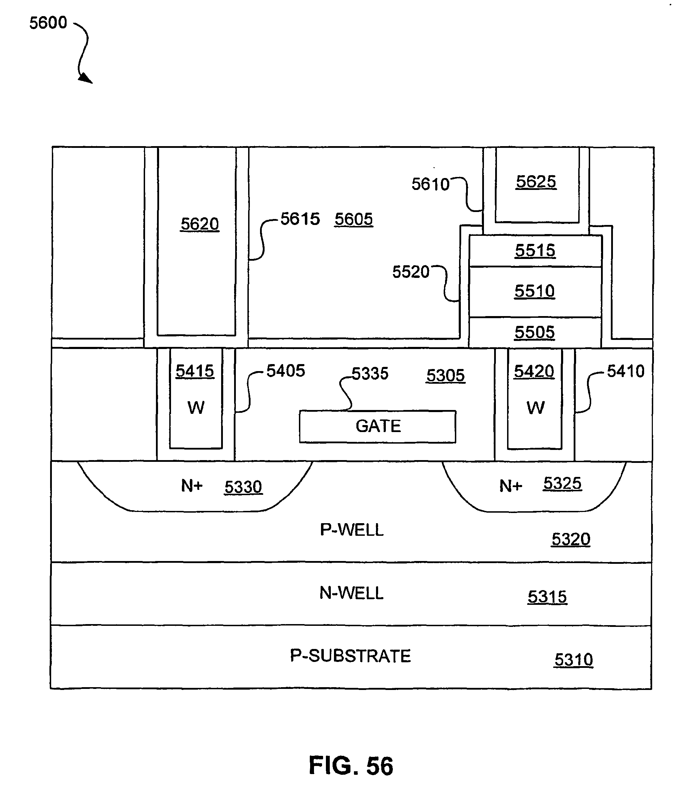

FIG. 56 depicts a cross sectional view of a further processed integrated circuit from FIG. 55 after the complete formation of a middle memory plug section atop the front end of line section;

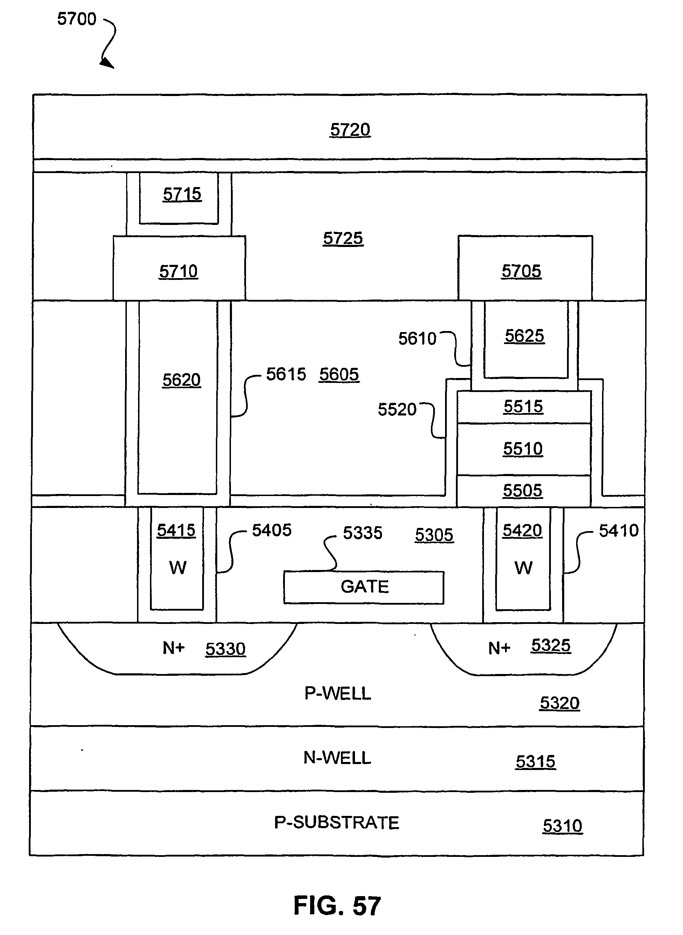

FIG. 57 depicts a cross sectional view of a completely processed integrated circuit from FIG. 56 after the complete formation of a top metallization section atop the middle memory plug section;

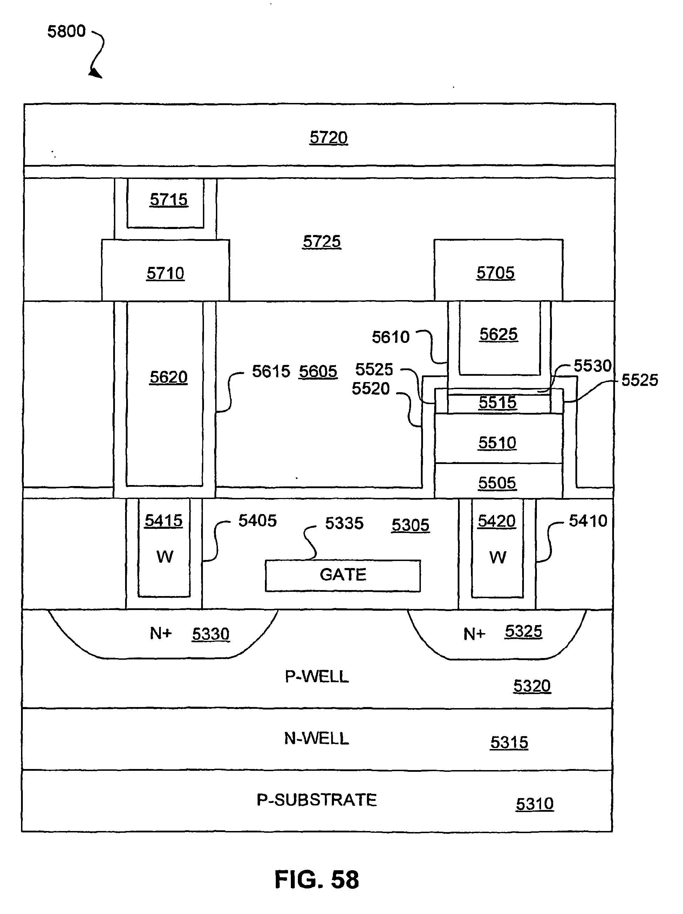

FIG. 58 depicts a cross sectional view of a completely processed integrated circuit wherein the middle memory plug section further include features of a hard mask layer and a spacer;

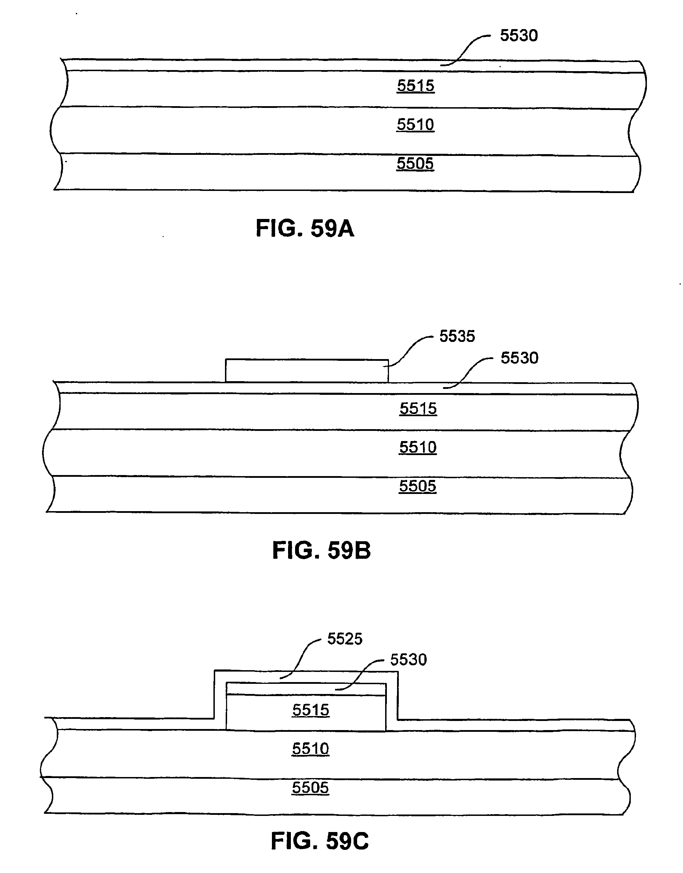

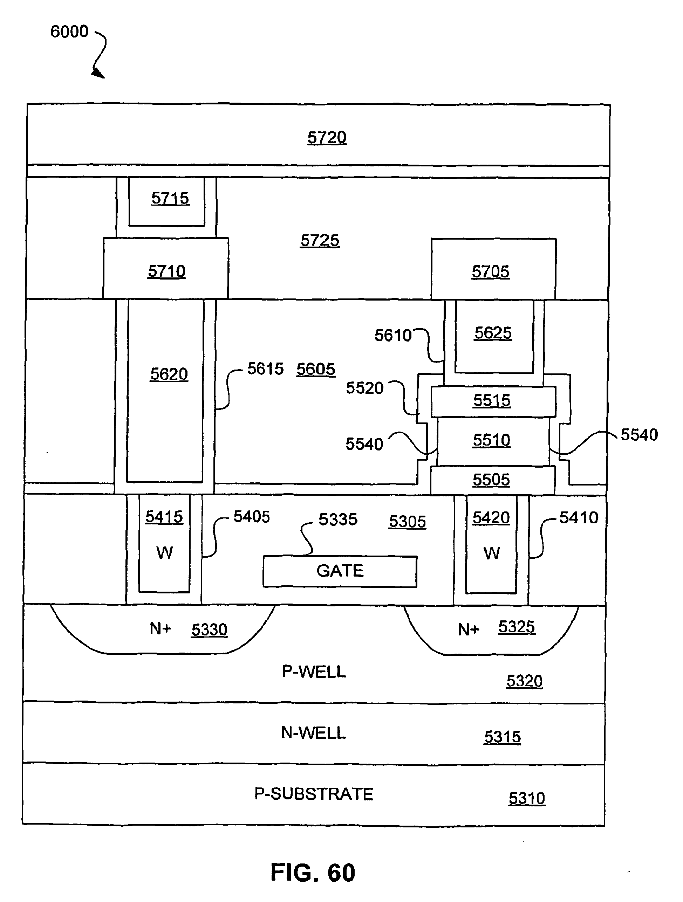

FIG. 59A through FIG. 59E depict an exemplary sequence of various processing steps that could be used for the creation of the hard mask and spacer features of FIG. 58; FIG. 60 depicts a cross sectional view of a completely processed integrated circuit wherein the middle memory plug section further include an optional undercut feature;

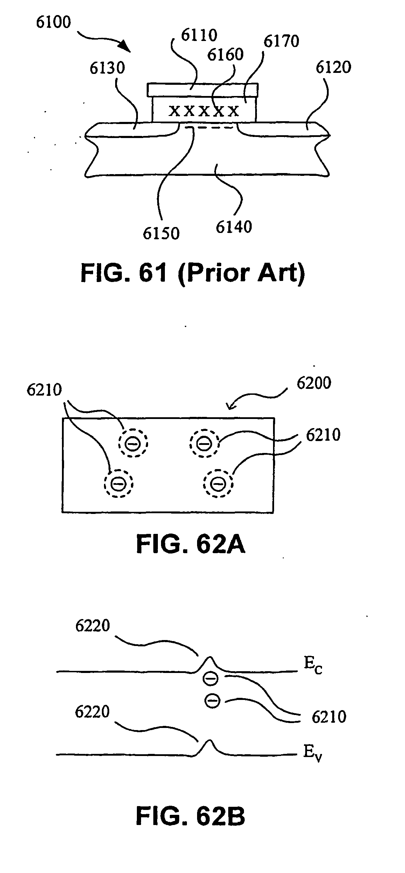

FIG. 61 depicts a cross-section of a prior art FET;
FIG. 62A depicts a section of a resistive memory material with charge traps;
FIG. 62B depicts an energy band diagram of the section of resistive memory material in FIG. 62A;

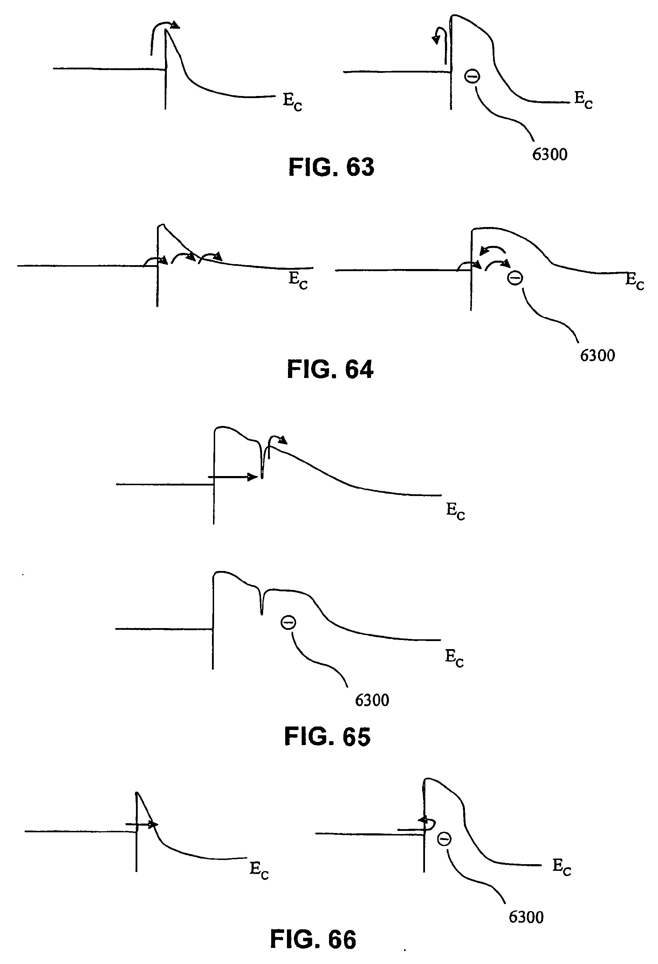

FIG. 63 depicts energy band diagrams of a Schottky barrier without and with a charged trap;
FIG. 64 depicts energy band diagrams of trap to trap conduction without and with trapped charge;
FIG. 65 depicts energy band diagrams of Frenkel-Poole conduction without and with charged trap; and
FIG. 66 depicts energy band diagrams of tunneling conduction through a Schottky junction without and with a charged trap.

It is to be understood that, in the drawings, like reference numerals designate like structural elements. Also, it is understood that the depictions in the figures are not necessarily to scale.

## DETAILED DESCRIPTION OF THE PREFERRED EMBODIMENTS

In the following description, numerous specific details are set forth to provide a thorough understanding of the present invention. It will be apparent, however, to one skilled in the art that the present invention may be practiced without some or all of these specific details. In other instances, well known process steps have not been described in detail in order to avoid unnecessarily obscuring the present invention.

### Cross Point Memory Array

Conventional nonvolatile memory requires three terminal MOSFET-based devices. The layout of such devices is not ideal, usually requiring an area of at least $8f^2$ for each memory cell, where f is the minimum feature size. However, not all memory elements require three terminals. If, for example, a memory element is capable of changing its electrical properties (e.g., resistivity) in response to a voltage pulse, only two terminals are required. With only two terminals, a cross point array layout that allows a single cell to be fabricated to a size of $4f^2$ can be utilized.

FIG. 1 depicts a perspective view of an exemplary cross point memory array 100 employing a single layer of memory. A bottom layer of x-direction conductive array lines 105 is orthogonal to a top layer of y-direction conductive array lines 110. The x-direction conductive array lines 105 act as a first terminal and the y-direction conductive array lines 110 act as a second terminal to a plurality of memory plugs 115, which are located at the intersections of the conductive array lines 105 and 110. The conductive array lines 105 and 110 are used to both deliver a voltage pulse to the memory plugs 115 and carry current through the memory plugs 115 in order to determine their resistive states.

Conductive array line layers 105 and 110 can generally be constructed of any conductive material, such as aluminum, copper, tungsten or certain ceramics. Depending upon the material, a conductive array line would typically cross between 64 and 8192 perpendicular conductive array lines. Fabrication techniques, feature size and resistivity of material may allow for shorter or longer lines. Although the x-direction and y-direction conductive array lines can be of equal lengths (forming a square cross point array) they can also be of unequal lengths (forming a rectangular cross point array), which may be useful if they are made from different materials with different resistivities.

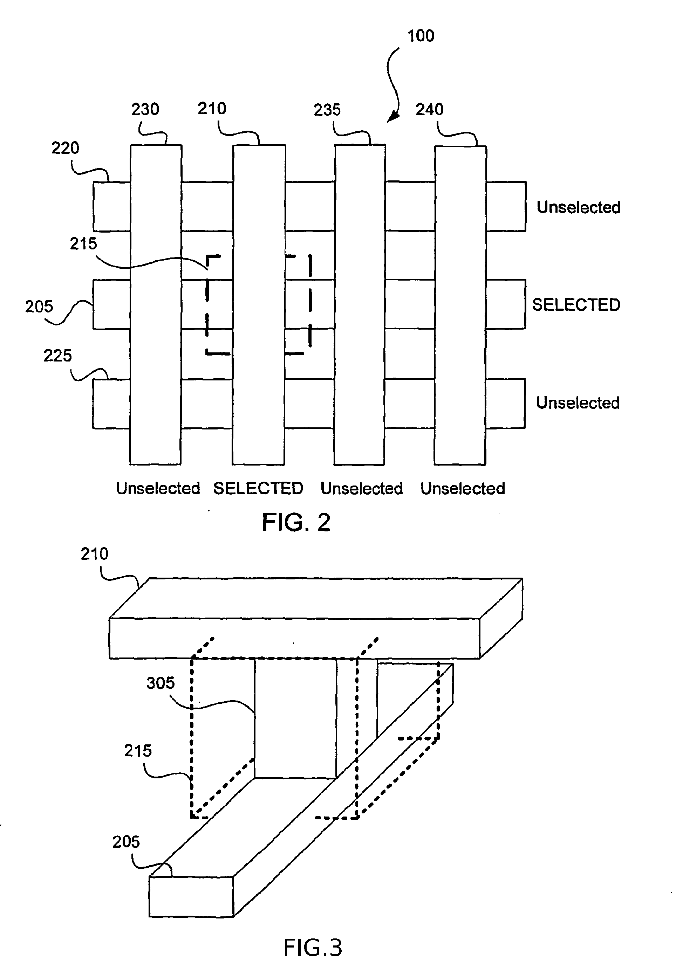

FIG. 2 illustrates selection of a memory cell 215 in the cross point array 100. The point of intersection between a single x-direction conductive array line 205 and a single y-direction conductive array line 210 uniquely identifies the single memory cell 215. FIG. 3 illustrates the boundaries of the selected memory cell 215. The memory cell is a repeatable unit that can be theoretically extended in one, two or even three dimensions. One method of repeating the memory cells in the z-direction (orthogonal to the x-y plane) is to use both the bottom and top surfaces of conductive array lines 105 and 110, creating a stacked cross point array.

The repeatable cell that makes up the cross point array 100 can be considered to be a memory plug 305, plus 1/2 of the space around the memory plug, plus 1/2 of an x-direction conductive array line 205 and 1/2 of a y-direction conductive array line 210. Of course, 1/2 of a conductive array line is merely a theoretical construct, since a conductive array line would generally be fabricated to the same width, regardless of whether one or both surfaces of the conductive array line was used. Accordingly, the very top and very bottom layers of conductive array lines (which use only one surface) would typically be fabricated to the same size as all other layers of conductive array lines.

### Stacked Cross Point Memory Array

FIGs. 4A and 4B depict an exemplary stacked cross point array 400 employing four memory layers 405, 410, 415, and 420. The memory layers, $ML_0$ 405, $ML_1$ 410, $ML_2$ 415 and $ML_3$ 420, are sandwiched between alternating layers of x-direction conductive array lines, $X_0$ layer 425, $X_1$ layer 430, and $X_2$ 435, and y-direction conductive array lines, $Y_0$

layer 440 and $Y_1$ layer 445. Stacking allows for the memory device to increase its memory capacity without increasing the footprint of the cross point array 400. A "memory layer," as the term is used herein, is not necessarily a homogenous layer of material, but a layer of memory plugs. Memory plugs are described below, and can be made up of several different layers of materials. The term "plug" is meant to be generally applicable to any stack or formation between complementary conductive array lines, and not intended to be limited to any manufacturing process.

Each memory layer 405, 410, 415, and 420 is associated with one layer 425, 430, or 435 of x-direction conductive array lines and one layer 440 or 445 of y-direction conductive array lines. Although the top conductive array line layers 435 and bottom conductive array line layer 425 are only used to supply voltage to a single memory layer 420 and 405, the other conductive array line layers 430, 440, and 445 can be used to supply voltage to both a top and a bottom memory layer 405, 410, 415, or 420.

Generally speaking, if each middle conductive array line layer were used for two memory layers, N memory layers would require $N + 1$ layers of conductive array lines. However, although every memory plug in a cross point array would need to have two conductive lines, not every conductive line layer would need to have its own separate circuitry. Since selection of a memory plug requires both an x-direction conductive array line and a y-direction conductive array line to be active, multiple conductive array lines in both directions can be activated as long as only one memory layer can be activated.

For example, in the stacked cross point array 400, the top and bottom x-direction layers of conductive array lines (the $X_0$ layer 425 and the $X_2$ layer 435) can be logically related for accessing memory elements, and, in addition to sharing the same selection logic, may even share the same circuitry. Table 1 shows the combinations of x-direction conductive array lines and y-direction conductive array lines that can be used to activate a memory element on a specific memory layer.

**TABLE 1**

| $X_0, X_2$ | $X_1$ | $Y_0$ | $Y_1$ | Memory Layer |
|:---:|:---:|:---:|:---:|:---:|
| x | | x | | $ML_0$ |
| | x | x | | $ML_1$ |
| | x | | x | $ML_2$ |
| x | | | x | $ML_3$ |

Therefore, in order to access a memory cell on $ML_1$ 410, for example, one conductive array line from the $X_1$ layer 430 and one conductive array line from the $Y_0$ layer 440 would need to be selected.

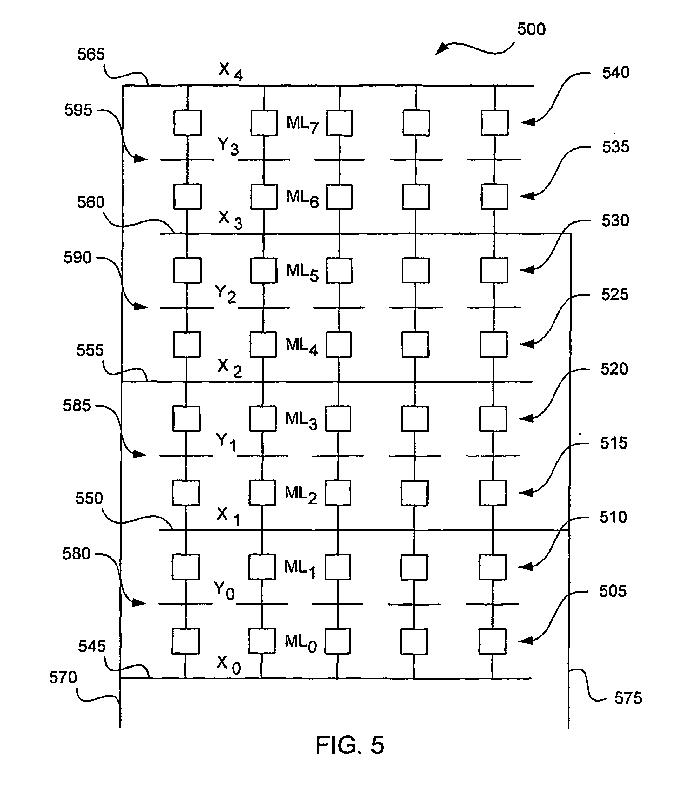

Similarly, FIG. 5 depicts a configuration of a stacked cross point array 500 that uses eight memory layers 505, 510, 515, 520, 525, 530, 535, and 540. All of the x-direction conductive array line layers 545, 550, 555, 560, and 565 are connected to one of two thrus 570 or 575, and, therefore, share decoding logic. A thru, as used herein, is generally defined as a vertical conductive pathway between multiple metal layers that bypasses layers of memory plugs, but is otherwise very similar in function to vias and contacts. Each of the y-direction conductive array line layers 580, 585, 590, and 595, however, are driven by their own decoding logic. Table 2 shows the combinations of x-direction conductive array lines and y-direction conductive array lines that can be used to activate a memory element on a specific memory layer.

**TABLE 2**

| $X_0, X_2, X_4$ | $X_1, X_3$ | $Y_0$ | $Y_1$ | $Y_2$ | $Y_3$ | Memory Layer |
|:---:|:---:|:---:|:---:|:---:|:---:|:---:|
| x | | x | | | | $ML_0$ |
| | x | x | | | | $ML_1$ |
| | x | | x | | | $ML_2$ |
| x | | | x | | | $ML_3$ |
| x | | | | x | | $ML_4$ |
| | x | | | x | | $ML_5$ |
| | x | | | | x | $ML_6$ |
| x | | | | | x | $ML_7$ |

***The Peripheral Circuitry***

One benefit of the cross point array is that the active circuitry that drives the cross point array (e.g., 100, 400, or 500) can be placed beneath the cross point array, therefore reducing the footprint required on a semiconductor substrate. FIG. 6A depicts x-direction driver sets 605, 610, and 615 that are used to select specific x-direction conductive array lines in the $X_0$ layer 425, $X_1$ layer 430, and $X_2$ layer 435 of the four memory layer stacked cross point array 400. Although the $X_0$ driver 605 and the $X_2$ driver 615 can use identical logic (as described in table 1), separate drivers are shown because of the difficulty in routing the single $X_0$ driver 605 around a thru 640 connecting the $X_1$ layer 430 to the $X_1$ driver 610.

FIG. 6B depicts y-direction driver sets 620 and 625 that are used to select specific y-direction conductive array lines in the y-direction conductive array line layers 440 and 445. The $Y_0$ driver set 620 uses a thru 630 that traverses one memory layer 405 in order to connect with the $Y_0$ layer 440. The $Y_1$ driver set 625 uses a thru 635 that traverses three memory layers 405, 410, and 415 in order to connect with the $Y_1$ layer 445.

FIG. 7A depicts the general layout of the x-direction and y-direction driver sets 605, 610, 615, 620, and 625 in relation to the stacked cross point array 400. FIG. 7B is a more abstracted representation of FIG. 7A. Since each driver set is on the same side the entire layout forms a non-symmetrical L-shape.

However, certain designs may interdigitate the driver circuitry so that the driver that controls one conductive array line comes from one side and the driver that controls the next conductive array line comes from the opposite side.

### Interdigitated Driver Sets

FIGs. 8A and 8B depict a layout of an interdigitated x-direction driver 805 and an interdigitated y-direction driver 810 that drive a single-layer cross point array 100. Interdigitating the drivers 805 and 810 not only allows for greater symmetry in a single-layer cross point array 100, but also permits the drivers to be fabricated to larger dimensions.

Drivers can be considered to be interdigitated when alternating lines in the same conductive array line layer are driven from different locations. Such oppositely driven lines may be alternate, i.e. even numbered lines are driven from one side and odd numbered lines are driven from the opposite side, or grouped by pair where 2 lines driven from one side are adjacent and two lines driven from the other side are next to them, or grouped in any arrangement which allows the use of a driver which is laid out in the pitch of 2 x N cells, and drives N lines. By extension, we call "interdigitated driver set" a set of drivers driving interdigitated lines even though the drivers themselves need not be interdigitated.

FIGs. 9A and 9B depict a layout of driver sets 605, 610, 620, and 625 for the stacked cross point array 400 that are interdigitated. The configuration of the x-direction driver sets 605 and 610 are depicted in FIGs. 10A and 10B. The configuration of FIG. 10A is alternated with the configuration of FIG. 10B for each x-direction conductive array line so that both the $X_0$ driver 605 and the $X_1$ driver 610 alternate sides.

Additionally, by placing the thru 640 that connects the $X_1$ layer 430 to the $X_1$ driver 610 and thru 645 that connects the $X_2$ layer 435 to the $X_0$ driver 605 on opposite sides, the bottom $X_0$ layer 425 can be directly tied to the $X_2$ layer 435. Therefore, a single $X_0$ driver 605 can be used for both the bottom $X_0$ layer 425 and the top $X_2$ layer 435.

The layouts shown in FIGs. 7B, 8B and 9B assume that the drivers 605, 610, 615, 620, 625, 805, and 810 all lay outside the cross point array 100 or 400. However, if the substrate underneath a cross-point array is used to draw the peripheral circuitry, the footprint of the entire memory chip can be reduced.

FIGs. 11A through 11C depict various layouts of the x and y direction driver sets 805 and 810 that have some drivers underneath the single-layer cross point array 100. In each layout, some drivers are left outside of the single-layer cross point array 100 even though there may be unused space underneath the cross point array 100. In FIG. 11A the layout forms a rectangle that extends beyond the cross point array 100 in the x-direction. In FIG. 11B the layout forms an H-shape that extends beyond the cross point array 100 in the y-direction. In FIG. 11C the layout forms an asymmetric shape that, while extending beyond the cross point array 100 in both the x-direction and y-direction, forms a more symmetrical pattern.

FIG. 12 depicts an alternative layout of the x and y direction driver sets 805 and 810 that interdigitate some drivers but not others. Portions of each driver set 805 and 810 are still outside the single-layer cross point array 100. However, assuming each driver is fabricated to common dimensions, a portion of the non-interdigitated driver would still extend beyond the cross point array 100 because non interdigitated drivers drive twice as many lines in the same pitch, and therefore necessitate more circuitry.

However, if none of the drivers 805 and 810 are interdigitated, then the entire peripheral circuitry might be placed underneath the single-layer cross point array 100.

### Non-Interdigitated Driver Sets

FIG. 13A depicts a layout of an x-direction driver 805 and a y-direction driver 810 that completely fits underneath the single-layer cross point array 100. FIG. 13B depicts an alternate layout of the x-direction driver 805 and the y-direction driver 810 that uses a more symmetrical layout.

The concept of using non-interdigitated driver sets can be extended to stacked cross point arrays. FIGs. 14A and 14B depict layouts of non-interdigitated driver sets 605, 610, 620, and 625. It should be appreciated that each driver set 605, 610, 620, or 625, is not necessarily to scale, and, depending upon both the number of lines in each conductive array line layer and the circuitry used for each driver, each driver set 605, 610, 620, or 625, may completely fit underneath the stacked cross point array 400, leave empty gaps underneath the stacked cross point array 400, as shown in FIG. 14B, or extend beyond the footprint of the stacked cross point array 400.

FIGs. 15A and 15B depicts one possible configuration of the driver sets 605, 610, 620 and 625 that can be used in the layout of FIGs. 14A or 14B. While the $X_0$ driver set 605 can directly connect with the $X_0$ layer 425 (and the $X_2$ layer 435 via the thru 645) and the $X_1$ and $Y_1$ driver sets 610 and 625 can be directly connected to their $X_1$ and $Y_1$ layers 430 and 445 via their respective thrus 640 and 635, the $Y_0$ driver set 620 will not be able to directly connect to the thru 630 that connects the peripheral circuitry to the $Y_0$ layer 440. Instead, the $Y_0$ driver set 620 uses an extra metal layer 1505 in the peripheral circuitry portion in order to connect to the thru 630 by going over the circuitry of the $Y_1$ driver set 625. The extra metal layer 1505 is in addition to any metal layers that may be necessary to construct the driver circuitry.

FIG. 16 depicts an alternate configuration for the x-direction driver sets 605, 610, and 615. Since the extra metal layer 1505 is used in connection with the y-direction drivers 620 and 625, the configuration of FIG. 15 also utilizes the extra metal layer 1505. By separating the $X_0$ driver set 605 from the $X_2$ driver set 615, the load on the $X_0$ driver is reduced even if the two drivers 605 and 615 use identical logic. This modification can improve the access time to layer 425 and 435.

FIG. 17 depicts yet another configuration for the y-direction driver sets 620 and 625 that can be used to eliminate the need for the extra metal layer 1505. In this configuration, one x-direction conductive array line is eliminated from the $X_0$ layer 425, creating an array cut that allows the $Y_0$ driver set 620 to directly connect with the thru 630 that connects the $Y_0$ driver set 620 to the $Y_0$ layer 440. While one line of memory plugs would be eliminated from the $ML_0$ layer 405, their absence would represent a very small percentage of the total memory plugs in the stacked cross point array 400 and may be a fair tradeoff for a peripheral circuitry design that does not use an extra metal layer 1505. Cells in layers $ML_1$ 410, $ML_2$ 415, and $ML_3$ 420 straight above the eliminated $ML_0$ array line can either be eliminated, or be kept as non-functional dummy cells. This way, the four array layers are symmetrical. Alternatively, the bottom $ML_0$ memory layer could use a redundancy line to replace the missing line.

Additionally, if the $Y_0$ driver set 620 is moved to the middle of the stacked cross point array 400, the access time for the $Y_0$ layer 440 is improved. If the $Y_0$ driver set 620 is at one end of the conductive array lines then current would need to travel to the opposite end in order to reach the active memory cell in the worst case scenario. However, if the $Y_0$ driver set 620 is positioned in the middle of the conductive array lines, the current would only need to travel half the length of the conductive array line in the worst case scenario. Access time is, therefore, improved by having the $Y_0$ driver set 620 positioned in the middle of the conductive array lines.

FIG. 18A depicts a layout of an x-direction driver 805 and a y-direction driver 810 that are both centered underneath the single-layer cross point array 100. The y-direction driver 810 can use the array cut to reach the middle of the y-direction conductive array lines 110 and the x-direction driver can be positioned anywhere under the x-direction conductive array lines 105 as long as it does not overlap with another driver. Moving both drivers 805 and 810 substantially to the middle of their respective conductive array lines 105 and 110 further reduces the access time to the memory plug layer 115.

Such a layout would be most effective for either a single layer cross point array or the bottom layer of a stacked cross point array. In the case of a stacked cross point array, while the $X_0$ driver set 605 and $Y_0$ driver set 620 are positioned substantially in the middle of cross point array 400, the other driver sets would typically connect to the ends of the conductive array lines for the upper conductive array line layers.

FIG. 18B depicts a layout of driver sets for a stacked cross point array 400 where the bottom memory layer has a faster access time than upper memory layers. Certain applications might require that a portion of memory be accessed faster than other portions. For example a mass storage device might want to be able to access its file allocation tables (FAT) quicker than other stored data.

### Non-Interdigitated Driver Design

The designs depicted in FIGs. 13A through 18B all presume that non-interdigitated drivers are used. FIG. 19 depicts one possible layout of the $X_0$ driver set 605 that would make it possible to fit the line drivers within the line pitch necessary for non- interdigitated drivers. Each driver would be responsible for supplying voltage to a specific conductive array line (or group of conductive array lines if the driver set supplied voltage to multiple memory layers). Therefore, if there were 256 conductive array lines on the $X_0$ layer 425, there would be 256 drivers in the $X_0$ driver set 605. The drivers deliver voltage to the conductive array lines through metal interconnects 1905. Each metal interconnect 1905 would preferably be fabricated to be the same width as the conductive array lines. Since each driver in FIG. 19 spans four metal interconnects, stacking the drivers four deep ensures that the entire $X_0$ driver set 605 fits within the required parameters. In general terms, if a line driver group contained N line drivers, and if a memory cell was fabricated to a width of W, then the line driver group could not have a width greater than $N \times W$ if the drivers were to fit completely underneath the cross point array.

It should be appreciated that additional peripheral circuitry may be needed in addition to the drivers. For example, the drivers might require access to both a primary decoder and a secondary decoder. The primary decoder is capable of selecting a single group of, for example, eight drivers (e.g., 1910), but not a specific driver, and the secondary decoder is capable of selecting a single driver (e.g., 1915), but not a specific group of eight drivers. Although the secondary decoder connections are not shown in FIG. 19, the primary decoder activates the group of eight drivers through a metal interconnect line 1920. If the primary decoder selected a group of, say, sixteen drivers, then the metal interconnect line 1920 could be tied to a metal interconnect line of another set of eight drivers. The secondary decoder would then select a single driver out of the group of sixteen drivers. More detailed information about the additional peripheral circuitry is described later. If there were room underneath the cross point array (e.g., the configuration shown in FIG. 14B), at least some of the additional peripheral circuitry required for the primary and secondary decoders could be placed underneath the cross point array.

FIG. 20A depicts one possible driver schematic in which the driver 1915 requires access to a primary decoder, a secondary decoder, and ground (or another reference voltage). The driver 1915 is made up of a pass device (one p-channel transistor 2005 and one n-channel transistor 2010) and a transistor 2015 to ground. The transistor to ground 2015 can be either an n-channel transistor or a p-channel transistor, depending upon how it is connected to the pass device.

FIG. 20B depicts one layout of the three transistors 2005, 2010, and 2015 that make up the driver 1915. Since one of the transistors 2005 of the pass device is a p-channel transistor, it must be fabricated in a portion of the semiconductor substrate that is n-doped 2020. In order to conserve space, each transistor 2005, 2010, and 2015 shares a node 2025, 2030, and 2035 with a transistor from another driver 1925 in the group of eight drivers 1910. The nodes can be shared because the entire group of eight drivers 1910 receives the same input 1920 from the primary decoder into each pass device and the third transistor in each driver is tied to ground.

Making the various connections can be accomplished through well-known process steps. FIG. 21A depicts the driver 1915 after a first metal layer is deposited that provides vertical connections 2105, 2110, 2115, and 2120 from the driver to other peripheral circuitry and/or other drivers. The transistor to ground 2015 can share its vertical connection 2115 to ground with every grounded transistor in the same horizontal position as the drivers 1915 and 1925. However, in order to reduce load alternative layouts may not tie all the drivers together. Similarly, the gates of each transistor 2005, 2010 and 2015 in the driver 1915 that takes inputs from the secondary decoder can share their vertical connections 2105, 2110, and 2115 with the gates of other drivers that have the same position in relation to the group of eight drivers 1910. Although not shown in FIG. 21A, the gate of the grounded transistor 2015 and the gate of the p-channel transistor 2005 are driven by the same input from the secondary decoder as shown in FIG. 20A.

Although a single via 2125, 2130, 2135, and 2140 is shown connecting each of the transistors 2005, 2010, and 2015 to their corresponding vertical connections 2105, 2110, 2115, and 2120, it should be appreciated that multiple vias might be used in order to improve performance. Similarly, different designs might use vertical connections 2105, 2110, 2115, and 2120 that are wider than a single feature size in order to similarly improve performance.

FIG. 21B depicts the driver 1915 after a second metal layer is deposited. The second metal layer provides the horizontal connections 2145, 2150, and 1920 that make the logical connections between the three transistors 2005, 2010, and 2015. The transistors 2005 and 2010 in the pass device are tied together with two horizontal connectors 2145 and 1920. Additionally, the horizontal connector 1920 that connects the nodes 2025 and 2030 of the pass device that is common to the two drivers 1915 and 1925 extends beyond the driver 1915 boundaries to the other drivers in the group of eight drivers 1910 and carries signals from the primary decoder.

Horizontal connector 2150 also connects the transistor to ground 2015 to the pass device transistors 2005 and 2010. In one embodiment, connector 2145 and connector 2150 are the same line, ensuring that all three transistors 2005, 2010, and 2015 are tied together. The horizontal connector 2150 is preferably the same line pitch as the conductive array lines because the horizontal connector 2150 is the beginning of the metal interconnect that joins the driver 1915 to the appropriate conductive array line. The other metal interconnects from the other drivers in the group of eight drivers 1910 are also formed on the second metal layer as shown in FIG. 19. Although other embodiments could use more metal layers, such designs would typically result in a more costly fabrication process.

The last column 1930 of drivers uses a slightly different layout than the previous three columns 1935, 1940, and 1945. Since the circuitry is laid out in the pitch of 8 array lines, which is intended to be minimum pitch, and the circuitry drives 8 conductive array lines, there is no space left for the line 1920 that drives the common nodes of the pass device. FIG. 22 depicts the layout for the drivers in the last column 1930. The gates 2205, 2210, 2215, and 2220 of the pass devices 2225 are lengthened with extensions 2230, 2235, 2240, and 2245. Although lengthening the pass devices 2225 increases the width of the last column 1930, such lengthening allows for the first metal layer to be used for both horizontal and vertical connections within the pass devices 2225

FIG. 23A depicts the driver in the last column 1930 after a first metal layer is deposited. A horizontal connector 2305 can directly connect the common node of the pass devices 2225 because the vertical connections 2310, 2315, 2320, and 2325 lie on the exterior of the pass devices 2225. Additionally, the horizontal connector 2305 extends to the beginning of a via 2330, which is how the last column 1930 receives its input 1920 from the primary decoder.

FIG. 23B depicts the driver in the last column 1930 after the second metal layer is deposited. The input 1920 from the primary decoder delivers its signal to the pass devices 2225 through the via 2330, which connects to the horizontal connection 2305 on the first metal layer. Allowing the primary decoder input 1920 to drop to the first metal layer makes an additional line available on the second metal layer, such that all eight metal interconnects 1905 from the group of eight drivers 1910 fit on the minimum line pitch.

### Cross Point Array Design

Once these front end of line (FEOL) processes are complete (which, in the previous example, includes the metallization layers that were described in FIG. 21B and FIG. 23B), the cross point array can be fabricated on top of the active circuitry. FIG. 24 depicts the exemplary stacked cross point array 400 employing thrus 2405 and 2410 for the two upper layers of x-direction conductive array lines 430 and 435. As will be appreciated by those skilled in the art, similar thrus could also be used to connect the peripheral circuitry to the y-direction conductive array lines 440 and 445.

The thru 2405 that connects the $X_1$ layer 430 to the peripheral circuitry would go through at least two inter-layer dielectric (ILD) layers 2415 and 2420. ILD layers provide several functions, including isolation between conductive array lines and providing a substrate for conductive array lines that would otherwise need to span empty spaces.

The thru 2410 that connects the $X_2$ layer 435 to the peripheral circuitry would go through at least four ILD layers 2415, 2420, 2425, and 2430. Although the thrus 2405 and 2410 may share some of the same processing steps as the memory layers, a conductive material 2435 would need to be used to connect the conductive array lines to the peripheral circuitry. The conductive material will typically be deposited in separate processing steps that include masking the area that is to have the conductive material 2435 while the memory layers are deposited.

### Driver Designs

As illustrated in the exemplary embodiments shown FIGs. 25A and 25B, each conductive array line 205, 210, 220, 225, 230, 235 and 240 is associated with a pass device 2505, 2510, 2515, 2520, 2525, 2530 and 2535 (one n-type and one p-type transistor). The gate voltages of each transistor can be adjusted such that the selected conductive array lines 205 and 210 are allowed to pass a voltage from primary decoders 2540. The voltage that is passed can either be the full voltage from the primary decoders 2540 during a write operation (e.g., a magnitude of 3 volts), a partial voltage during a read operation (e.g., a magnitude of 2 volts), or no voltage for the unselected lines in an unselect mode. Therefore, the pass devices 2505 can act as part of the decoding circuitry as a type of modulating circuit, allowing one conductive array line to be on ("selected") at either a read or write voltage and the other conductive array lines to be off ("unselected"). FIG. 25A illustrates the logical connections and FIG. 25B illustrates the same connections, but with a different physical layout (the pass devices alternating on each end of the conductive array lines).

Alternatively, in place of the pass devices pass device 2505, 2510, 2515, 2520, 2525, 2530 and 2535, a single transistor can be used. However, the transistor's gate voltage would need to be such that it could pass large magnitude voltages. For example, an n-channel transistor would pass the full 3V if its gate were held to 3V plus the n-channel transistor's threshold voltage. A single transistor could still act as a modulating circuit by only partially turning on the transistor.

In another embodiment, the modulation is performed upstream of the gate circuit such that the input to the gate circuit would already be at an appropriate read or write voltage. In this embodiment, the gate circuit would only have a first select mode (passing substantially the full input voltage) and an unselect mode (passing substantially no voltage).

It should be noted that if the unselected conductive array lines 220, 225, 230, 235 and 240 were not held to a certain voltage, they would be considered floating, which is generally discouraged in circuit design. Specifically, a problem would arise if, for example, an unselected y-direction conductive array line 240 were floating at -3 volts. If the selected x-direction conductive array line 205 was at 3 volts and the selected y-direction conductive array line 210 was at -3 volts, two cells 215 and 2545 would see a 6-volt drop, potentially disturbing the resistive states of both cells.

FIG. 26A illustrates one mechanism for preventing the unselected conductive array lines 220, 225, 230, 235 and 240 from floating to an undesired voltage. Prior to a read or write operation, each pass device 2505, 2510, 2515, 2520, 2525, 2530 and 2535 would have both of their transistors turned on, the primary decoders 2540 would be deactivated, and voltage reference generators 2605 would be at some reference voltage (presumed to be ground). Therefore, all the conductive array lines 205, 210, 220, 225, 230, 235 and 240 would be pulled to the reference voltage. During the read or write operation, the voltage reference generator 2605 would be deactivated, the primary decoders 2540 would be activated, and only the appropriate pass devices 2505 and 2510 would be on, bringing the selected conductive array lines 205 and 210 to the driver voltage. Although the unselected conductive array lines 220, 225, 230, 235 and 240 would be floating during a read or write operation, their parasitic capacitance might keep them at the reference voltage for the time it takes to do a normal read or write cycle. However, lateral coupling capacitance will work against the parasitic capacitance, raising the voltage on the unselected conductive array lines 220, 225, 230 and 235 adjacent to the selected conductive array lines 205 and 210.

FIG. 26B illustrates another mechanism for preventing the unselected conductive array lines 220, 225, 230, 335 and 240 from floating to an undesired voltage. Each conductive array line 205, 210, 220, 225, 330, 235 and 240 would have an associated grounding pass device 2610, 2615, 2620, 2625, 2630, 2635 and 2640 that allows the conductive array lines 205, 210, 220, 225, 230, 235 and 240 to be pulled to ground when activated.

The grounding pass devices 2610, 2615, 2620, 2625, 2630, 2635 and 2640 could be activated prior to a read or write operation (similar to the operation described in connection with FIG. 26A), could be triggered by the selection of a conductive array line, or could always be kept on. If the grounding pass devices 2610, 2615, 2620, 2625, 2630, 2635 and 2640 were always on, their relative size would need to be small in relation to the decoding pass devices 2505, 2510, 2515, 2520, 2525, 2530 and 2535 so that the leakage to ground would have a small effect.

If the grounding pass devices 2610, 2615, 2620, 2625, 2630, 2635 and 2640 were triggered by the selection of a conductive array line, the process of selecting the x-direction conductive array line 205, would activate the decoding pass device 2505 and deactivate the grounding pass device 2610 associated with the selected conductive array line 205 while deactivating the decoding pass devices 2515 and 2520 and activating the grounding pass devices 2635 and 2640 associated with the unselected conductive array lines 220 and 225. Similarly, selecting the y-direction conductive array line 210 would activate the decoding pass device 2510 and deactivate the grounding pass device 2615 associated with the selected conductive array line 210 while deactivating the decoding pass devices 2525, 2530 and 2535 and activating the grounding pass devices 2620, 2625 and 2630 associated with the unselected conductive array lines 230, 235 and 240.

FIG. 26C is an improvement on FIG. 26B. However, instead of pass devices 2610, 2615, 2620, 2625, 2630, 2635 and 2640, a single transistor 2645, 2650, 2655, 2660, 2665, 2670 and 2675 is used. Assuming the transistors 2645, 2650, 2655, 2660, 2665, 2670 and 2675 were n-channel devices, they would be on only if the gate voltage were held to at least the threshold voltages of the transistors. Similarly, if the transistors were p-channel devices, they would be on if the gate voltages were held to at least the negative threshold voltages. Therefore, an appropriate gate voltage can fully discharge the conductive array lines.

The single n-channel (or p-channel) transistor embodiment can be used either at the beginning of a cycle or by using the inverse of the signal that activates the n-channel (or p-channel) portion of the decoding pass devices 2505, 2510, 2515, 2520, 2525, 2530 and 2535. As shown in FIG. 26D, in some embodiments, the single n-channel (or p-channel) transistor's activating signal might simply use the activating signal of the p-channel (or n-channel) portion of the decoding pass devices 2505, 2510, 2515, 2520, 2525, 2530 and 2535.

FIG. 26E illustrates yet another mechanism for preventing the unselected conductive array lines 220, 225, 230, 235 and 240 from floating to an undesired voltage by using a 3-output driver 2680. Since the 3-output driver 2680 would deliver a voltage to all of the decoding pass devices 2505, 2510, 2515, 2520, 2525, 2530 and 2535, such a mechanism could not be used while a specific conductive array line was being selected. Therefore, the 3-output driver 2680 could either be used to discharge the floating voltages prior to a read or write operation. Alternatively, the 3-output driver 680 could be used during a read or write operation if it were only used in connection with unselected banks.

FIG. 27 illustrates one possible configuration of a 3-output driver 2680. A p-channel transistor 2705 and an n-channel transistor 2710 are arranged in series. The n-channel transistor may be in a separate well from the CMOS logic because its substrate is tied to a negative voltage. The source of the p-channel transistor 2705 is connected to a voltage source of $+1/2 \, V_W$ (e.g., +3 V) and the source of the n-channel transistor 2710 is connected to a voltage source of $-1/2 \, V_W$ (e.g., -3 V). The drains of both transistors are connected to both the decoding pass devices 2505, 2510, 2515, 2520, 2525, 2530 and 2535 and transistor to ground 2715. In order to discharge the entire line, the transistor to ground 2715 would need to have an appropriate gate voltage, as described in connection with FIG. 26C, or be a pass device. The 3-output driver 2680 would function when only one transistor 2705, 2710 or 2715 was on, while the other two transistors were off.

Depending on the embodiment, the driver 2540 or the 3-output driver 2680, must be able to supply either $+1/2 \, V_W$ or $-1/2 \, V_W$ to the decoding pass devices 2505, 2510, 2515, 2520, 2525, 2530 and 2535. This is because applying a voltage pulse in one direction $(+V_W)$ will decrease the resistive state of the memory cell from $R_0$ to $R_1$ and applying a voltage pulse in the opposite direction $(-V_W)$ will increase the resistive state from $R_1$ to $R_0$.

The polarity of the voltage drop is not important during a read. The resistive state of the memory cell can be detected regardless of whether the x-direction conductive array line 205 is $V_R$ (e.g., 4 V) higher or $V_R$ lower than the y-direction conductive array line 210. However, it is desirable to alternate polarities of reads to reduce the effect of long term read disturbs on the memory elements.

Additionally, a write operation could be preceded by a read operation in order to ensure a write is necessary. In other words, $+V_W$ should only be applied to a memory plug in its $R_0$ resistive state and $-V_W$ should only be applied to a memory plug in its $R_1$ resistive state. By ensuring that a voltage pulse is only used when the memory cell needs to change state, the memory cell would not either be placed in a resistive state lower than $R_1$ or higher than $R_0$ or suffer any degradation that occurs with certain memory cells. Additionally, avoiding a write operation will reduce disturbing the unselected cells and improve the endurance of the selected cell, avoiding unnecessarily stress on the cross point memory array. However, use of an adaptive programming scheme could avoid the need for a read operation before a write operation. Adaptive programming is described below.

If a read operation is used prior to a write operation, the polarity of the read can be the same as the polarity of the write operation that would follow, if required. For example, if the data to be written is "0" then the selected x-direction conductive array line 205 would be 3V and the selected y-direction conductive array line 210 would be -3V. If the read operation preceding the write used +2V on the selected x-direction conductive array line 205 and -2V on the selected y-direction conductive array line 210, then the circuitry would only need to switch 1V for both conductive array lines 205 and 210. This can be preferable to the alternative (-2V on the selected x-direction conductive array line 205 and +2V on the selected y-direction conductive array line 210), which would require the voltage to switch a total of 5V.

### Timing of Discharge

Since the memory cell is capable of being programmed with very little current, floating conductive array lines may create disturb conditions. If an unselected conductive array line inadvertently stays charged, it may be at a high enough voltage to affect the state of unselected cells on that line.

Discharging the selected conductive array line after a voltage has been applied is not only useful to avoid disturb conditions, but may be necessary in certain architectures where the line drivers are not strong enough to quickly drive a conductive array line from one state to another. As previously discussed, a reprogrammable memory experiences at least three different operational voltages: $-V_W$ (to be programmed into a high state) $+V_W$ (to be programmed into a low state), and $V_R$ (to read the data in the cell). Each conductive array line would typically carry half of the voltage such that only the selected cells in the array would experience the full voltage. In such a system, it is possible that a conductive array line be required to be driven to half $-V_W$ immediately after being held to half $+V_W$.

Since the most common reference voltage is ground, application of the reference voltage is referred to as "discharge." However, it should be understood that the lines could be equalized (tied together to a common node) to realize the same purpose.

FIG. 28 is a timing diagram showing the falling edge of the write select signal (labeled "Write Enable #") being used to discharge the array lines. The actual write operation is triggered by the rising edge of the Write Enable # signal with the address and data signals typically being latched. By using this falling edge, the conductive array lines are discharged prior to a write operation. The data and address information associated with the write operation are not applied to the memory array until after the conductive array lines are discharged.

FIG. 29 is a timing diagram showing the falling edge of the write select signal being used to discharge the conductive array lines. By the time the write select signal changes state, the data and address signals usually will have been applied and become stable. However, the write operation would be delayed by the discharged time, which may not be preferable in certain architectures as it would delay the write operation and slow the performance of the memory chip.

FIG. 30 is a timing diagram showing the conductive array lines being discharged at the end of a write operation. A prolonged write operation could saturate or damage the memory element. Accordingly, a timer is used to terminate the internal write operation. The falling edge of the internal write timer pulse is used to trigger a discharge pulse. Use of the timer ensures that the array lines are free of charge after the write operation, and ready for further operations.

FIG. 31 is a timing diagram showing the array lines being discharged both as the write mode is selected and at the end of the write operation, as defined by an internal write timer pulse. As will be appreciated by those skilled in the art, many of the discharge schemes can similarly be combined for improved operation.

FIG. 32 is a timing diagram showing the array lines being discharged by the write select signal falling edge, data or address transitions. Such discharge pulses are obtained with a signal transition detector, which will be further detailed in connection with FIG. 34. Such a scheme may be beneficial if a discharge is desired while the write select signal is not switching, if only one address or one data signal switches.

FIG. 33 is a timing diagram with multiple addresses switching at different times. The changes in the address create multiples signal transition pulses, which can be combined as a logical OR to create a transition detection pulse. The OR'd transition signal can then either act as a discharge signal or trigger a discharge signal.

In a first approach, the discharge signal is applied to conductive array lines while addresses are being decoded. Since the address bus has address signals switching at different times, and an internal delay may occur in the circuitry generating the discharge pulse, it is possible for some unselected array lines to switch momentarily, temporarily selecting the wrong memory cells, as is depicted by the "X, Y Lines" signal in FIG. 33. During a read operation the switching noise may disturb the following read operation.

In a second more preferable approach, the address signals going to the decoders of the array lines are delayed sufficiently so that the array lines would switch during the discharge pulse. Such a technique ensures a clean operation of the conductive array lines without spurious selection of unselected memory cells, therefore reducing switching noise, as depicted by the "X, Y Lines With Delayed Addresses" signal in FIG. 33. Such a scheme can be further used for continuous write operations where new data or new addresses trigger a new write while the memory chip stays in write mode. By ensuring that address transitions are clean and no intermediate lines get selected, write cycles can be accomplished without disturb to undesired memory cells.

The detection circuit can be made in many ways. FIG. 34A shows an exemplary schematic of a detection circuit 3400. The detection circuit is a logic AND gate 3405, which compares the input signal 3410 (whose edge is to be detected) and the same signal 3410 after it has been delayed and inverted 3415. When a transition on this signal 3410 occurs, the delayed and inverted transition 3415 will reach the AND gate 3405 later than the signal 3410 itself. During the time where the delayed signal has not reached the AND gate, the output 3420 of the gate will switch and a pulse is created. FIG. 34B shows the timing of the detection circuit

To detect both rising and falling edges, two such circuits can be combined, with inverted inputs and OR'ed outputs. If it is desired to trigger on only one edge (either rising or falling), only one such circuit is used.

Such a combination can be repeated for all address and control signals, and all the outputs of these circuits can be OR'ed together, so that if any of these signals transitions, a pulse will be generated. As explained above, the resulting pulse can be used to trigger a pulse of appropriate duration for discharge of the array lines. This transition detection pulse can then be used to control different elements of the memory circuits.

### *Single Transistor Array Design*

The cross point array is not the only type of memory array that can be used with a two-terminal memory element. FIG. 35 is a schematic representation of memory cells laid out in a two-dimensional transistor memory array 3500. Each memory cell in the transistor memory array 3500 is connected to one select line 3505, 3510, or 3515, one data line 3520, 3525, 3530, or 3535, and a reference line 3540 or 3545. In one embodiment, all reference lines 3540 and 3545 are held to the same voltage, and perhaps even tied together. Therefore, a single select line 3510 and a single data line 3525 uniquely define an individual memory cell 3550.

By connecting the select lines 3505, 3510, and 3515 to the gates of field effect transistors (FETs), the select lines 3505, 3510, and 3515 can control whether current from the data lines 3520, 3525, 3530, and 3535 are able to pass to the memory plugs. Although the transistor memory array 3500 depicts n-channel FETs controlling access to the memory plugs (e.g., 3555), many other semiconductor devices can be used. Such device can include p-channel FETs, pnp transistors, npn transistors, diodes, and many other devices, such as parasitic vertical bipolar transistors that consists of a p junction and an N well in a p substrate.

Additionally, the semiconductor device can either be placed in between the memory plug 3555 and the reference line 3540 or in between the memory plug 3555 and the data line 3525. In both configurations the semiconductor device is able to prevent the memory plug from experiencing a voltage drop between the data line 3525 and the reference line 3540 when the semiconductor device is turned off. However, in the former case the memory plug would still experience voltage changes associated with the changing data line 3525, but no voltage drop. In contrast, memory plug in the configuration of FIG. 35 is insulated from the voltage of the data line 3525 for as long as the semiconductor device is not activated.

The data lines 3520, 3525, 3530, and 3535 both carry the data from the memory cells during read operations and provides the memory cells with a voltage pulse appropriate to change the resistive state of the memory plug during write operations. Selection circuitry used to select a specific data line 3520, 3525, 3530, or 3535 would generally be placed outside the select transistor memory array 3500.

Table 3 shows the operational voltages that could be applied to the array in one possible embodiment of the invention.

**TABLE 3**

|  | Selected Data Line | Unselected Data Line | Selected Select Line | Unselected Select Line | Reference Line |
|---|---|---|---|---|---|
| READ | 1V | Floating or 0V | 3V | -2V | 0V |
| WRITE 1 | -2V | Floating or 0V | 3V | -2V | 0V |
| WRITE 0 | 2V | Floating or 0V | 3V | -2V | 0V |

In the embodiment of table 3, the reference lines 3540 and 3545 stay grounded. Activating more than one cell at a time may lead to voltage drops due to parasitic resistances. One technique that can be used to avoid this problem is to tie all the reference lines (e.g., 3540 and 3545) together at regular intervals. For example, including a line parallel to the data lines every 64 cells might ameliorate any unwanted voltage drops. Regardless of the technique used, it would generally be desirable to keep the reference line at a constant voltage.

During the read operation, the selected memory cell experiences a voltage drop of $V_R$'. It should be noted that current also flows through the unselected memory plugs along the selected select line 3510. An unselected memory cell along the selected select line 3510 would have its n-channel FET active, allowing current to flow. However, since the decoding circuitry only reads information off of the selected data line 3525, the current that flows through the unselected data lines 3520, 3530, and 3535 is not relevant to determining the stored value in the selected memory cell 3550. The voltage of the floating unselected data lines 3520, 3530, and 3535 must not, however, exceed either the positive voltage threshold ($V_{Wth}$) or negative voltage thresholds (-$V_{Wth}$) that can alter the resistive states in the unselected memory cells. Alternatively, the unselected data lines 3520, 3530, and 3535 might be held to some voltage in between $V_{Wth}$ and -$V_{Wth}$ (such as the reference voltage) if parasitic capacitance or some other correction mechanism was not thought to be sufficient to prevent the voltage from floating too high or too low.

Current does not flow through the other unselected memory plugs because their n-channel FETs do not have a gate voltage greater than the required threshold gate voltages. An unselected memory cell along the selected data line 3525 would have a gate voltage of -2V, which is lower than both the voltage of the selected data line 3525, which is 1V, and the reference voltage, which is 0V. Of course, any value of 0V or less could be used for the unselected select lines 3505 and 3515 during the read operation. As will be appreciated, the -2V value is used to allow for rapid transitions from a read to a WRITE 1 operation. Similarly, an unselected memory plug 3565 along an unselected data line 3535 and an unselected select line 3515 would have a gate voltage of -2V, which is lower than both the unselected data line, which cannot float to less than -2V, and the reference voltage, which is 0V.

The WRITE 1 operation puts the memory cell into the $R_1$ state. Similarly, the WRITE 0 operation puts the memory cell into the $R_0$ state. The unselected memory cells are not affected by the write operations because either their gates are not activated or the unselected data lines only float between voltages of $V_{Wth}$ and - $V_{Wth}$.

To generate internal write voltages, two on chip voltage converters can convert the chip power supply, typically 3V or 1.8V, to the required value. One voltage converter, for example, could produce a 2V signal, and the other might produce a -2V signal.

FIG. 36 is a diagrammatic cross sectional representation of the memory cell 3550 that can be used in a transistor memory array 3500. Each memory cell 3550 includes a transistor 3605 and a memory plug 3610. The transistor 3605 is used to permit current from the data line 3525 to access the memory plug 3610 when an appropriate voltage is applied to the select line 3510, which is also the transistor's gate. The reference line 3540 might span two cells if the adjacent cells are laid out as the mirror images of each other.

Depending upon the fabrication process (e.g., solution based spin on followed by high temperature anneal, pulsed laser deposition, sputtering, and metalorganic chemical vapor deposition) the fabrication temperature might require that substances such as polysilicon, silicide, and/or refractory metals be used for the layers that are formed below the memory plug 3610, such as the select lines 3505, 3510, and 3515 and some vias 3620 and 3625. Polysilicon and silicide have resistances of 3 to 30Ω/□ where copper metal lines typically have resistances of less than 0.1Ω/□. Therefore, certain embodiments employing polysilicon or silicide may have the chip be much longer in the data line-direction than the select line-direction

As long as no high temperature processes are required after the memory plug 3610 is deposited, a more standard conductive metal (e.g., copper or tungsten for the vias) can be used for the layers that come after, such as the reference line 3540, metal plugs 3635 and 3640, vias 3615, 3630, 3645, and 3650, and the data line 3525. The metal plugs 3635 and 3640 are one technique that can be used to connect the vias 3615, 3630, 3645, and 3650 after the memory plugs 3610 and 3655 have been deposited.

It should be appreciated that the memory plug 3610 and 3655 geometries that are depicted are merely one embodiment, and will not be the same for every transistor memory array 3500. For example, in certain processes, the memory plug 3610 and 3655 may be the same dimensions as the underlying vias 3620 and 3625. In yet other processes, the underlying vias 3620 and 3625 may be unnecessary, as the memory plugs 3610 and 3655 may be deposited directly on the transistor's drain.

### *Memory Chip Configuration*

FIG. 37A is a block diagram of a representative implementation of an exemplary 1 MB memory 3700. Physical layouts might differ, but each memory bit block 3705 is typically formed on a separate portion of a semiconductor substrate. It should be appreciated that a memory chip is not the only type of chip that could use a memory array, and many other types of chips would benefit from memory formed on the same substrate. For example, a microprocessor that has access to fast non-volatile L1 cache would be beneficial for many portable applications.

Referring back to FIG. 37A, inputs signals into the memory 3700 can include an address bus 3730, a control bus 3740, some power supplies 3750, and a data bus 3760. The control bus 3740 typically includes signals to select the chip, to signal whether a read or write operation should be performed, and to enable the output buffers when the chip is in read mode. The address bus 3730 specifies which location in the memory array is accessed -- some addresses going to the X block 3770 (typically including a predecoder and an X-decoder) to select one line out of the horizontal array lines. The other addresses go to a Y block 3780 (typically including a predecoder and a Y-decoder) to apply the appropriate voltage on specific vertical lines. Each memory bit block 3705 operates on one line of the memory chip data bus 3760.

The reading of data from a memory array 3720 is relatively straightforward: an x-line is energized, and current is sensed by the sensing circuits 3710 and converted to bits of information. FIG. 37B is a block diagram of an exemplary memory that includes sensing circuits 3715 that are capable of reading multiple bits. The simultaneous reading of multiple bits involves sensing current from multiple y-lines simultaneously.

During a write operation, the data is applied from the data bus 3760 to the input buffers and data drivers 3790 to the selected vertical lines, or bit lines. Specifically, when binary information is sent to the memory chip 3700, it is stored in latch circuits within the circuits 3790. Each y-line can either have an associated driver circuit 3790 or a group of y-lines can share a single driver circuit 3790 if the non-selected lines in the group are held to a constant voltage that would not cause the unselected memory plugs to experience any change in resistance. The driver circuit then writes the 1 or 0 to the appropriate memory plug during the appropriate cycle. For example, there may be 1024 y-lines in a cross point array, and the page register may include 8 latches, in which case the y-block would decode 1 out of 128 y-lines and connect this selected line to block 3790. As described below, certain memory plugs can have multiple stable distinct resistive states. With such multi-level resistance memory plugs, driver circuits could program, for example, states of 00, 01, 10 or 11 by varying write voltage magnitude or pulse length.

It is to be noted that such an architecture can be expanded to create a memory where one array handles all the bits of the data bus, as opposed to having multiple arrays, or memory bit blocks as described above. For example, if the data bus, or memory data organization, also called data width, is 16-bit wide, the y-block of one cross point array can be made to decode 16 lines simultaneously. By applying the techniques of simultaneous reads and 2-cycle writes, such a memory chip with only one array can read and program 16-bit words.

### Page Mode and Burst Mode

There are two common techniques used to output or input data in the page, often termed "page mode" and "burst mode." In both cases these modes take advantage of the internal architecture of memory. Words that are consecutive in address can be accessed faster with such modes, as the X/Y selection is only performed once, and the data for a number of words, which constitute a "page," is read or written at once, as opposed to being read or written one word at a time. This number of consecutive words read together and commonly referred as a "page" or an "information set."

In page mode, the lower significant bits of the address can be utilized to determine the order in which individual bits are to be read or written. The words selected by these address bit combinations can thus be in any order, and some words may not be read or written.

In burst mode the internal read or write operation is similar to page mode, but an external clock is used to sequentially input or output the words in the page. A post-sensing decoding block can be configured to simply sequentially output its information upon receipt of a trigger signal from an external burst clock. In this manner, information is either read from the decoding block or written to the cross point array automatically upon receiving the trigger signal. The advantage of burst mode over page mode is that no address decoding is needed to input or output the subsequent words in the page; this technique thus allows for a faster access time. The disadvantage of burst mode over page mode is that the page words can only be accessed in a set order.

Page or burst read can be accomplished by selecting multiple y-lines, connecting them to sensing circuits, and connecting the sensing circuit outputs to a post-sensing decoding block to select the appropriate data to bring to the pins of the memory integrated circuit. The page or burst write can be accomplished by selecting multiple y-lines, connecting them to the same number of drivers and energizing the drivers in a two-cycle sequence that writes in parallel all bits of the same data polarity (e.g., all binary 1's during the first cycle, and all binary 0's during the second). A pre-driver decoding stage would ensure that the data coming from the memory integrated circuit data pins is loaded in the appropriate latches.

FIG. 38A illustrates an exemplary latch 3810, drivers 3830 and 3840 and sensing circuit 3850 that can be used to accomplish two-cycle write operations. The circuit includes a page latch 3810 for storing one bit of information, AND gates 3860 and 3870 that receive signals from the page latch 3810 and inputs 3880 and 3890, an inverter 3820, and two drivers 3830 and 3840. The page latch 3810 is configured to hold a signal (either high or low signal depending on whether a 1 or 0 is received). Similarly, the inputs 3880 and 3890 are configured to receive the signal sequence shown in FIG. 38B. As one skilled in the art will appreciate, the write 1 signal is only high during the portion of the cycle where a write command is received, and the write 0 signal is only high during the portion of the cycle immediately following the write 1 cycle. It should be noted that the duty cycle of the write 0 and write 1 operations can either correspond to the system clock, some fraction or multiple thereof, or can be asynchronous.

On receipt of a high or low signal, the page latch 3810 then continues to emit a corresponding high or low signal for as long as is necessary to complete the two-cycle write. When it is desired to write this 1 or 0 to the appropriate memory plug, circuitry then transmits the signals of FIG. 38B to each AND gate 3860 and 3870. Specifically, a high signal is sent to the input 3880 of the AND gate 3860 attached to the 1 driver 3830 during a first cycle, followed by a high signal to the other input 3890 during a second cycle. One of skill can see that either the 1 driver 3830 or the 0 driver 3840 will then be triggered to apply a write voltage to the y-line, as shown in the table of FIG. 38C. In this manner, a bit is written to the page latch 3810, and either its 1 driver 3830 or 0 driver 3840 will apply +2V or -2V to the y-line so as to write this bit to an associated memory plug within two cycles. It can also be seen that electrically connecting each y-line of a word, or other group of memory plugs, to a group of driver circuits allows that entire word or group of data to be written in two cycles, i.e. one cycle to write the binary 1's, and one to write the binary 0's.

While these driver circuits allow for two-cycle write operations, it would also be desirable to conduct read and write operations in both page and burst modes, so as to further speed reads and writes. As discussed above, read operations in page mode can be accomplished by reading multiple words (or other groupings of data) from the memory cells to the sensing circuits 3850, which then output the appropriate words, possibly buffering the data so that it could be output when desired, based on receipt of an address bit or bits identifying a particular word.

When read operations are to be performed in burst mode, multiple words or other data are read into a buffer, and are output sequentially upon receipt of signals from a burst clock or other known device for generating a trigger signal at a particular time. Typically, the burst clock signal triggers the circuit block to output words or other data groupings in an orderly fashion, such as one at a time from left to right y-lines.

Write operations are performed in page mode or burst mode according to specific signals sent to the inputs 3880 and 3890. Each bit block would simultaneously perform either the write 1 cycle or the write 0 cycle, according to the state of the signals described in FIG. 38B. In this manner, multiple driver circuits write their information to a memory array simultaneously, in either page mode or burst mode. It is to be noted that write 1 cycle signal 3880 and write 0 cycle signal 3890 will also control the X-block 3770 (shown in FIG. 37) in order to switch the selected x-line polarity, for example from -2V in the first cycle to +2V in the second cycle.

FIG. 39A further exemplifies the behavior of the memory chip during a page or burst read. The write enable signal is set low, which sets the chip for a read operation. An address is asserted on the address bus and all bits within the page at the given address are internally read. The first data is output after a delay which corresponds to the first access time. The way the data is output is different in burst mode and in page mode.

In burst mode, no page addresses are specified, but the sense amps 3710 send their data to a set of logic circuits within the page register, the logic circuits also being connected to the data bus 3760. An external burst clock signal 3910 is used to trigger the logic circuits to sequence the output of the page data bits to the data bus 3760.

In page mode page addresses 3920 that specify which bits are being output within the page are given. More specifically, known decoder circuits are employed within the page register to receive page address signals and decode these address signals into an order in which bits are to be output to the data bus 3760.

Although both burst clock and page addresses signals are shown on FIG. 39A, only one of these signals would be used for any one given mode. Many variations can be inferred by those skilled in the art as to whether the first address may be at the boundary of a page or not, or the exact shape and timing of the burst clock. In essence these variations do not alter the scope of page or burst mode operations within the memory chip.

FIG 39B further exemplifies the behavior of the memory chip during a page or burst write. In burst mode, information is sent over the data bus 3760 to the logic circuits. A burst clock signal toggles repeatedly to trigger the logic circuits to latch successive bits of data. Further burst clock pulses and optional write enable pulses are used to enter further data. When the last burst clock pulse has been entered, for example the 4th pulse if the internal page is 4 words long, the internal write operation, which as above can be a two-cycle write, is triggered. As above, in page mode, the page register contains address circuits and decoder circuits. These circuits ensure that the data to be programmed is transmitted from the bus 3760 and loaded into the page register at the page address being input to the memory chip, according to a succession of write enable pulses while page data and page address signals are input to the memory chip. When the page register is full, or according to any other signal (such as a control signal or combination of signals), the memory chip triggers the page register/buffer/driver 3795 and decoding circuits 3770 and 3780 to select the desired memory locations and send information to their associated driver circuit according to the signal sequence of FIG. 38B.

Although both burst clock and page address signals are shown in FIG. 39B, only one of these signals would be used for any one given mode. Many variations in the way data and addresses as well as how the actual write operation is triggered can be contemplated without departing from the scope of this invention.

*Adaptive programming*

A high-level conceptual diagram of an adaptive programming circuit of the present invention is depicted in FIG. 40. The adaptive programming circuit 4000 includes a coupled detector 4010, controller 4020 and driver 4030. The detector 4010, being coupled to a memory cell, functions to detect a cell resistance $R_d$ and output an indicating signal identifying an $R_j$ within the multi-level resistance set $(R_1, R_2, ..., R_M)$ that corresponds to $R_d$, where $M \geq 2$. Identifying an $R_j$ can be accomplished by determining $R_d$'s closest neighbor out of the multi-level resistance set $(R_1, R_2,..., R_M)$.

The controller 4020, being coupled to the detector 4010, functions to detect a write command with write-data and the indicating signal and to generate an activating signal when a write is desired. The driver 4030, being coupled to the re-writable memory and the controller 4020, functions to drive, only while the activating signal is in the activated state, the memory to the desired resistance. The controller 4020 can further include activating logic functions as follows:

(a) an absence of the write command (or the presence of a read command) sets the activating signal to a deactivated state, thus insuring that the memory device is not driven by the driver 4030.
(b) a presence of the write command activates a comparison of the indicating signal with the write-data; and
(b1) a non-correspondence between the indicating signal and the write-data sets the activating signal to an activated state while continuing function (b) thus causing the driver 4030 to drive the re-writable memory device to effect a desired switching of the memory cell resistance among the multi-level resistance set; or
(b2) a correspondence between the indicating signal and the write-data sets the activating signal to a deactivated state and terminates the programming cycle.

Notice that logic element (b2) above, in addition to completing the adaptive aspect of the adaptive programming circuit 4000, also functions to avoid a redundant programming cycle where the resistive state of the memory cell already corresponds to the write-data before the programming cycle. Repetitive redundant programming cycles can potentially cause a shortening of the memory device operating life.

To deal with re-writable memory devices that either are unreasonably hard to program or would require an unreasonably long programming cycle time or simply have failed in time, the controller 4020 can further include a pre-determined maximum allowable programming time $T_{max}$ and a timer tracking an elapsed time $T_{lp}$ of the programming cycle from the moment of presence of the write command. Correspondingly, the above activating logic can be first modified to include a Logic Fault Signal (LFS). For example, LFS = 1 can mean a fault condition and LFS = 0 can mean a no-fault condition. Specifically, the activating logic can add to function (b) a logic that sets LFS = 1 if $T_{lp} > T_{max}$. The activating logic can further include the following changes:

1. logic element (a) includes an additional, unconditional initialization of LFS to 0.
2. logic element (b1) is replaced with the following two logic elements:

(b11) a non-correspondence between the indicating signal and the write-data, while LFS = 0, sets the activating signal to an activated state while continuing function (b) thus causing the driver 4030 to drive the re-writable memory device to effect a desired switching of the resistive state of the memory cell among the multi-level resistance set; or
(b12) a non-correspondence between the indicating signal and the write-data, but LFS = 1, sets the activating signal to a deactivated state and terminates the programming cycle.

For simplicity of implementation in practice, to effect the function of detecting the memory cell's resistance and outputting an indicating signal identifying an $R_j$ within the multi-level resistance set $(R_1, R_2, ..., R_M)$ that $R_d$ corresponds to, the detector 4010 includes an equivalent-signal $S_{eq}$ generator, whose value corresponds to $R_d$ through a pre-determined function $R_d = f(S_{eq})$.

The detector 4010 further selects an equivalent-reference signal set $(REF_1, REF_2, ..., REF_M)$, depending upon the write data. A base reference signal will typically be an input to the adaptive programming circuit 4000, or derived from resistive circuitry within the adaptive programming circuit 4000. Additionally, the detector 4010 compares $S_{eq}$ with an appropriate reference signal from the equivalent-reference signal set $(REF_1, REF_2, ..., REF_M)$.

For one example, the driver 4030 is switchable by the activating signal voltage source with an output voltage $V_{cs}$, the equivalent-signal $S_{eq}$ generator can be a current detector, coupled to the memory device, providing the memory device current $I_d$ as the equivalent-signal $S_{eq}$. That is $S_{eq} = I_d$. Consequently, the pre-determined function $R_d = f(S_{eq})$ can simply be $R_d = V_{es}/I_d$ by Ohm's law. Where the output voltage $V_{cs}$ is a constant voltage, of course, its magnitude must exceed each respective threshold voltage to effect a desired switching of $R_d$ among the multi-level resistance set. As a higher $V_d$ generally results in a shorter device programming cycle time, for those re-writable memory devices having high threshold voltages, the $V_{cs}$ can be set as a time-varying voltage ramp or voltage steps of increasing magnitude so as to exceed each respective threshold within a pre-determined time interval to shorten the programming cycle time. Of course, the initial value of the time-varying voltage ramp can be set at or above a corresponding threshold voltage of the re-writable memory device to further shorten the programming cycle time.

For another example, the driver 4030 is, by the activating signal, a switchable current source with an output current $I_{cs}$ the equivalent-signal $S_{eq}$ generator can be a voltage detector, coupled to the writable memory device, providing the memory device voltage $V_d$ as the equivalent-signal $S_{eq}$. That is $S_{eq} = V_d$. Consequently, the pre-determined function $R_d = f(S_{eq})$ can be $R_d = V_d/I_{cs}$, also by Ohm's law. Where the output current $I_{cs}$ is a constant current, of course, its magnitude must cause the corresponding $V_d$ to exceed each respective threshold voltage to effect a desired switching of $R_d$ among the multi-level resistance set. As a higher $V_d$ generally results in a shorter device programming cycle time, for those memory devices having high threshold voltages, the $I_{cs}$ can be set as a time-varying current ramp or steps of increasing magnitude so as to cause the corresponding $V_d$ to exceed each respective threshold within a pre-determined time interval to shorten the programming cycle time. Of course, the initial value of the time-varying current ramp can be set to cause the corresponding $V_d$ to be at or above a corresponding threshold voltage of the re-writable memory device to further shorten the programming cycle time.

By now it should become clear that, in addition to being an adaptive programming circuit, the adaptive programming circuit 4000 is equally applicable to a method of programming the re-writable memory device with a sequence of steps logically corresponding to the above attributes of the adaptive programming circuit. It should also be clear that, except for insuring that $V_d$ stays below each respective threshold to avoid the switching of $R_d$, essentially the same adaptive programming circuit can be adapted to effect a read operation outputting an indicating signal identifying an $R_j$ that $R_d$ corresponds to upon detection of a read-command. Additional, even more detailed embodiments of the detector 4010, the controller 4020 and the driver 4030 will be presently illustrated graphically.

FIG 41A depicts a first more detailed embodiment of an exemplary adaptive programming circuit 4100. In this case the multi-level resistance set $R_j$ consists of only two distinct resistance levels $R_1 < R_2$, that is M = 2. As part of the detector 4010, the equivalent-reference signal set selector includes a reference driver 4105 working in conjunction with a reference data source 4110 to provide an equivalent-reference signal $REF_1$ at node B of a comparator 4115. The driver 4030 includes a program supply 4120 and a data driver 4125. The program supply 4120 outputs write-data. The data driver 4125 is a voltage source with an output voltage $V_{cs}$ for effecting an actual programming of the memory device according to the write-data. The equivalent-signal $S_{eq}$ generator is a current detector 4130, coupled to the memory device, providing the equivalent-signal $S_{eq} = I_d$ at node A. Consequently, the pre-determined function $R_d = f(S_{eq})$ is $R_d = V_{cs}/I_d$. Hence, this particular embodiment essentially employs a current comparison technique and the output of the comparator 4115 is logically the indicating signal identifying an $R_j$ within the multi-level resistance set $(R_1, R_2)$ that $R_d$ corresponds to. The controller 4020, in this case a single feedback signal path, functions to either activate or deactivate the data driver 4125 depending upon the correspondence between the indicating signal and the write-data.

The current comparison technique is further illustrated with a numerical example. Here the selected re-writable memory device to be programmed is in the low resistive state with $R_d$ corresponds to $R_1$. When a write voltage $V_W$ is initially applied to the cell $I_d = 40$ $\mu$A before any resistance switching takes place. The comparator 4115 includes a reference current set at 20 $\mu$A, a similar load circuit for the reference current and the selected memory device and a voltage comparator. The load circuits are basically resistor networks connected to the voltage source $V_{cs}$. As the reference current is 20 $\mu$A and the selected memory device current is 40 $\mu$A, the voltage on node A will be lower than that on node B causing the output of the voltage comparator to be high. Instead the comparator could be connected with a different polarity of input so that its output would be low, but this would not change the nature of this invention. In time, as the write voltage $V_W$ starts to switch the resistance of the selected memory device, its current $I_d$ decreases from 40 $\mu$A until it reaches the reference current of 20 $\mu$A. At this point node A voltage equals node B voltage. As the programming of the selected memory device progresses further, node A voltage becomes higher than node B voltage that causes the voltage comparator to trip into a state of low output voltage. Hence, the voltage comparator output can be used to deactivate the data driver 4125, thus turning off the write voltage $V_W$ applied to the selected memory device.

On the other hand, if the selected memory device to be programmed is already in the high resistive state with $R_d$ corresponds to $R_2$ thus, for example, $I_d = 15$ $\mu$A at start of the programming operation, the comparator output will stay low and the data driver will stay deactivated.

Notice that the above circuit needs to be properly initialized. If, at the beginning of the write cycle, the node A voltage starts at a value higher than the node B voltage, the output of the voltage comparator is low thus the data driver 4125 stays disabled. The consequence is that the program operation would never start. To avoid this problem a discharge circuit and an initialization pulse can be used to force node A voltage low at the beginning of each program operation.

It is further remarked that, while only one reference current is needed in the above example for minimum functionality, this would not provide a'more precise resolution of the actual resistance values $R_1$ and $R_2$. Thus, if so desired, additional reference current levels can be included in the adaptive programming circuitry to further improve the detection margin of the various resistance levels.

As already remarked before, the programming voltage pulse does not have to be a square pulse of constant amplitude. A further improvement would be to use a ramp on the programming voltage, starting at a low initial voltage value and increasing with time. The initial voltage can start somewhere at or above the read voltage and can go as high as the circuitry allows. For a cross point array, that means the voltage should not disturb unselected memory devices on the selected array lines. This technique, combined with the comparison technique, would insure that memory devices with a fast programming cycle time get programmed quickly at a relatively low voltage. On the other hand, memory devices with a slow programming cycle time can be programmed faster than if a constant voltage was applied as a write voltage. Furthermore, if a memory device has a very high write threshold voltage it may never program under a normal constant voltage drive. Here, by increasing the write voltage it may become possible to program this memory device. However, it may not be desirable to program all the memory devices of the array with the increased write voltage as this could prematurely wear out or even damage those memory devices easily programmable at lower voltage levels.

Figure 41B depicts a second more detailed embodiment of an exemplary adaptive programming circuit 4150. The multi-level resistance set $R_j$ still consists of only two distinct resistance levels $R_1 < R_2$, that is M = 2. As part of the detector 4150, the equivalent-reference signal set selector includes a reference data source 4110 providing an equivalent-reference signal $REF_1$ at node B of a comparator 4115. The driver 4030 includes the program supply 4120 and a data driver with voltage detector 4155 outputting a detected re-writable memory device voltage $V_d$ at node A. The program supply 4120 outputs write-data. The data driver with voltage detector 4155 includes a current source with an output current $I_{cs}$ for effecting an actual programming of the re-writable memory device according to the write-data. Thus, the equivalent-signal $S_{eq}$ generator is the above voltage detector, coupled to the re-writable memory device, providing the equivalent-signal $S_{eq} = V_d$, at node A. Hence, this particular embodiment essentially employs a voltage comparison technique and the output of the comparator 4115 is logically the indicating signal identifying an $R_j$ within the multi-level resistance set $(R_1, R_2)$ that $R_d$ corresponds to. The controller 4020, in this case a single feedback signal path, functions to either activate or deactivate the data driver with voltage detector 4155 depending upon the correspondence between the indicating signal and the write-data.

FIG. 42 depicts a third circuit schematic level embodiment of an exemplary adaptive programming circuit 4200 with a bipolar voltage driver, a current comparison circuit and activating logic. This circuit schematic uses two references so that the programmed resistance states $R_1$ and $R_2$ are separated by a pre-determined margin. Correspondingly, the adaptive programming circuit 4200 includes upper half circuitry to provide the required positive voltage driver and lower half circuitry, being essentially a mirror image of the upper half circuitry, to provide the required negative voltage driver. For convenience, the upper half circuitry is also called positive drive circuitry and the lower half circuitry is also called negative drive circuitry. While both the positive drive circuitry and the negative drive circuitry are logically driven by a write command pulse 4205, the positive drive circuitry is only activated with a write-data $R_2$ signal 4210 whereas the negative drive circuitry is only activated with a write-data $R_1$ signal 4215. In this way, during a programming operation with a positive voltage drive the negative drive circuitry is deactivated in a state of high impedance to avoid any interference with the positive drive circuitry, and vice versa.

Focusing on the details of the positive drive circuitry, the controller 4020 includes an activating logic 4225 in turn driving both a device pre-driver 4220 and, through an $R_2$ reference pre-driver 4235, an $R_2$ reference driver 4240. The device pre-driver 4220 drives a $+V_{Wth}$ device driver 4230 whose output drives a selected re-writable memory device within the re-writable memory array. In parallel, the $+V_{Wth}$ device driver 4230 output, through a signal branch at node A, also feeds a negative terminal of a comparator 4260. The $R_2$ reference driver 4240 output, in combination with an $R_2$ reference resistance 4250, establishes an equivalent-reference signal $REF_1$ at node B that feeds a positive terminal of the comparator 4260. Except for working in a domain of negative voltage with a $-V_{Wth}$ device driver 4280, by now it should become clear that the negative drive circuitry has a similar circuit topology and functions, in a way similar to the positive drive circuitry above, to accomplish the desired function of adaptive programming. It is also instructional to note that, while FIG. 42 depicts an embodiment with a bipolar voltage drive, there is nevertheless a typically small drain-to-source voltage drop across the $+V_{Wth}$ device driver 4230 and the $-V_{Wth}$ device driver 4280. Furthermore, the drain-to-source voltage drop itself is dependent upon the memory device current $I_d$. Thus, the driving circuit can also be characterized as a hybrid combination of voltage and current source.

Lastly, for those skilled in the art, the circuit topology of FIG. 42 is used for detecting $R_d$ between two levels separated by two reference levels in between to affect a higher detection resolution of $R_d$ with a correspondingly higher margin of correct logic decision.

FIG. 43 depicts an exemplary timing diagram of signals and memory device currents during an application of the present invention in a re-writable memory array. In this example, a first device A within the re-writable memory array is programmed with a low resistance state, a second device B is programmed with a low resistance state and a third device C is programmed with a high resistance state. Notice the self-adapting nature of the activating signal having a variable pulse width each corresponds to an individual memory device being programmed. That is, device A exhibits a typical programming cycle time of $t_{A2}-t_{A1}$, cell B exhibits a fast programming cycle time of $t_{B2}-t_{B1}$ while cell C exhibits a slow programming cycle time of $t_{C2}-t_{C1}$.

FIG. 44 illustrates another embodiment of the adaptive programming circuit extended to a general case where the re-writable memory device exhibits a multi-level voltage switchable resistance set of more than two resistance levels. To avoid unnecessary obscuring aspects of the present invention only section-j of adaptive programming circuit 4400 is illustrated here where j = (1,2, ..,M-1), M >= 3 and R1 < R2 < .. < RM. Furthermore, it should be understood that all similar sections are set in parallel, with a common connection at node A. First of all, the entire section-j of adaptive programming circuit 4400 is selected by a section-j selection signal 4405, where j would be the distinct state that is desired. If the j-state is higher than the initial state of the memory plug, section-j selection signal 4405, for Rj programming, activates a reference $R_{jlow}$ generator 4410 to establish an equivalent-reference signal $REF_{jlow}$ at node B1 that feeds a first input terminal of a comparator 4415. The output of the comparator 4415, while in an activated state, in turn activates a low $R_d$ device driver 4420 through a feedback signal path 4425 to drive a selected memory device within the re-writable memory array causing a switching of $R_d$ into the $R_j$-state. In parallel, the low $R_d$ device driver 4420 output, through a signal branch at node A, also feeds a second input terminal of the comparator 4415 to complete the adaptive programming logic for resistance $R_j$. Similarly, if the j-state is lower than the initial resistance state of the memory plug, the section-j selection signal 4405, for $R_{jhigh}$ programming, activates a reference $R_j+1$ generator 4430 to establish an equivalent-reference signal $REF_{jhigh}$ at node B2 that feeds a first input terminal of a comparator 4435. The output of the comparator, while in an activated state, in turn activates a high $R_d$ device driver 4440 through a feedback signal path 4445 to drive a selected memory device within the re-writable memory array, causing a switching of $R_d$ into the $R_j+1$-state. In parallel, the high $R_d$ device driver 4440 output, through the signal branch at node A, also feeds a second input terminal of the comparator 4435 to complete the adaptive programming logic for resistance $R_j$. At the beginning of the write, if the selected cell resistance is above $R_{jhigh}$ the low $R_d$ driver 4420 will turn on. If the selected cell resistance is below $R_{jlow}$ the high $R_d$ driver 4440 will turn on. At the end of the write operation the selected cell's resistance will be between $R_{jlow}$ and $R_{jhigh}$.

As an alternative embodiment, FIG. 45 depicts a block diagram of yet another implementation of an exemplary adaptive programming circuit 4500. The state-j selection signal 4505, which tells the circuit which is the desired state out of M states, and includes typically k lines, so that M = 2k, can be applied to the two reference generators 4510 and 4530, and possibly also to the device drivers 4520 and 4540, to adjust these reference generators and device drivers so that their outputs equal to a respectively desired level appropriate for the state-j programming. Unlike the embodiment of FIG. 44, this approach requires only two comparators 4515 and 4535, two adjustable references 4510 and 4530 and two adjustable drivers 4520 and 4540. This is an advantage where no replication of the section-j circuit would be necessary to implement the programming of the multi-level resistance set ($R_1$, $R_2$, ... $R_M$).

### Memory Plug

Each memory plug contains layers of materials that may be desirable for fabrication or functionality. For example, one desirable function might be a non-ohmic characteristic. A non-ohmic characteristic might exhibit a very high resistance regime for a certain range of voltages ($V_{NO-}$ to $V_{NO+}$) and a very low resistance regime for voltages above and below that range. In a cross point array, a non-ohmic characteristic could prevent leakage during reads and writes if half of both voltages were within the range of voltages $V_{NO-}$ to $V_{NO+}$. If each conductive array line carried 1/2 $V_W$, the current path would be the memory plug at the intersection of the two conductive array lines that each carried 1/2 $V_W$. The other memory plugs would exhibit such high resistances from the non-ohmic characteristic that current would not flow through the half-selected plugs.

A non-ohmic device might be used to cause the memory plug to exhibit a non-linear resistive characteristic. Exemplary non-ohmic devices include three-film metal-insulator-metal (MIM) structures and back-to-back diodes in series. Separate non-ohmic devices, however, may not be necessary. Certain fabrications of the memory plug can cause a non-ohmic characteristic to be imparted to the memory cell. While a non-ohmic characteristic might be desirable in certain arrays, it may not be required in other arrays.

Electrodes will typically be desirable components of the memory plugs, a pair of electrodes sandwiching the memory element. If the only purpose of the electrodes is as a barrier to prevent metal inter-diffusion, then a thin layer of nonreactive metal, e.g. TiN, TaN, Pt, Au, and certain metal oxides could be used. However, electrodes may provide advantages beyond simply acting as a metal inter-diffusion barrier. Electrodes (formed either with a single layer or multiple layers) can perform various functions, including: prevent the diffusion of metals, oxygen, hydrogen and water; act as a seed layer in order to form a good lattice match with other layers; provide adhesion layers; reduce stress caused by uneven coefficients of thermal expansion; and provide other benefits.

For example, a conducting oxide electrode might modify the formation and migration of oxygen vacancies. Oxygen vacancies in certain embodiments can cause degradation of electrical properties in the memory plug. A conducting oxide electrode can also withstand high temperature processing. Most non-refractory metals either start oxidizing or combining with adjacent materials at temperatures above 400C. Accordingly, fabrication processes above these temperatures can be considered to be high temperature processing. Additionally, conducting oxide electrodes will not degrade during operation. Regular metal electrodes may degrade due to the electric field assisted metal migration and interaction between the metal atoms and the memory material atoms.

Examples of conductive oxides include $LaSrCoO_3$, $RuO_2$, $IrO_2$, $SrRuO_3$, $LaNiO_3$ and doped strontium titanate (STO). The dopant used in STO can be either Nb or Ta to substitute for titanium atoms, or any rare earth such as La or Pr to substitute for strontium atoms. Generally, a conducting oxide electrode is metallic with resistivity below 1 $\Omega$-cm.

Conducting oxide electrodes can be fabricated directly, or can be made with a material that is not initially an oxide, but is subsequently oxidized during further processing or operation. Ru and Ir are both examples of materials that can be oxidized during processing or operation.

Additionally, certain materials oxidize at a finite rate and allow dual layers to form. For example, Ir might be particularly well suited for making contact to an underlying conductive array line layer. When Ir is oxidized, the top of the Ir layer becomes $IrO_2$. Since the $IrO_2$ grows at a finite rate it becomes possible to control the oxidation so that a dual layer of $Ir/IrO_2$ is formed. Such a dual layer could provide a good contact on the un-oxidized bottom while still forming an oxygen barrier on the oxidized top.

Furthermore, some conductive oxides electrodes form a good lattice match with other layers, and thus lower crystallization temperature for those layers. For example, if an oxide such as STO is to be deposited on top of a conductive electrode, possible conductive oxide electrodes that make a good lattice match include doped STO, $LaSrCoO_3$, and $SrRuO_3$. If the oxide is PCMO, possible conductive oxide electrodes include the STO electrodes and also $LaNiO_3$. A seed layer will often be used on top of a thin layer of metal. A seed layer will help the formation of the layer grown or deposited above it. For example, the seed layer could be on Pt, Ru, Ir or TiN. Some seed layer/metal layer matches include $LaNiO_3$ or $SrRuO_3$ on Pt, $IrO_2$ on Ir, $RuO_2$ on Ru, and Pt on TiN.

Another benefit to certain conductive oxide electrodes is that stress may be reduced by more closely matching the conductive oxide electrode's coefficient of thermal expansion to the oxide. The electrodes might be further improved by using a layer of metal such as thin platinum, less than 100 Å, between the oxide and the conductive oxide electrode. Such implementations advantageously provide a good Schottky barrier with the conductive oxide to minimize cell leakage current, and a good contact with an adjacent metal layer. The Schottky barrier can provide a desired non-linearity of a non-ohmic device.

Barrier layers are generally helpful to prevent inter-diffusion of atoms after different materials have been deposited. For example, barrier layers can block the diffusion of metals, oxygen, hydrogen or water. Binary oxides or nitrides with 2 elements and ternary oxides or nitrides with 3 elements are particularly suited to high temperature processing. Unlike a regular electrode like titanium that oxidizes and becomes non-conductive, titanium nitride will remain conductive and will not oxidize until about 500C. Ternary nitrides oxidize at even higher temperatures, typically about 50C higher than binary nitrides. The rate of oxidation depends on the temperature and the oxygen partial pressure.

Examples of binary nitrides include titanium nitride, tantalum nitride and tungsten nitride. Examples of ternary nitrides include titanium silicon nitride, tantalum aluminum nitride, tantalum silicon nitride, and ruthenium titanium nitride. An example of a ternary oxide is ruthenium tantalum oxide.

As will be appreciated by those skilled in the art, an electrode may require other layers, in order to properly function. For example adhesion layers are sometimes necessary. An adhesion layer is used between a substrate and thin-film layer to improve adhesion of the thin-film layer to substrate. Pt does not stick well to $SiO_2$, so a glue layer, such as Ti or $TiO_2$, is used between them for better adhesion. Similarly, a sacrificial barrier layer is an oxide layer that is deposited for the sole purpose of capturing all the oxygen that could otherwise diffuse into other layers, such as the oxide. The electrode is considered to include any adhesion or sacrificial barrier layers, as required.

For example, an electrode may include a TiN or TiAlN layer, an Ir layer and an $IrO_2$ layer to have good metal barrier and oxygen barrier properties. However, such additional layers are only necessary to the extent they are required. Certain conductive oxide electrodes may provide multiple functions. For example, ternary nitrides and ternary oxides that have one component that is either ruthenium or iridium and another component that is either tantalum or titanium can act as both a barrier layer and a sacrificial high-temperature oxygen barrier.

Additionally, the choice of electrode layers can affect the memory effect properties of the memory plug and become part of the memory element.

*Memory Effect*

The memory effect is a hysteresis that exhibits a resistive state change upon application of a voltage while allowing non-destructive reads. A non-destructive read means that the read operation has no effect on the resistive state of the memory element. Measuring the resistance of a memory cell is generally accomplished by detecting either current after the memory cell is held to a known voltage, or voltage after a known current flows through the memory cell. Therefore, a memory cell that is placed in a high resistive state $R_0$ upon application of $-V_W$ and a low resistive state $R_1$ upon application of $+V_W$ should be unaffected by a read operation performed at $-V_R$ or $+V_R$. In such materials a write operation is not necessary after a read operation. It should be appreciated that the magnitude of $|-V_R|$ does not necessarily equal the magnitude of $|+V_R|$. In certain cases the details of the voltage pulse can actually affect the resistance of a memory plug. For example, the paper "New Conduction and Reversible Memory Phenomena in Thin Insulating Films" by J.G. Simmons and R.R. Verderber, 301 Proc. Roy. Soc. A. 77-102 (1967), describes a memory effect on certain MIM structures that are controlled by details of the voltage pulse duration and height. In such a system, bringing an MIM structure to a certain voltage, and then quickly dropping the voltage to zero would achieve a different resistance state than bringing the MIM structure to the same voltage and then slowly decreasing the voltage to zero. In such a system voltage pulses of opposite polarity are not needed.

The $R_1$ state of the memory plug may have a best value of 10kΩ to 100kΩ. If the $R_1$ state resistance is much less than 10kΩ, the current consumption will be increased because the cell current is high, and the parasitic resistances will have a larger effect. If the $R_1$ state value is much above 100kΩ, the RC delays will increase access time. However, workable single state resistive values may also be achieved with resistances as low as 5kΩ and as high as 1MΩ. Typically, a single state memory would have resistive values of $R_0$ and $R_1$ separated by a factor of 10.

For example, if 1 volt were used as a read voltage ($V_R$), $R_1$ might be about 100kΩ and $R_0$ might be about 1MΩ, making the current either 10μA or 1μA, depending on the resistive state. Since large currents can be destructive to semiconductors fabricated to small dimensions, no more than 100μA would be desired for a memory circuit in most cases. Once a $V_R$ is identified, a desired write voltage ($V_W$) can also be determined. Not only should $V_W$ be greater than $V_R$, but it should also be far enough away from $V_R$ to allow minor voltage fluctuations (e.g., due to fabrication imperfections) to have a negligible effect on the memory plug. Similarly, $V_W$ should be greater than $V_{Wth}$, the threshold at which the resistive material starts to change resistivity, for the same reason. A typical $V_W$ might be about 2 volts, and $V_{Wth}$ might be about 1.5 volts.

It should be noted that changes in the resistive property of the memory plugs that are greater than a factor of 10 might be desirable in multi-bit resistive memory cells. Since memory plugs can be placed into several different resistive states, multi-bit resistive memory cells are possible. For example, the memory plug might have a high resistive state of $R_{00}$, a medium-high resistive state of $R_{01}$, a medium-low resistive state of $R_{10}$ and a low resistive state of $R_{11}$. Since multi-bit memories typically have access times longer than single-bit memories, using a factor greater than a 10 times change in resistance from $R_{11}$ to $R_{00}$ is one way to make a multi-bit memory as fast as a single-bit memory. For example, a memory cell that is capable of storing two bits might have the low resistive state be separated from the high resistive state by a factor of 100. A memory cell that is capable of storing three or four bits of information might require the low resistive state be separated from the high resistive state by a factor of 1000. Typically, the intermediary resistive states in a multi-bit memory would evenly subdivide the resistive range between the high resistive state and the low resistive state on a logarithmic scale. For example, if a memory cell that held three bits of memory had a low resistive state of 10kΩ, the six intermediary states might have resistive states of about 26.8kΩ, 72.0kΩ, 193kΩ, 518kΩ, 1.39MΩ, and 3.73MΩ. The highest resistive state would then be 10MΩ, 1000 times the value of the low resistive state.

*Creating The Memory Effect*

Although the memory effect properties of the memory plug appear to be dominated by carrier trapping, other carrier transport mechanisms such as oxygen migration or electrolyte migration may be present. Even within carrier charge trapping, dominant factors can include space-charge limited currents, thermionic emission limited conduction, electrothermal Poole-Frenkel emission, or Fowler-Nordheim quantum tunneling. While the inventors note that experimental data is consistent with the memory effect being created primarily by carrier trapping, they do not wish to be bound by any explanation of how the memory effect is created or how any other effect that is described herein functions.

Additionally, different mechanisms may be responsible for a memory effect depending upon whether the interface has been "formed." Forming, (or "electroforming") as it relates to a MIM structure, was described in "The Electroformed metal-insulator-metal structure: a comprehensive model," J. Phys. D: Appl. Phys. Vol. 35, pp. 802 - 809, 2 April 2002 by R E. Thurstans and D. P. Oxley, and can be thought of as "the localized filamentary movement of metallic anode material through the dielectric, induced by the electric field. Here it is important to note that the evaporated dielectric may contain voids and departures from stoichiometry. When resulting filaments through the dielectric carry sufficient current, they rupture to leave a metal island structure embedded in the dielectric. Electronic conduction is possible through this structure by activating tunneling." However, the authors caution, "The forming process is complex and inherently variable. Also tunneling barriers are susceptible to changes in their characteristics when exposed to water vapour, organic species and oxygen.... Thus, device characteristics can never be expected to be produced consistently or be stable over long periods without passivation, effective encapsulation and a better understanding of the dynamics of the forming process."

Contrary to the warnings of Thurstans and Oxley, certain methodologies can be used to direct and control forming, and even obtain a memory effect without forming. For example, simply exposing a reactive metal layer to an oxide can create a memory effect without forming. It is believed that in those circumstances the memory effect is created through an interface between the oxide and the reactive metal layer.

A formed structure can also be approximated by depositing islands of one material within the bulk of a second, more insulating material. Islands (as opposed to a continuous thin film) can be formed by a number of different processes, including sputtering, co-sputtering, evaporation, molecular beam epitaxy, atomic layer deposition, implantation, etc, and are typically related to the surface energies of the two materials. Those skilled in the art will appreciate that a first material can form islands on the surface of a second material under some processes and not others.

In one specific embodiment, a portion of a non-organic semiconductive material is first deposited on an electrode. Then, conductive islands are formed on the semiconductive material. After the islands are formed, another portion of the same semiconductive material is deposited on the islands. Then, either a top electrode is formed or additional island/semiconductive material layers are formed prior to the top electrode.

As a more specific example, a damascene process could be employed where an interlayer dielectric such as $SiO_2$ is patterned on top of a bottom electrode in order to create voids over the bottom electrodes. Aluminum oxide can then be deposited and polished off the $SiO_2$ surface such that a portion of the void is filled with aluminum oxide. A small amount of conductive metal or oxide could then be formed on top of the aluminum oxide, which will preferentially nucleate into an array of island formations on the aluminum oxide. Another layer of aluminum oxide could then be sputtered fill more the void, followed by another polish and then another deposition of islands. A final layer of aluminum oxide could then be deposited to completely fill the void, followed by a final polish so that the $SiO_2$/aluminum oxide surface was smooth.

*Interfacial layer*

The interface layer is typically a very thin layer because the reaction that is created by placing the oxide in contact with the reactive metal only extends a short distance, typically less than 100 angstroms. The thickness of the interfacial layer can be controlled by limiting the thickness of the reactive metal. Although the interfacial layer can be placed into different resistive states, even the lowest resistive state is typically very insulating. Accordingly, a thick interfacial layer would not allow any current to pass through the memory cell in an optimal period of time. To allow rapid access times (on the order of tens of nanoseconds, typically below 100 ns) in small dimension devices (on the order of hundreds of nanometers), the entire memory plug should have a resistivity of not more than about 1 ohm-cm.

The oxide will generally (but not necessarily) be a conductive crystalline metal oxide -- either as a single crystalline structure or a polycrystalline structure. One class of conductive oxides are perovskites that include two or more metals, the metals being selected from the group consisting of transition metals, alkaline earth metals and rare earth metals. The perovskites (generally in the form of $ABX_3$ structures, where A has an atomic size of 1.0-1.4 Å and B has an atomic size of 0.45 - 0.75 Å for the case where X is either oxygen or fluorine) can be any number of compositions, including manganites (e.g., $Pr_{0.7}Ca_{0.3}MnO_3$, $Pr_{0.5}Ca_{0.5}MnO_3$ and other PCMOs, LCMOs using lanthanum and calcium as A, etc.), titanates (e.g., $SrTiO_3$ doped with Cr, also identified as STO:Cr), zirconates (e.g., $SrZrO_3$ doped with Cr, also identified as SZO:Cr), other materials such as $Ca_2Nb_2O_7$:Cr, and $Ta_2O_5$:Cr, and high Tc superconductors (e.g., yttrium barium copper oxide, also identified as YBCO). Specifically, $MnO_3$, when combined with the rare earth metals La, Pr or some combination thereof and the alkaline earth metals Ca, Sr or some combination thereof have been found to be effective for use in the memory plug.

Further, some oxides that may not be conductive in their pure form may be used as they become conductive through the addition of dopants, or if they are used as a very thin layer (e.g., in the order of tens of Angstroms) in which case tunneling conduction can be achieved. Therefore, as will be appreciated by those skilled in the art, oxides that are classified as insulators, but are thin enough to allow tunneling conduction, can still be considered conductive oxides. Since a memory plug will need to be able to be switched at low currents, low resistances are desirable - making conductive oxides more attractive than insulating oxides.

Whether a metal is a "reactive metal" is determined by its relation to the conductive metal oxide, and whether the metal is a strong enough reducing agent to reduce the conductive metal oxide and be oxidized, and whether the resulting oxidized reactive metal is insulating. For example, Al will reduce a PCMO perovskite in order to form an insulating interfacial layer having a memory effect. Other reactive metals, depending on the conductive metal oxide, can include Ta, Ti, Zr, Y, Hf, Cr and Mg.

In one embodiment, the interfacial layer can be considered to be between the unaltered conductive oxide and the unaltered reactive metal. If, however, only a small amount of reactive metal is deposited such that all of the reacted metal is oxidized, then the interfacial layer will be between the unaltered conductive oxide and an electrode on top of the interfacial layer.

However, it should be appreciated that using a reactive metal may not be the only way to create a memory effect with a conductive oxide. Insulating layers having the memory effect might be able to be created through doping, implantation or use of other techniques.

For example, strontium titanate (STO) or strontium zirconate (SZO) can be doped by adding an element that has a different preferred oxidation state (a different charge when ionized) when it replaces an element in the crystal matrix. Typically, the dopant would make up less than 10% molecular percentage of the total material. In SZO, chromium (Cr), with a +3 oxidation state, can replace zirconium (Zr) with a +4 oxidation state. Charge imbalance is compensated by either creation of appropriate vacancies (e.g., oxygen vacancies), by change of valence on a matrix element, or by introduction of free carriers (electrons or holes).

A dopant atom usually substitutes for a matrix element based, at least partly, on the similarity of ionic radii. Thus lanthanum (La) primarily substitutes for strontium (Sr) whereas Cr primarily substitutes for Zr in SZO. In SZO, cation vacancies are rare (i.e., there are few Sr and Zr vacancies), but anion vacancies (i.e., oxygen) are common. Therefore, adding Cr to SZO generates both oxygen vacancies and free holes. However, Cr addition is usually compensated by oxygen vacancies (one vacancy for every two Cr atoms) such that the material remains essentially insulating. In contrast, free electrons primarily compensate for La in SZO. Therefore adding La drastically lowers the resistance of SZO. Similarly tantalum (Ta) or niobium (Nb) can substitute for Zr to lower SZO resistivity.

Further, vacancies (either anion or cation) can also act to create charge traps. The charge imbalance caused by a vacancy can be compensated by the same mechanisms that compensate for the intentional additions of a dopant. Thus, an oxygen vacancy compensated by 2 Cr atoms provides no free carriers, but if there is insufficient Cr for full compensation, oxygen vacancies lead to free electrons.

Some dopants create centers at deep levels in the bandgap. Such dopants create centers where a charge would need a high level of energy to exit that level, effectively creating traps with the deep levels. For example, Cr, iron (Fe),or nickel (Ni) can create traps in STO and SZO. To the contrary, yttrium (Y), La, Nb and Ta would create centers at shallow levels, which would not be traps.

Treatment can additionally occur through, for example, ion implantation. In ion implantation accelerated ions penetrate a solid surface up to certain depth that is determined by the ion energy. Ion implantation can be used to introduce dopants, to form buried layers, and to modify solid surfaces.

Another treatment method is to expose a reactive metal or a conductive oxide to either an anneal or a gas at a given temperature within a given ambient. Some anneals can be easily integrated into fabrication. For example, if the array only has a single memory plug layer, then the bottom layers might be subjected to high temperatures in order to properly form the conductive oxide. However, the top layers can then be deposited at temperatures far below what is necessary for forming the conductive oxide. Similar results can be obtained by laser treating one of the surfaces, or exposing one of the surfaces to a plasma process (such as plasma etching).

Another treatment method might be to expose the entire structure and/or a particular surface layer to a physical re-sputtering, typically by using Ar and/or $O_2$ or other inert gas plasma. Re-sputtering is a technique commonly used to clean-up surfaces. Since a new film is not deposited when the plasma hits the surface in the sputtering chamber, it can be considered to be the opposite of sputtering. Similarly, the surface can be exposed to an inert ion from an ion gun, bombarding the surface with accelerated inert ions, such as ionized Ar.

Typically, the goal of such treatments is to create traps. Traps can also be introduced with high energy radiation or particle beam bombardment. For example, UV and X-ray radiation induces traps in $SiO_2$. Also, neutron transmutation doping can be used to create dopant atoms in silicon. Furthermore, traps can be created by an electrical initialization process during which oxygen vacancies drift through an oxide in the presence of an applied electric field. Of course, the dominant carrier mechanisms may change depending upon the treatment of the interface layer.

A memory plug using an interface layer, therefore, has many similarities with a traditional MIM structure. However, it should be noted that the interface layer exhibits memory characteristics regardless of whether it has been formed. The interfacial layer may be very rough, and therefore allows many current leakage paths, which eliminates the need for forming at low currents. It should be appreciated that the term "memory element" includes all the layers that contribute to the memory effect. Such layers, depending on the specific embodiment, can include the interface layer, the conductive oxide, reactive metal layer and/or electrodes.

***Multiple Interfaces***

Making sandwich-type structures can create additional interfaces. Depositing layers of reactive metal/conductive oxide/reactive metal will, for example, create two separate interfaces, as will depositing layers of conductive oxide/reactive metal/conductive oxide (assuming the entire middle layer does not reactive with the top and bottom layer, which would result in only a single interfacial layer). Although multiple interfaces can be created, it is sometimes useful to subject the interfaces to dissimilar treatments in order to bias the memory plug in a single direction, thereby encouraging the desired hysteresis effect.

Including dopants in only either the top or the bottom layer, or using different dopants allows the use of substantially similar materials, thus avoiding control issues while imparting enough differences between the substantially similar materials to constitute and create an active interface.

Thus, for example, a conductive metal oxide layer that includes a metal oxide strontium zirconate doped with chromium could be sandwiched between two substantially similar conductive metal oxide layers. The top conductive metal oxide layer can be strontium zirconate doped with iron, which results in a p-type metal oxide layer. The bottom conductive metal oxide layer is strontium zirconate doped with niobium, which results in an n-type metal oxide layer.

The thickness of such layers is not critical, typically 500 Å may be used, but any thickness from 100 to 1000 Å will usually be adequate. The only constraint is to ensure that the layer is thick enough that it is not completely depleted of charges when a voltage is applied across the memory element. The thickness of the middle layer is more critical, as tunneling conduction is preferred and will usually be achieved between 10 and 100 Å of thickness, depending on the voltage applied to the memory element. A typical thickness of 30 Å is adequate.

By causing the top metal oxide layer to have a surplus of either holes or electrons, and causing the bottom metal oxide layer to have a surplus of either electrons or holes (the opposite of the top metal oxide layer), it is possible to create an asymmetry in the electrical properties of the memory element. The asymmetry ensures that a program pulse of one polarity always changes the material to a higher resistance, and a program pulse of the other polarity changes the material to a lower resistance. If the top and bottom conductive metal oxide materials are the same, there is no asymmetry, and, at first, the memory material may switch either way. To avoid this lack of directionality, pre-conditioning techniques can be used, such as applying a high voltage pulse across the memory material. However, by using slightly different materials such an initialization step can be minimized or avoided.

Another way to create an asymmetry between the bottom and top metal oxide layers is to use the same type material, that is both layers being n-type (surplus of mobile electrons) or p-type (surplus of mobile holes), with a different concentration of mobile carriers.

Notably, the dopants included in the conductive metal oxide layers are typically used in low concentration. Generally, the amount of dopant included in the conductive metal oxide is less than 10% by weight and more particularly approximately 1% by weight.

The dopants used to create an n-type and a p-type region can be chosen with the following guidelines. An n-type dopant has a higher valence (more positive charge) than the lattice atom it replaces, therefore n-type dopants which substitute for Zr or Ti in strontium zirconate or strontium titanate include Nb and Ta. Similarly, n-type dopants which substitute for Sr include Y, La, and all of the lanthanide elements. A p-type dopant has a lower valence (less positive charge) than the lattice atom it replaces, therefore p-type dopants which substitute for Zr or Ti include Cr, Mn, Fe, Co, Ni, and Al. Another way to obtain hole conduction in strontium zirconate would be to dope with Nb on the Zr site and simultaneously with nitrogen on two adjacent oxygen sites to obtain p-type conductivity.

In still another embodiment of the present invention, the bottom conductive metal oxide material can be made out of praseodymium calcium manganese oxide ($Pr_xCa_{1-x}MnO_3$) with a selected ratio of $Mn_3$ or $Mn_4$ ions. The ratio of $Mn_3$ or $Mn_4$ can be adjusted by varying, during deposition, the ratio of Pr and Ca atoms. The top conductive metal oxide can be made out of $Pr_xCa_{1-x}MnO_3$ with another specific ratio of $Mn_4$ or $Mn_3$ ions so that the top metal oxide layer and the bottom metal oxide layer are dissimilar.

In similar fashion, one skilled in the art can appreciate that only two layers of conductive metal oxides may be utilized without departing from the scope of the present invention. In particular, either the bottom conductive metal oxide layer or the top conductive metal oxide layer can be excluded from the memory device because an active interface is still present between the remaining conductive metal oxide layers and the electron or hole imbalance is sufficient to provide asymmetry. As such, the use of three layers as described above is illustrative only and not indicative of any inherent limitation of the scope of the disclosure as any of a number of conductive metal oxide layers are contemplated by the present invention.

As another example of the present invention, it is also possible to use different materials to form the conductive metal oxide layers, as long as these materials are compatible. Example compatible materials would have a similar crystal structure and similar lattice parameters. Strontium ruthenate (SRO) and strontium titanate STO constitute an example of such a material, where the distance between Sr-Ru atoms in a SRO crystal and Sr-Ti atoms in a STO crystal are within a few percentage points of each other.

The criteria for other compatible materials would be the same as the criteria used for a good epitaxy. For example, Si is compatible with $Al_2O_3$ (Sapphire) since one plane of $Al_2O_3$ crystal closely matches an integral multiple of Si crystal plane.

### *Modifying the Electrical Properties of Various Layers*

The electrical properties of layers within the memory plug can be modified with several techniques. These electrical properties include, but are not limited to, the resistivity of the material as well as the temperature sensitivity of such resistance; the amount or magnitude of charge traps; and magnetic field dependence.

It is known that the resistivity of certain metal oxides depends upon various factors, often including some of the following: film thickness, oxygen content of the film, stoichiometry, elemental composition, deposition method and conditions, degree of crystallinity, crystallite size, crystalline orientation, and doping level and choice of dopant. Current research indicates that suitably low resistivity (less than or equal to 1 ohm-cm) materials can be achieved by judicious choice of these parameters.

One example of a suitable film thickness for the memory applications of this invention is approximately 100Å to 3000Å. Thinner films sometimes have higher strains, usually resulting from a slight misalignment with the seed layer, which can result in higher resistivity. Film thickness has been discussed by S.I. Khartsev, et al. in "Colossal magnetoresistance in ultrathin epitaxial La0.75Sr0.25MnO3 films," Journal of Applied Physics, Vol. 87, No. 5, 1 March 2000.

Another factor that affects resistivity is the oxygen content of the film. By properly controlling the exposure to oxygen during deposition and annealing (if any) the resistivity can be controlled. It has been observed that 1500Å lanthanum manganese oxide (LMO) films deposited by pulsed laser deposition in oxygen environments have a lower resistivity than films deposited in vacuum (but otherwise identical conditions). *See* Y. G. Zhao, et al., "Effect of oxygen content on the structural, transport, and magnetic properties of La1-δMn1-δO3 thin films," Journal of Applied Physics, Vol. 86, No. 11,1 December 1999. Cooling down the freshly deposited film in an oxygen-containing atmosphere further decreases film resistivity.

It has been further observed that adjusting the relative amounts of the rare earths and the alkaline earth metals can modify resistivity. Higher ratios of alkaline earth to rare earth metals can, to a degree (e.g., up to about 50:50 in lanthanum calcium manganese oxides), lower resistivity. See Guo-Qiang Gong, et al., "Colossal magnetoresistance of 1000000-fold magnitude achieved in the antiferromagnetic phase of La1-xCaxMnO3," Applied Physics Letters, Vol. 67, No. 12, 18 September 1995.

Further, it has been found that some polycrystalline materials may have lower resistivities than their amorphous and single crystal counterparts. Large changes (i.e., greater than about 10x), are, however, not typically necessary for making a practical memory chip with only two resistive states (although they may be necessary for memory cells that hold multiple bits of information).

In addition to the above properties, certain process and design features are important. First, the seed layer or other "substrate" on which the oxide deposits impacts the resistivity of the oxide and other properties. Often the underlying crystrallographic orientation of the substrate will epitaxially propagate to the upper levels the oxide element. So, for example, if the underlying substrate has a 100 orientation, then the oxide may preferentially deposit in a 100 orientation. Preferably, the underlying substrate is a conductive electrode such a noble metal (e.g., platinum) or relatively conductive oxide such as $LaNiO_3$. In polycrystalline structures, suitable crystallite sizes may range from about 100Å to about 500Å.

If more than one dopant is used, the dopants may serve to modify the same or different properties of the various layers. Doping the oxide, the reactive metal layer and/or the interface can cause electrical properties to be more uniform, whereby the electrical properties have a greater predictability.

In a particular aspect, doping alters resistivity. For example, application of an electrical pulse reversibly changes the resistivity from either a high value to a low value or from a low value to a high value; and doping the materials can modify the magnitude of the difference from the high value to the low value.

In another aspect, doping alters the amount or magnitude of charge traps or otherwise modifies the ability of the charge traps to capture electrons and thus, improve the data retention capability of the memory plug. In other words, the doping should facilitate electrons tunneling through the memory plug and leaving charge traps during the operation of the memory.

In yet another aspect, doping additionally reduces the temperature sensitivity of its resistance. In a further aspect, doping reduces magnetic field dependence.

### *Electrical Properties of the Cross Point Array*

FIG. 46 depicts a simplified representation of a cross point memory array. The selected X line 4605 and the selected Y line 4610 intersect at the selected cell 4615. The remaining unselected X lines 4620 and the remaining unselected Y lines 4625 are each represented as a single group for simplicity. Similarly, the unselected memory cells 4630 on the selected X line 4605, the unselected memory cells 4635 connected to the selected Y line 4610, and the unselected cells 4640 connected to neither the selected X line 4605 nor the selected Y line 4610 are also represented as groups for simplicity.

The combination of unselected memory cells 4630, 4635, and 4640 is set in parallel with the selected memory cell 4615, and therefore, the current that is read when applying some $V_x$ on line 4605 and some $V_y$ on line 4610 will be: $(V_x-V_y) \times (R_{4615}+R_{4630}+R_{4635}+R_{4640})/(R_{4615} \times (R_{4630}+R_{4635}+R_{4640}))$, where $R_{4630}$, $R_{4635}$, and $R_{4640}$ are the resistances of the unselected memory cells 4630,4635, and 4640 and $R_{4615}$ is the resistance of the selected memory cells 4615. In large arrays, the combined resistance of the selected cell 4615 in parallel with the unselected cells 4630, 4635, and 4640 will be significantly less than the resistance of the selected cell 4615 alone. As such, it is not practical to read the resistance of the selected cell 4615 with floating lines and unselected cells 4630, 4635, and 4640 that allow current to flow.

Although clamping the unselected lines 4620 and 4625 at specific voltages reduce the effect of the unselected memory cells 4630, 4635, and 4640, such techniques result in current consumption through unselected cells. For example, if $V_y = -V_x$ and the unselected lines 4620 and 4625 are held at 0V, the unselected memory cells 4635 on the selected Y line 4610 will pass a current equal to $V_x/R_{4635}$, which can be high if there are a high number of unselected array lines.

As previously discussed, a higher voltage is typically applied on both selected X line 4605 and Y line 4610 during a write operation. Although the current leakage in other elements is not critical to the selected element, in a large array, the current leakage amplitude could be such that it would require impractically large currents from the line drivers. Further, unselected memory cells 4630, 4635 and 4640 carrying unselected current could have their memory state affected by the unselected current.

FIG. 47 depicts an exemplary cross point array 4700 where each memory cell includes a diode. As the voltage $V_x$ is applied on selected X line 4705 and $V_y$ is applied to the selected Y line 4710, the diodes block the current flow through the unselected memory cells 4730, 4735 and 4740 in series. With unselected lines 4720 and 4725 left floating the current going from selected X line 4705 to selected Y line 4710 will pass exclusively through the selected memory cell 4715, therefore giving an accurate evaluation of the value of the resistance of the memory cell 4715.

During a write operation, the diodes will also block the parasitic current path through unselected memory cells 4730, 4735 and 4740. However, if the unselected lines 4720 and 4725 are floating then they will be charged by current going through the unselected memory cells 4730, 4735 and 4740. For example, one of the unselected lines that crosses the selected X line 4705 will reach $V_x - V_{fwd}$, where $V_{fwd}$ is the forward bias voltage drop across a diode, since line 4705 is at $V_x$ (which, during a write operation, might be $1/2\ V_W$) and current can flow through the unselected memory cell. If $V_x$ is high enough, the current flowing temporarily through the unselected memory cell can be high enough to disturb its resistive state. If unselected lines 4720 and 4725 are clamped to a fixed voltage, as long as $V_x$ is above a diode voltage drop, some cells will see a constant current flow, which is undesirable because it could slowly affect the state of those cells.

FIG. 48 depicts an exemplary cross point memory array 4800 where each memory cell includes a back to back diode. FIG. 49 depicts the current-voltage, or "N" characteristic of a back to back diode device. At low voltages, between $-V_{NO}$ and $+V_{NO}$, the device does not conduct or conducts only slightly. The $V_{NO}$ voltage can be referred to as the non-ohmic voltage, where conduction becomes significant. Below $-V_{NO}$ and above $+V_{NO}$, the device is conductive.

FIG. 50 shows the IV characteristic of one type of linear memory element. As a positive voltage is applied across its terminals, the memory element has a substantially linear resistance value, as a write threshold voltage $V_W$ is reached, the resistance of the memory element rises. As the voltage across the terminals is decreased and becomes negative, the memory element characteristic exhibits a higher resistance value. When the voltage across the terminals reaches a negative write threshold, the resistance state goes back to a lower value. FIG. 51 depicts the IV characteristics of both a linear memory element and a back to back diode in series. A further embodiment would use two tunnel or backward diodes mounted back to back. The principal of backward diode is explained in Sze S.M., Physics of Semiconductor Devices, pp. 537-539, 1981, and can be realized with a N+, a P+ and another N+ layer of about 500 Å each.

Referring back to FIG. 48, one method of writing to the cross point memory array 4800 is to apply $V_x = (V_{NO} + V_W)/2$, and $V_y = -(V_{NO}+V_W)/2$ on the respective selected lines 4805 and 4810, and to ground the unselected lines 4820 and 4825. This will result in the voltage across the memory element of the selected memory cell 4815 to be $V_x - V_y - V_{NO}$, or $V_W$, and across the memory elements of the unselected cells 4830 and 4835 on a select line to be $(V_{NO} + V_W)/2 - V_{NO}$, or $V_W/2 - V_{NO}/2$, and across the memory elements of the unselected memory cells 4840 to be 0V, since in this case the unselected lines 4820 and 4825 are grounded. Applying the reverse polarity voltage on the selected X and Y lines 4805 and 4810 will program the opposite data in the selected cell. Therefore, if $V_W$ is set to be higher than the threshold write voltage and lower than twice the threshold write voltage, the unselected cells that see $V_W/2$ across their terminals are not affected and written during the write operation.

A read operation will process similarly, replacing $V_W$ by $V_R$, a lower voltage so that $V_R$ is below the threshold write voltage. In the read case, the selected memory element will see a $V_R$ voltage across its terminal and unselected memory elements will see $V_R/2 - V_{NO}/2$, or zero if this $V_R$ is less than $V_{NO}$.

During read another point of concern are leakage currents, since the read operation tries to ascertain the value of the selected cell's resistance by applying a voltage and reading a current. Any change in the read current may affect the read value. For example, if each unselected cell 4835 on line 4810 leaks 1 nA, and the array has 1024 cells per line, the leakage on the line would be 1023 x 1nA, or 1.023 µA. Although 1.023 µA can be tolerated in many systems, a leakage of 100 nA per cell would create more than 100 µA of leakage, which could affect the proper read of the selected cell. In such a case, a smaller array, possibly 100 cells per line, would only have a 100 x 100nA or 10 µA of leakage, and would still be workable.

An alternate embodiment to the memory element and the back to back diode in series is to embed the back to back diode into the memory element, and take advantage of the non-ohmic nature of some metal / semiconductor interfaces. FIG. 52 depicts an representative IV curve of a stack consisting of a Pt electrode, crystalline PCMO, a thin layer of Al, and another Pt electrode that exhibits a non-ohmic behavior. Although such material shows some leakage below $V_{NO}$, it is still applicable to smaller arrays, and may be improved to be of use in larger arrays.

To use this embodiment, the threshold write voltage of the memory element has to be adjusted. Typical non-ohmic behavior, such as Schottky effect, will result in a $V_{NO}$ below 1V. If $V_W$ is above $V_{NO}$, the unselected cells will see $(V_W - V_{NO})/2$ across the memory element, which will create an un-desirable current in the unselected memory cell. To avoid or reduce this current, it is preferable to keep $V_W$ close to or below $V_{NO}$. Therefore, the write threshold voltage will have to be adjusted, by varying the properties of the conductive metal oxide such as thickness, oxygen content, crystalline structure, stoichiometry to achieve a write threshold below VNO.

### Methods of Manufacture

FIG. 53 depicts a cross sectional view of a partially processed integrated circuit up to the completion of a bottom front end of line (FEOL) processed section 5300. A p-type substrate 5310 lies beneath an n-well 5315 that in turn lies underneath a p-well 5320. Two N+ islands 5325 and 5330 are created within the p-well 5320 to form reverse-biased p-n junctions. A first inter-layer dielectric (ILD) 5305 is formed atop the p-well 5320. A select line 5335 can be formed, within the first ILD 5305, with a standard polysilicon gate controllably turning on a field effect transistor (FET) type of conduction between the two N+ islands 5325 and 5330. For simplicity and low cost fabrication, the selected FEOL process can be any of the many standard IC processes such as Silicon, Germanium, Gallium Arsenide, Silicon-Germanium and Silicon on Insulator. FEOL processes in this embodiment can be defined as operations performed on a semiconductor wafer in the course of device manufacturing up to but just before first metallization, and might end with chemical-mechanical polishing (CMP) of the first ILD 5305. To simplify the description of the present invention, the following embodiments are generally described using a Silicon process with the understanding that the scope of our present invention is not so limited.

FIG. 54 depicts a cross sectional view of a further processed integrated circuit 5400 after conductive plugs are formed in the FEOL section 5300 of FIG. 53. In the process that is shown, a number of contact holes, each corresponding to the location of a desired conductive plug, are first formed through the first ILD 5305. Barrier/adhesion layers 5405 and 5410 can then sputtered inside the contact holes. Notice that sputtering is a form of physical vapor deposition technique. The specific sputtering composition will depend on the conductive plug material being used, and can be 100Å Ti followed by 200Å of TiN. Next, a conductive plug material can be deposited within the contact holes atop the barrier/adhesion layers 5405 and 5410. As illustrated, the conductive plug can be Tungsten (W)-plug 5415 and Tungsten (W)-plug 5420 deposited with 5000Å of W using chemical vapor deposition (CVD) followed by an etchback process or chemical-mechanical polishing (CMP) to remove excess conductive plug material atop the first ILD 5305 surface.

FIG. 55 depicts a cross sectional view of a further processed integrated circuit 5500 after the partial formation of a middle memory plug section atop the partially processed integrated circuit 5400 from FIG. 54. First, a bottom electrode 5505 is deposited. The bottom electrode 5505 can in turn be made of multiple layers, such as a 500Å thick barrier layer of TiAIN to prevent metal inter-diffusion followed by a 500Å $LaNiO_3$ or 1000Å Pt. These layers can be deposited by sputtering. Next, a conductive oxide 5510 is deposited on top of the bottom electrode 5505. The conductive oxide and can be 500Å of a material having a stoichiometry of $Pr_{0.7}Ca_{0.3}MnO_3$ (PCMO) and is preferably deposited at less than or equal to about 600°C by a physical vapor deposition technique such as sputtering, followed by annealing. The annealing step helps to recover the intended crystalline structure and material composition of the conductive oxide 5510. Next, a top electrode 5515 can be deposited using sputtering. The top electrode can have a composition similar to the bottom electrode 5505, except that a small layer of a reactive metal (e.g., 10Å of Al) is first deposited on the conductive oxide 5510. Standard photolithography and appropriate multi-step etch processes can then be used to pattern the bottom electrode/conductive oxide/top electrode layers into a memory plug. As an optional improvement, one or both of the bottom electrode 5505 and the top electrode 5515 can be made of a conductive layer and a barrier layer to prevent metal inter-diffusion.

Numerous sputtering techniques can be employed to further improve the formation of the middle memory plug section. In an off-axis sputtering process, the target surface, the supplier of the material to be sputtered, and the substrate surface, the receiver of the material to be sputtered, are oriented approximately orthogonal to each other, about 70 to 90 degrees. The advantage of the off-axis sputtering includes minimizing material damage from ion impingement during an on-axis reactive ion sputtering process. Another implementation can include two oppositely faced targets as in facing target sputtering (FTS). In a co-sputtering process, the deposited materials are sputtered from more than one target concurrently so as to create a plasma of more than one material, hence the deposition of more than one material on the substrate surface at the same time. Thus, the advantage of co-sputtering includes flexibility of material composition. In a continuous deposition process, in-situ multilayer film deposition takes place inside the same deposition chamber without breaking the vacuum. This deposition technique is most easily accomplished, for example, in a sputtering machine by keeping the substrate at one location while switching targets or by switching deposition chambers within one system. By not breaking the vacuum, numerous contamination and oxidation problems from exposure to air are avoided.

Given the above discussion, the deposition of the conductive oxide 5510 can advantageously employ the co-sputtering technique. At least one of the three sputtering processes for the bottom electrode 5505, the conductive oxide 5510 and the top electrode 5515 can employ the off-axis sputtering technique. Furthermore, out of these three sputtering processes, at least two consecutive sputtering processes can advantageously use the continuous deposition technique. These layers are then patterned (photodefined) to create the stacks 5505, 5510 and 5515 on top of the contact 5420. As another option, an etch stop/diffusion barrier 5520 might then be deposited to protect the PCMO from inter-diffusion. The etch stop/diffusion barrier 5520 would surround the exposed surfaces of the bottom electrode 5505, top electrode 5515 and conductive oxide 5510 as shown. Notice that the etch stop/diffusion barrier 5520 is a dual-function layer also acting as an etch stop in the fabrication process. Notice also that the etch stop/diffusion barrier 5520 forms a sidewall layer that surrounds the side surfaces of the bottom electrode 5505, the conductive oxide 5510 and the top electrode 5515. The etch stop/diffusion barrier 5520 can be made of 250Å of $Si_3N_4$, $TiO_2$ or $Al_2O_3$. As a material improvement, the deposition of the conductive oxide 5510 can be followed by modification of the interface property between the conductive oxide 5510 and the later deposited top electrode 5515. More specifically, the modification of the interface property can be done by ion implantation, in situ plasma treatment in various gasses, or in situ annealing in various gasses. Possible gasses might include argon, oxygen or hydrogen.

FIG. 56 depicts a cross sectional view of a further processed integrated circuit 5600 after the complete formation of a middle memory plug section atop the partially processed integrated circuit 5500 of FIG. 55. As a clarification while counting IC components upwards from the bottom, the middle memory plug section includes all IC components above the top surface of the first ILD 5305, as shown in FIG. 54, up to the top surface of a second ILD 5605.

The second ILD 5605 is deposited on top of the etch stop/diffusion barrier 5520. The second ILD 5605 can be made of a thick $SiO_2$ layer and then planarized by chemical-mechanical polishing (CMP). A plurality of via holes, locationally and geometrically corresponding to the top electrode 5515, can then be formed with standard photolithography and via etch. Barrier/adhesion layers 5610 and S61S are then sputtered inside the via holes. The specific sputtering composition can be 100Å Ti followed by 200Å of TiN. Next, a conductive plug material is deposited within the contact holes atop the barrier/adhesion layers 5610 and 5615. The conductive plug can be W-plug 5620 and W-plug 5625 deposited with 5000Å of W using chemical vapor deposition (CVD) followed by an etchback process or CMP to remove excess conductive plug material atop the second ILD 5605 surface. As a process improvement, an annealing step can take place at this point to help in recovering the original crystalline structure and material composition of the middle memory plug section.

FIG. 57 depicts a cross sectional view of a completely processed integrated circuit 5700 after the complete formation of a top metallization section atop the middle memory plug section. As a clarification while counting IC components upwards from the bottom, the top metallization section includes all IC components above the middle memory plug section. Using standard processes, one or more metallization layers can be formed above the partially processed integrated circuit 5600 of FIG. 56. Two metallization layers are illustrated in this embodiment. The first metallization layer can be used to form both a reference line 5705 and a metal plug 5710 that eventually connects two W-plugs 5620 and 5715. The W-plug 5715 is used to connect a data line 5720, formed during the second metallization layer, to the metal plug 5710 through a third ILD 5725 used to support the data line 5720. The W-plug 5715 and the third ILD 5725 are respectively formed with processes similar to those described before. As a process improvement, an annealing step can take place at this point to help recovering the original crystalline structure and material composition of the completed IC. By now it should become clear to those skilled in the art, while the bottom front end of line section 5300 is shown with the addition of a FET with a terminal ofN+ island 5325 connected to the bottom electrode 5505 of the memory device via the W-plug 5420, in general any other IC components can be implemented instead to connect the bottom electrode 5505 to suit a corresponding application. Some examples are a resistor, a capacitor or a non-ohmic device like a diode. To further clarify the spatial orientation and alignment of the memory device an X-Y-Z Cartesian coordinate system can be set in reference to FIG. 55: the interfaces between the electrodes 5505 and 5515 and the conductive oxide 5510 generally define the X-Y plane while the direction of current through the memory device is essentially parallel to the Z-axis.

FIG. 58 depicts a cross sectional view of another completely processed integrated circuit 5800 wherein the memory devices of the middle memory plug section further include features of a hard mask 5530 layer and a spacer 5525. Except for these features, whose fabrication process is to be presently described, the completely processed integrated circuit 5800 is otherwise the same as the completely processed integrated circuit 5700 depicted in FIG. 57. The spacer 5525 can be made of a dielectric material surrounding the top electrode 5515. Some examples of the dielectric material are $Si_3N_4$, $SiO_2$, $TiO_2$, SiON or $Al_2O_3$. The hard mask 5530 is typically made of an electrically conductive material having a similar X-Y cross section as the top electrode 5515. The hard mask 5530 is a masking material that is used as etching mask to protect the film or films underneath from etching in a plasma etch chamber. The hard mask materials can be divided into two categories, insulator or conductor. The popular insulating hard mask materials are oxide and nitride. The popular conductive hard mask materials are binary nitrided metals including TiN, TaN, WN, etc. and ternary nitrided metals including TiSiN, TiAlN, TaSiN, etc. One advantage of the hard mask over a standard photo-resist is that the hard mask can resist a dry etching process requiring elevated temperature. Usually reactive ion etching (RIE) at an elevated temperature is required to etch precious metals or complex metal oxides because of the difficulties associated with their etching, especially the etch byproduct volatility. Due to the impact of previous etch steps defining the profile of bottom electrode 5505, conductive oxide 5510 and top electrode 5515, the outer periphery of the conductive oxide 5510 is often damaged by plasma ions, causing a corresponding leakage current conduction in the Z-direction. This leakage current can short out the current conduction through the bulk of the conductive oxide 5510, and is therefore undesirable and detrimental to the operation of the memory device. The introduction of the spacer 5525 makes the cross sectional area, along the X-Y plane, of the top electrode 5515 smaller than that of the conductive oxide 5510. The spacer 5525 creates a resistance between the sides of the electrode 5515 and the edge of the conductive oxide 5510. Hence, the X-Y footprint of the spacer 5525 can be made large enough to make the resistance between the sides of the top electrode 5515 and the edge of the conductive oxide 5510 high enough to render the effect of the leakage current conduction negligible.

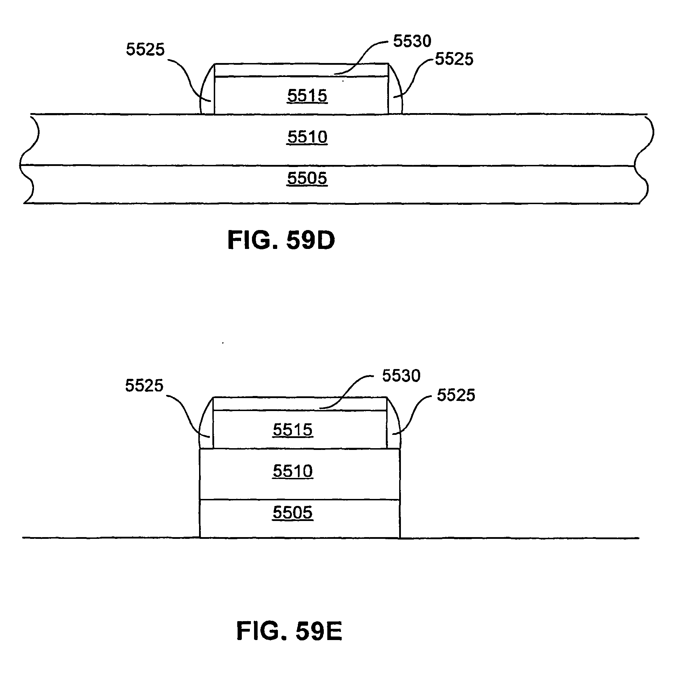

FIG. 59A through FIG. 59E detail an exemplary sequence of various processing steps that could be used for the creation of the hard mask 5530 and spacer 5525 features of the memory device 5800 of FIG. 58. FIG. 59A illustrates only a memory device following the steps of sputtering a bottom electrode layer 5505, sputtering a conductive oxide 5510, sputtering a top electrode layer 5515 and depositing a hard mask layer 5530. The hard mask layer can be deposited by various means such as Chemical Vapor Deposition, spin coat or sputtering. Like before, the deposition of the conductive oxide 5510 can be followed by modification of the interface property between the conductive oxide 5510 and the later deposited top electrode 5515. More specifically, the modification of the interface property can be done by ion implantation, in situ argon plasma treatment, in situ oxygen plasma treatment, in situ annealing in argon or in situ annealing in oxygen. FIG. 59B and FIG. 59C illustrate the steps of photo lithographically etching, with a photo resist 5535, the hard mask layer 5530 and the top electrode layer 5515 both having cross sections smaller than that of a later-patterned conductive oxide 5510. A dielectric material is then deposited on top to form the spacer 5525. FIG. 59D illustrates the memory device following an anisotropic dry etching, with a much higher etch rate in the Z-direction than the X- and Y-directions, of the dielectric material to create a sidewall spacer 5525 surrounding the side surfaces of the top electrode 5515 and the hard mask 5530. Finally, FIG. 59E illustrates the memory device following an etching of the conductive oxide layer 5510 and the bottom electrode layer 5505. As an optional measure to further remove the damaged outer periphery of the conductive oxide 5510, an additional clean-up step of wet etching can be applied to selectively remove 50 - 150 Å material of the conductive oxide sides, thus forming an undercut.

FIG. 60 depicts a cross sectional view of yet another completely processed integrated circuit 6000 wherein the memory devices of the middle memory plug section include an undercut 5540. Geometrically, the X-Y cross section of the bottom electrode 5505 is larger than that of the conductive oxide 5510. Similarly, the X-Y cross section of the top electrode 5515 is also larger than that of the conductive oxide 5510. Except for the undercut 5540 the completely processed integrated circuit 6000 is otherwise the same as the completely processed integrated circuit 5700 depicted in FIG. 57. Referring back to FIG. 55 and its accompanying description, after patterning the bottom electrode/conductive oxide/top electrode layers into a memory plug, an optional clean-up step of wet etching can be applied to selectively remove 50 - 150 Å of the sides of the conductive oxide 5510, thus forming an undercut 5540 as shown in FIG. 60. The purpose of the undercut 5540 is to directly remove the damaged outer periphery of the multi-resistive state element 5510 that would otherwise cause an undesirable leakage current conduction in the Z-direction, as explained before.

### Hugh Temperature Fabrication

As previously described, the fabrication techniques used for the memory plug will typically dictate the requirements of the layers beneath the memory plug (e.g., the select line in a transistor memory array; and the driver circuitry and the bottom conductive lines in a cross point array). Since certain fabrication processes (e.g., solution based spin on followed by high temperature anneal, pulsed laser deposition, sputtering, and metal-organic chemical vapor deposition) might require high temperatures, refractory metals can be used for these layers so that they may withstand the temperatures.

Typical metal lines in integrated circuits are made out of aluminum or copper. However, these metals have a rather low melting point, and the structural integrity of the formed metal lines is damaged if they are allowed to melt. Furthermore, these materials cannot even withstand exposure to temperatures below their melting point. For example, although aluminum's melting point is 660C, it generally should not be exposed to temperatures above 400C. At such temperatures the aluminum atoms start to diffuse to other areas, possibly reacting with other semiconductor elements on the substrate, disturbing the characteristics of those elements. The diffusion increases with increasing temperatures, becoming largely unworkable at 450C.

Therefore, if typical low temperature conductive lines were used (i.e., aluminum or copper), any material above the first metal line would be limited to temperatures where they were considered to be "stable" metals. However, most manufacture processes require high temperatures to grow the crystalline or poly-crystalline structure of the multi-resistive state element. In such processes, high temperature is typically between 600C and 800C.

Therefore, using conductive lines that can withstand high temperatures is sometimes required. High melting point metals are usually referred to as refractory metals, and include tungsten, molybdenum, tantalum, niobium, chromium, vanadium and rhenium, as well as the less common zirconium, technetium, ruthenium, rhodium, hafnium, osmium and iridium. Some of the latter metals may, however, not be practical for use in an integrated circuit process. Refractory metals also include any compounds and alloys that have high melting points. Additionally, in many applications it is preferable to use a material with a low resistivity in order to both improve the memory access time and allow for longer array lines.

Additionally, any conductive material with a melting point of at least 100C above the desired process temperature can typically be used. For example, in the case of aluminum, a desired process temperature 200C below the melting point of aluminum is generally preferred. Therefore, an optimum conductive array line would be a refractory metal with a low resistivity that has a melting point at least 100C above the high temperature processing that is used.

Conductive lines are not the only elements that may need to withstand high temperature processing. Typically, only the layers that are deposited after the high temperature processing of the memory plug are free from those high temperatures. Since no high temperature steps are required after the memory plug's formation, the top layers of the memory do not need to have high melting points. Therefore, such layers can be made with standard metallization materials such as aluminum, copper or aluminum alloys such as aluminum-silicon, aluminum-silicon-copper or aluminum-copper.

The elements that may need to withstand high temperature processing can include the multi-resistive state material, a possible non-ohmic device, appropriate electrodes, bottom layers of conductive array lines, and contact plugs to connect the electrodes of the memory cells to the conductive array lines. Electrodes made out of noble metals, binary or ternary oxides and nitrides, and conductive metal oxides are temperature resistant. Examples of high temperature resistant materials that can act as sacrificial layers include ternary oxides such as ruthenium tantalum oxide, ruthenium titanium oxide, iridium tantalum oxide or iridium titanium oxide and ternary nitrides such as ruthenium tantalum nitride, ruthenium titanium nitride, iridium tantalum nitride or iridium titanium nitride.

### Mechanisms for Storing Resistive States

The use of stored or trapped charges is the dominant mechanism for storing data in a non-volatile memory cell. During device operation, these trapped charges function to modify, for example, the silicon surface conductivity of a FET. A corresponding general device configuration is illustrated in FIG. 61. A FET 6100 includes a source 6130 and a drain 6120 separated by a control gate 6110. This FET 6100 can be ofn-type or p-type. For simplicity an n-type FET will be described. Thus, the drain 6120 and the source 6130 are both made of an n-doped semiconductor material while the substrate 6140 is made of a p-doped semiconductor material. When a positive voltage is applied to the control gate 6110, electrons within the substrate 6140 are attracted toward the control gate 6110 and form an inversion layer 6150 in an area called the 'channel' that is within the substrate 6140 and under the control gate 6110. The channel then allows current conduction between the drain 6120 and the source 6130.

Notwithstanding the foregoing description, the presence of any trapped charges 6160 within the oxide 6170 and between the control gate 6110 and the substrate 6140 will modify the required value of the voltage applied to the control gate 6110 to create the inversion layer 6150. For a case of negative trapped charges 6160, the higher the magnitude of trapped charge the higher the required voltage would have to be. The reason is that the negative charges trapped in the oxide will repel the electrons away from the channel, necessitating the application of a higher positive voltage on the control gate 6110 to counteract this effect.

For each of the above devices, the magnitude of trapped charges can be altered through various mechanisms. Retrieving data can then be accomplished by sensing the voltage that is required to create the inversion layer. Similarly, the memory material in the present invention also has a resistive state that is modified with trapped charges. As previously described, the memory material can be any of a variety of materials, and will most commonly be an insulator or semiconductor that is treated to become conductive.

A current carrier can be either a negatively charged electron or a positively charged hole. The current carrier trap locations, or simply traps, are regions within the memory material causing the presence of localized energy levels within the bandgap of the memory material. These traps are thus capable of trapping, or immobilizing, current carriers within the memory material and affecting its resistance.

Furthermore, the degree of charging or discharging the traps are dependent upon localized energy levels within the bandgap. Also, the carrier occupancy can be affected by an electric field applied across the memory material and accompanied by a corresponding current flow. Typically, the electric field will need to be beyond a certain threshold value before it affects carrier occupancy. Consequently, the resistance of a properly designed memory plug can be switched through multiple values following a corresponding number of applied voltage thresholds. The means of creating and configuring these traps will be presently described.

For a crystalline memory material, the traps may be located within the crystal lattice. However, for a poly-crystalline memory material, the traps may be located within the grain boundaries or within a molecular structure.

To foster the creation of traps, extrinsic materials, called dopants, can be introduced into the memory material in minute quantities. Typically, the dopant would make up less than 10% molecular percentage of the total material. As a result, some dopants create trapping centers at deep energy levels within the bandgap. That is, once captured at these trapping centers, a current carrier would need to acquire a sufficient amount of energy to regain its mobility. For example, the elements Cr, Fe or Ni can create traps at deep energy levels in STO and in SZO. On the other hand, the elements Y, La, Nb and Ta primarily create centers at shallow energy levels which typically do not act as traps. See the technical papers "Photochromism in Ni-doped SrTiO3," P. Koidl et al, Physical review B, Vol. 14, No. 7, Oct. 7, 1976 PP. 2703 - 2708, and "Photoinduced Phenomina in Sr1-xCaxTi02, 0 <= x <= 0,12," S. A. Basun et al, Ferroelectrics, 1996, Vol.

183, PP. 255 - 264.

Traps can also be introduced in memory material with high energy radiation or particle beam bombardment. For example, UV and X-ray radiation induces traps in $SiO_2$. Also, neutron transmutation doping has been used to create dopant atoms in silicon.

Traps can also be created intrinsically within the memory material during its fabrication. Examples of such mechanisms have been previously described. Furthermore, traps can be created by an electrical initialization process during which oxygen vacancies drift through a complex metal oxide in the presence of an applied electric field. See references "DC Electrical Degradation of Perovskite-Type Titanates (Ceramics, Single Crystal, A Model of the Mechanism): I, II & III," Rainer Waser et al, J. Am. Ceram. Soc., 73 [6] 1990 PP. 1645-1663 and "New conduction and reversible memory phenomena in thin insulating films" J.G. Simmons and R. R. Verderber, Proc. Roy. Soc. A. 301, 1967 PP. 77-102.

The presence of the trapped charge modifies or otherwise alters the conductivity of the bulk memory material. An example is illustrated in FIG. 62A, which depicts a section of a memory material 6200 with charge traps 6210. Each charge trap 6210 is shown carrying an amount of negative charge. Here, the charge traps 6210 act to reduce the flow of electrons by repelling those electrons traveling nearby. On the other hand, the same charge traps 6210 can enhance the flow of holes by attracting those holes traveling nearby. Thus, depending upon its polarity, a trapped charge could either enhance or deplete the concentration of free current carriers in its vicinity. The corresponding energy band diagram is illustrated in FIG. 62B showing a localized elevation 6220 of both conduction band EC and valence band EV.

The presence of the trapped charge raises or lowers, depending upon the charge type, the height of the Schottky barrier at the top electrode to memory material contact or at the bottom electrode to memory material contact. The trapped charge would raise the Schottky barrier for free carriers of like charge polarity by introducing an opposition electric field at the contact. On the other hand, the trapped charge would lower the Schottky barrier for free carriers of the opposite polarity by introducing an enhancement electric field at the contact. Consequently, a higher Schottky barrier acts to increase the resistance of the trapped charge memory device and vice versa. The corresponding energy band diagrams of the Schottky barrier are shown in FIG. 63 wherein the left side has no charged trap but the right side has a charged trap 6300 and the free carriers are electrons.

The interface between a metal electrode and a CMO film can have a depletion region, like in a Schottky barrier, and traps at the interface can affect conduction. Trap to trap hopping, while allowing bipolar conduction, is affected by the presence of trapped charge and are illustrated in the energy band diagrams without (left hand) and with trapped charge (right hand) of FIG. 64.

Frenkel-Poole conduction is an electric field assisted thermionic emission from moderately deep traps. Here, charges trapped in other energy levels, while not participating in the emission of current carriers, could affect the resistance as well. Under this mechanism there are two types of traps, the traps that participate in the Frenkel-Poole conduction and the charged traps responsible for the resistance memory effect. The associated trapped charges will affect the resistance by modifying the barrier height in a way similar to the mechanism above. The corresponding energy band diagrams of Frenkel-Poole Conduction without (top) and with charged trap (bottom) are illustrated in FIG. 65.

Tunneling conduction can happen in which current carriers tunnel from the electrode directly to the conduction band (for electrons) or valence band (for holes) in a Schottky-like structure. Here, the trapped charge in the depletion region can affect the resistance in a way similar to the Schottky barrier mechanism described above. The corresponding energy band diagrams of tunneling conduction through a Schottky junction without (left hand) and with a charged trap (right hand) are illustrated in FIG. 66.

Orbital ordering is a mechanism in which the electron orbitals in a crystal lattice have a preferred direction, typically in an ordered pattern, such that the resistivity of the crystal lattice will be higher than the case wherein the ordered pattern is disrupted by the addition of charged traps.

Direct tunneling is a mechanism during which electrons from the conduction band in semiconductor are transferred across an insulator directly (i.e. without changing energy) into the conduction band of a conductor. The probability of direct tunneling is a very strong function of the width of the barrier electron tunnels through (i.e., the oxide thickness or the interfacial layer or other insulating structure).

In order for trapped-charge conductive metal oxide memories to be non-volatile, trapped charges must remain trapped until intentionally depopulated. In the case where traps are populated and depopulated by means of electric field induced tunneling processes, traps having a fixed energy level will not result in non-volatility because charges will be able to discharge (or charge) with no externally applied voltage bias. However, a non-volatile trapped-charge conductive metal oxide memory can be produced by introducing "level shifting" traps into the oxide. A level-shifting trap is one in which the energy required to depopulate the trap is larger than that required to populate it because of a relaxation process that takes place immediately after the trap becomes populated (or depopulated). For non-volatility, an electron level-shifting trap must have an energy level above the Fermi levels of the adjacent metal electrodes when unpopulated, and below the Fermi levels when populated.

There are several possible relaxation mechanisms that can lead to such level-shifting. One such mechanism is a symmetric lattice distortion which takes place as a result of the change in local electric field arising from a change in the trap charge state (electron-photon interaction). This mechanism is especially active in ionic solids. A related phenomenon is an asymmetric distortion called the Jahn-Teller effect. Also electronic processes such as bond formation can lead to shifts in trap energy levels. Polarization of dipoles can also work to shift trap energy levels.

For those skilled in the art, while the charges and energy band diagrams from FIG. 62A through FIG. 66 are largely illustrated for electron conduction near the conduction band EC, it should be understood that the same mechanisms above are equally applicable to hole conduction near the valence band EV as well.

Traps can therefore be charged and discharged in a variety of ways, each mechanism potentially changing the resistance of the memory material. For example, under a high electric field the current carriers can tunnel from an electrode to the traps or between neighboring traps. For another example, the traps can also be charged by trapping free current carriers with lower energy. Clearly, the concentration of the traps, be it by molecular counts; by weight or by volume, will also determine their net total effect on the resistance of the memory material.

The following analytical expressions, while not being a complete set, includes some modeling expressions that have been identified in "Physics of Semiconductor devices," 2nd Edition: S. M. Sze, Publisher: John Wiley & Sons, 1981 to explain the above emissions:

Schottky emission:

$$J = A^*T^2 \; \exp\left[\frac{-q(\phi_B - \sqrt{q\xi / 4\pi\varepsilon_i}}{kT}\right]$$

with a voltage and temperature dependence of $\sim T^2 \exp(+a\sqrt{V}/T - q\phi_B/kT)$

Frenkel-Poole emission:

$$J \sim \xi \; \exp\left[\frac{-q(\phi_B - \sqrt{q\xi/\pi\varepsilon_i})}{kT}\right]$$

with a voltage and temperature dependence of $\sim V \exp(+2a\sqrt{V}/T - q\phi_B/kT)$

Tunnel or field emission:

$$J \sim \xi^2 \; \exp\left[-\frac{4\sqrt{2m^*}(2q\phi_B)^{3/2}}{3qh\xi}\right]$$

with a voltage and temperature dependence of $\sim V^2 \exp(-b/V)$

Ohmic conduction:

$$J \sim \xi \exp(-\Delta E_{ae}/kT)$$

with a voltage and temperature dependence of $\sim V \exp(-c/T)$

Ionic conduction:

$$J \sim (\xi/T)\, \exp(-\Delta E_{ai}/kT)$$

with a voltage and temperature dependence of $\sim \dfrac{V}{T}\, \exp(-d'/T)$

Where:

$A^*$ = effective Richardson constant, $\phi_B$ = barrier height, $\xi$ = electric field, $\varepsilon_i$ = insulator dynamic permittivity, $m^*$ = effective mass, d = insulator thickness, $\Delta E_{ac}$ = activation energy of electrons, $\hbar$ = reduced Planck constant, $\Delta E_{ai}$ = activation energy of ions, and $a \equiv \sqrt{q/(4\pi\varepsilon_i d)}$. $V = \xi d$, J = current density, V = terminal voltage. Positive constants independent of V or T are b, c, and d'.

The fabrication of the trapped charge memory element as described, being basically a multi-layered thin film structure with each film typically of a thickness less than 10 $\mu$m, includes (1) providing a substrate on which to first form the bottom electrode material, (2) forming or depositing the memory material with any of a variety of treatments or conditioning schemes, (3) forming or depositing the top electrode material, and, optionally (4) conditioning the structure with a variety of means. Some specific fabrication processes for the memory element include: Solution based spin on followed by high temperature anneal, pulsed laser deposition (PLD), sputtering, and metalorganic chemical vapor deposition (MOCVD).

Where one or both of the top electrode-to-memory material contact and the bottom electrode-to-memory material contact are made non-ohmic with the addition of diodes, the diodes can be (i) a PN junction diode made of amorphous, microcrystalline, polycrystalline or single crystal semiconductor (e.g. Si, Ge, SiGe, GaAs, InP, etc.); (ii) a metal-semiconductor Schottky diode; (iii) a junction field-effect transistor with gate connected to source (or to drain): (iv) a MOSFET with gate either floating, or connected to source or connected to drain; (v) a Zener diode, avalanche diode, or tunnel diode; (vi) a four-layer diode (SCR); (vii) a P-I-N diode made of amorphous, microcrystalline, polycrystalline or single crystal semiconductor. Yet another implementation comprises a metal-insulator-metal (MIM) tunneling device.

### Concluding Remarks

Although the invention has been described in its presently contemplated best mode, it is clear that it is susceptible to numerous modifications, modes of operation and embodiments, all within the ability and skill of those familiar with the art and without exercise of further inventive activity. For example, some techniques can be applied to other, types of memories that switch fast with a relatively low current or amount of charge, such as chalcogenide, silver dendrite, molecular, polymer or organic memories.

### Claims

1. A non-volatile memory, comprising:

   a plurality of x-direction conductive array lines (105) and a plurality of y-direction conductive array lines (110); a plurality of two-terminal memory plugs (115), wherein the conductive array lines cross one another in a substantially orthogonal orientation and the memory plugs are positioned at intersections of the conductive array lines forming a cross point memory array (100), each memory plug including

   (i) a first electrode (5505) connected with one of the x-direction conductive array lines,
   (ii) a second electrode (5515) connected with one of the y-direction conductive array lines,
   (iii) at least one layer of a conductive oxide (5510) and at least one insulating layer in contact with the at least one layer of conductive oxide (5510), said at least one insulating layer having a thickness operable for tunnelling conduction, the at least one layer of conductive oxide (5510) and the at least one insulating layer positioned between and in electrical communication with the first and second electrodes that can be written from a first state exhibiting a first I-V curve to a second state exhibiting a second I-V curve that is different from the first I-V curve by applying a first write voltage pulse of a first polarity and reversible written from the second state to the first state by applying a second write voltage pulse of a second polarity opposite to the first polarity, the conductive oxide does not experience a change in state when subjected to read voltage pulse that is lower in magnitude than either write voltage pulse, and the conductive oxide does not experience a change in state in the absence of electrical power, and

(iv) a non-ohmic device positioned between and in electrical communication with the first and second electrodes and operable to impart a high resistance for half selected memory plugs and operable to impart a low resistance to selected memory plugs; and

a substrate including active circuitry fabricated on the substrate in electrical communication with the conductive array lines and operable to drive the cross point memory array, the cross point array is in contact with the substrate and is fabricated above the active circuitry so that the active circuitry is positioned below the cross point array.

2. The non-volatile memory as set forth in Claim 1, wherein the at least one layer of the conductive oxide (5510) comprises a first conductive metal oxide layer and a second conductive metal oxide layer that are made from the same type of material and the first and second layers are doped with different concentrations of the same type of dopant.

3. The non-volatile memory as set forth in Claim 1, wherein the at least one layer of the conductive oxide (5510) comprises a conductive metal oxide layer, a top conductive metal oxide layer, and a bottom conductive metal oxide layer that are made from substantially similar materials, the conductive metal oxide layer is positioned between the top and bottom conductive metal oxide layers, and the top and bottom conductive metal oxide layers are doped with dopants having an opposite mobile carrier type.

4. The non-volatile memory as set forth in Claim 1, wherein the active circuitry further comprises:

an adaptive programming circuit (4000) including a detector (4010) coupled with a memory plug selected for a write operation and operative to detect a resistive state of the memory plug and to output an indicating.signal indicative of the resistive state, a controller (4020) coupled with the detector and operative to detect a write command and a write-data, the controller compares the indicating signal with the write data and generates an activating signal only when there is a non-correspondence between the indicating signal and the write-data, and a driver (4030) coupled with the controlled and the memory plug and operative drive the memory plug to a desired resistive state indicative of the write-data in response to the activating signal.

5. The non-volatile memory as set forth in Claim 1, wherein at least a portion of the active circuitry is positioned beneath the cross point array.

6. The non-volatile memory as set forth in Claim 5 and further comprising:

a plurality of x-direction drivers sets (605, 610, 615) operable to drive specific x-direction conductive array lines (425, 430, 435);
and a plurality of y-direction drivers sets (620, 625) operable to drive specific y-direction conductive array lines (440, 445).

7. The non-volatile memory as set forth in Claim 6, wherein the x-direction and y-direction driver sets are a selected one of interdigitated or uon-interdigitated

8. The non-volatile memory as set forth in Claim 1, wherein the cross point array is a stacked cross point array that includes multiple memory plug layers.

9. The non-volatile memory as set forth in Claim 8, wherein at least two memory plug layers share the plurality of y-direction conductive array lines or the plurality of the x-direction conductive array lines.

10. The non-volatile memory as set forth in claim 1, wherein the active circuitry comprises peripheral circuitry in electrical communication with the conductive array lines and operable to apply the first and second write voltage pulses and the read voltage pulse, and to select at least one memory plug, apply the read voltage pulse to the selected memory plug to determine a resistive state of the memory plug, and apply the write voltage pulses to change the resistive state of the memory plug if a write operation to the memory plug is desired and if a write-data associated with the write operation will change the resistive state of the selected memory plug.

11. The non-volatile memory as set forth in Claim 10, wherein the substrate the cross point array is formed on includes a microprocessor fabricated on the substrate.

12. The non-volatile memory as set forth in Claim 10 and further comprising:

a control bus (3740) that carries a write enable signal pulse when a write operation to the cross point array is desired, the write enable signal pulse having an end;
an address bus (3730) that carries signals indicative of a selected memory plug or a group of selected memory plugs; and
a data bus (3760) that carries signals indicative of a write-data relating to the selected memory plug or the group of selected memory plugs, and
wherein the peripheral circuitry does not apply the first and second write voltage pulses that are operable to change the resistive state of the selected memory plug or the, group of selected memory plugs until after the write enable signal pulse has ended.

13. The non-volatile memory as set forth in Claim 10, wherein data is read from or written to the cross point array in a mode selected from the group consisting of a page mode and a burst mode.

14. The non-volatile memory as set forth in Claim 1 or 10, wherein the conductive oxide comprises a perovskite.

15. The non-volatile memory as set forth in Claim 1, wherein the non-ohmic device comprises a pair of back-to-back diodes.

16. The non-volatile memory as set forth in Claim 1, wherein the non-ohmic device comprises a plurality of thin film layers including at least one insulating layer and at least one conductive layer.

17. The non-volatile memory as set forth in Claim 16, wherein the plurality of thin film layers comprises a metal-insulator-metal structure including a first thin film layer of a conductive material, a thin film layer of an insulating material, and a second thin film layer of a conductive material.

18. The non-volatile memory as set forth in Claim 1, wherein the first and second electrodes comprise at least one layer of material selected from the group consisting of a metal, a refractory metal, a precious metal, and a conductive oxide.

19. The non-volatile memory as set forth in Claim 18, wherein the at least one layer of material operatively performs a function selected from the group consisting of a diffusion barrier, an adhesion layer, a glue layer, a seed layer, and a stress relief layer.

**Patentansprüche**

1. Nicht-flüchtiger Speicher, umfassend:

mehrere leitfähige Anordnungsleitungen (105) in x-Richtung und mehrere leitfähige Anordnungsleitungen (110) in y-Richtung;
mehrere Speicherkerne (115) mit zwei Anschlüssen, wobei die leitfähigen Anordnungsleitungen einander in einer im Wesentlichen senkrechten Ausrichtung kreuzen und die Speicherkerne an Kreuzungsstellen der leitfähigen Anordnungsleitungen angeordnet sind, welche eine Kreuzungspunktspeicheranordnung (100) bilden, wobei jeder Speicherkern aufweist

(i) eine erste Elektrode (5505), welche mit einer der leitfähigen Anordnungsleitungen in x-Richtung verbunden ist,
(ii) eine zweite Elektrode (5515), welche mit einer der leitfähigen Anordnungsleitungen in y-Richtung verbunden ist,
(iii) mindestens eine Schicht eines leitfähigen Oxyds (5510) und mindestens eine isolierende Schicht in Kontakt mit der mindestens einen Schicht des leitfähigen Oxyds (5510), wobei die mindestens eine isolierende Schicht eine Dicke aufweist, welche für eine Tunnelleitung ausgestaltet ist, wobei mindestens eine Schicht aus leitendem Oxyd (5510) und die mindestens eine isolierende Schicht, welche zwischen und in elektrischer Verbindung mit der ersten und der zweiten Elektrode angeordnet ist, von einem ersten Zustand, welcher eine erste I-V Kurve aufweist, zu einem zweiten Zustand, welcher eine zweite I-V Kurve aufweist, die unterschiedlich zu der ersten I-V Kurve ist, durch Anlegen eines ersten Schreibspannungsimpulses einer ersten Polarität geschrieben und umgekehrt von dem zweiten Zustand zu dem ersten Zustand durch Anlegen eines zweiten Schreibspannungsimpulses einer zweiten Polarität entgegengesetzt zu der ersten Polarität geschrieben werden können, wobei das leitfähige Oxyd keine Zustandsänderung erfährt, wenn es einem Lesespannungsimpuls ausgesetzt wird, welcher einen kleineren Betrag als jeder Schreibspannungsimpuls aufweist, und wobei das leitfähige Oxyd bei der Abwesenheit von elektrischer Energie keine Zustandsänderung erfährt, und

(iv) eine nicht-ohmsche Vorrichtung, welche zwischen und in elektrischer Verbindung mit der ersten und der zweiten Elektrode angeordnet ist und ausgestaltet ist, einen hohen Widerstand für halb ausgewählte Speicherkerne hervorzurufen, und ausgestaltet ist, einen niedrigen Widerstand für ausgewählte Speicherkerne hervorzurufen; und

ein Substrat, welches einen aktiven Schaltkreis aufweist, welcher auf dem Substrat in elektrischer Verbindung mit den leitfähigen Anordnungsleitungen hergestellt ist und ausgestaltet ist, die Kreuzungspunktspeicheranordnung anzusteuern, wobei die Kreuzungspunktanordnung in Kontakt mit dem Substrat ist und über dem aktiven Schaltkreis derart hergestellt ist, dass der aktive Schaltkreis unterhalb der Kreuzungspunktanordnung angeordnet ist.

2. Nicht-flüchtiger Speicher nach Anspruch 1, wobei die mindestens eine Schicht aus dem leitfähigen Oxyd (5510) eine erste leitfähige Metalloxydschicht und eine zweite leitfähige Metalloxydschicht umfasst, welche aus der gleichen Art von Material gefertigt sind, und wobei die erste und die zweite Schicht mit unterschiedlichen Konzentrationen der gleichen Art einer Dotiersubstanz dotiert sind.

3. Nicht-flüchtiger Speicher nach Anspruch 1, wobei die mindestens eine Schicht aus dem leitfähigen Oxyd (5510) eine leitfähige Metalloxydschicht, eine obere leitfähige Metalloxydschicht und eine untere leitfähige Metalloxydschicht umfasst, welche aus im Wesentlichen ähnlichen Materialien gefertigt sind, wobei die leitfähige Metalloxydschicht zwischen der oberen und der unteren leitfähigen Metalloxydschicht angeordnet ist, und wobei die obere und die untere leitfähige Metalloxydschicht mit Dotiersubstanzen dotiert sind, welche eine entgegengesetzte Art beweglicher Träger aufweisen.

4. Nicht-flüchtiger Speicher nach Anspruch 1, wobei der aktive Schaltkreis ferner umfasst:

eine adaptive Programmierschaltung (4000) umfassend einen mit einem Speicherkern gekoppelten Detektor (4010), welcher für einen Schreibbetrieb ausgewählt wird und ausgestaltet ist, einen Widerstandszustand des Speicherkerns zu erfassen und ein Anzeigesignal auszugeben, welches den Widerstandszustand anzeigt, eine Steuerung (4020), welcher mit dem Detektor gekoppelt ist und ausgestaltet ist, einen Schreibbefehl und einen Schreibwert zu erfassen, wobei die Steuerung das Anzeigesignal mit dem Schreibwert vergleicht und nur ein Aktivierungssignal erzeugt, wenn keine Übereinstimmung zwischen dem Anzeigesignal und dem Schreibwert besteht, und einen Treiber (4030), welcher mit der Steuerung und dem Speicherkern gekoppelt ist und ausgestaltet ist, den Speicherkern in Abhängigkeit von dem Aktivierungssignal auf einen gewünschten Widerstandszustand zu treiben, welcher den Schreibwert anzeigt.

5. Nicht-flüchtiger Speicher nach Anspruch 1, wobei mindestens ein Abschnitt des aktiven Schaltkreises unterhalb der Kreuzungspunktanordnung angeordnet ist.

6. Nicht-flüchtiger Speicher nach Anspruch 5 und ferner umfassend:

mehrere Treibergruppen (605, 610, 615) für die x-Richtung, welche ausgestaltet sind, spezielle leitfähige Anordnungsleitungen (425, 430, 435) in x-Richtung anzusteuern; und mehrere Treibergruppen (620, 625) für die y-Richtung, welche ausgestaltet sind, spezielle leitfähige Anordnungsleitungen (440, 445) in y-Richtung anzusteuern.

7. Nicht-flüchtiger Speicher nach Anspruch 6, wobei die Treibergruppen für die x-Richtung und y-Richtung eine ausgewählte einer ineinandergreifenden oder einer nichtineinandergreifenden sind.

8. Nicht-flüchtiger Speicher nach Anspruch 1, wobei die Kreuzungspunktanordnung eine gestapelte Kreuzungspunktanordnung ist, welche mehrere Speicherkernschichten aufweist.

9. Nicht-flüchtiger Speicher nach Anspruch 8, wobei mindestens zwei Speicherkernschichten die mehreren leitfähigen Anordnungsleitungen in y-Richtung oder die mehreren der leitfähigen Anordnungsleitungen in x-Richtung gemeinsam verwenden.

10. Nicht-flüchtiger Speicher nach Anspruch 1, wobei der aktive Schaltkreis einen Peripherieschaltkreis umfasst, welcher in einer elektrischen Verbindung mit den leitfähigen Anordnungsleitungen ist und ausgestaltet ist, den ersten und den zweiten Schreibspannungsimpuls und den Lesespannungsimpuls aufzubringen und mindestens einen Speicherkern auszuwählen, den Lesespannungsimpuls an den ausgewählten Speicherkern anzulegen, um einen Widerstandszustand des Speicherkerns zu bestimmen, und die Schreibspannungsimpulse anzulegen, um den Widerstandszustand des Speicherkerns zu ändern, wenn ein Schreibvorgang für den Speicherkern gewünscht ist und wenn ein Schreibwert, welcher dem Schreibvorgang zugeordnet ist, den Widerstandszustand des ausgewählten Speicherkerns ändern wird.

11. Nicht-flüchtiger Speicher nach Anspruch 10, wobei das Substrat, auf welchem die Kreuzungspunktanordnung ausgebildet ist, einen auf dem Substrat hergestellten Mikroprozessor aufweist.

12. Nicht-flüchtiger Speicher nach Anspruch 10 und ferner umfassend:

einen Steuerbus (3740), welcher einen Schreibfreigabesignalimpuls überträgt, wenn ein Schreibvorgang für die Kreuzungspunktanordnung gewünscht ist, wobei der Schreibfreigabesignalimpuls ein Ende aufweist;
einen Adressbus (3730), welcher Signale überträgt, welche einen ausgewählten Speicherkern oder eine Gruppe von ausgewählten Speicherkernen anzeigen; und
einen Datenbus (3760), welcher Signale überträgt, welche einen Schreibwert anzeigen, welcher sich auf den ausgewählten Speicherkern oder die Gruppe von ausgewählten Speicherkernen bezieht, und
wobei der Peripherieschaltkreis den ersten und den zweiten Schreibspannungsimpuls, welche ausgestaltet sind, den Widerstandswert des ausgewählten Speicherkerns oder der Gruppe von ausgewählten Speicherkernen zu ändern, nicht anlegt bis der Schreibfreigabesignalimpuls beendet ist.

13. Nicht-flüchtiger Speicher nach Anspruch 10, wobei ein Wert in einer Betriebsart, welche aus der Gruppe bestehend aus einer Seitenbetriebsart und einer Blockbetriebsart ausgewählt ist, aus der Kreuzungspunktanordnung gelesen oder in die Kreuzungspunktanordnung geschrieben wird.

14. Nicht-flüchtiger Speicher nach Anspruch 1 oder 10, wobei das leitfähige Oxyd einen Perowskit umfasst.

15. Nicht-flüchtiger Speicher nach Anspruch 1, wobei die nicht-ohmsche Vorrichtung ein Paar von aufeinanderfolgenden Dioden umfasst.

16. Nicht-flüchtiger Speicher nach Anspruch 1, wobei die nicht-ohmsche Vorrichtung mehrere Dünnfilmschichten umfasst, welche mindestens eine isolierende Schicht und mindestens eine leitfähige Schicht aufweisen.

17. Nicht-flüchtiger Speicher nach Anspruch 16, wobei die mehreren Dünnfilmschichten eine Metall-Isolator-Metall-Struktur umfassen, welche eine erste Dünnfilmschicht aus einem leitfähigen Material, eine Dünnfilmschicht aus einem isolierenden Material und eine zweite Dünnfilmschicht aus einem leitfähigen Material aufweist.

18. Nicht-flüchtiger Speicher nach Anspruch 1, wobei die erste und die zweite Elektrode mindestens eine Schicht aus einem Material umfassen, welches aus der Gruppe bestehend aus einem Metall, einem hitzebeständigen Metall, einem Edelmetall und einem leitfähigen Oxyd ausgewählt wird.

19. Nicht-flüchtiger Speicher nach Anspruch 18, wobei die mindestens eine Schicht aus einem Material funktionsfähig eine Funktion ausführt, welche aus der Gruppe bestehend aus einer Diffusionssperre, einer Haftschicht, einer Klebeschicht, einer Impfschicht und einer Spannungsentlastungsschicht ausgewählt ist.

**Revendications**

1. Mémoire non volatile, comprenant :

une pluralité de lignes de réseau conductrices dans la direction x (105) et une pluralité de lignes de réseau conductrices dans la direction y (110) ;
une pluralité de fiches de mémoire à deux bornes (115), dans lesquelles les lignes de réseau conductrices se croisent dans une orientation sensiblement orthogonale et les fiches de mémoire sont positionnées à des intersections des lignes de réseau conductrices formant un réseau de mémoire à points de croisement (100), chaque fiche de mémoire comprenant

(i) une première électrode (5505) connectée à l'une des lignes de réseau conductrices dans la direction x,
(ii) une seconde électrode (5515) connectée à l'une des lignes de réseau conductrices dans la direction y,
(iii) au moins une couche d'un oxyde conducteur (5510) et au moins une couche isolante en contact avec l'au moins une couche d'oxyde conducteur (5510), ladite au moins une couche isolante ayant une épaisseur permettant une conduction par effet tunnel, l'au moins une couche d'oxyde conducteur (5510) et l'au moins une couche isolante étant positionnées entre et en contact électrique avec les première et seconde électrodes qui peuvent être écrites d'un premier état présentant une première courbe I-V à un second état présentant une seconde courbe I-V différente de la première courbe I-V en appliquant une première impulsion de tension d'écriture ayant une première polarité et réécrites du second état au premier état en appliquant une seconde impulsion de tension d'écriture ayant une seconde polarité opposée à la première polarité, l'oxyde conducteur ne changeant pas d'état lorsqu'il est soumis à une impulsion de tension de lecture inférieure en amplitude à l'une ou l'autre des impulsions de tension de lecture, et l'oxyde conducteur ne changeant pas d'état en l'absence d'alimentation électrique, et
(iv) un dispositif non ohmique positionné entre et en contact électrique avec les première et seconde électrodes et permettant de fournir une forte résistance pour les fiches de mémoire mi-sélectionnées et permettant de fournir une faible résistance pour les fiches de mémoire sélectionnées ; et

un substrat comprenant un circuit actif fabriqué sur le substrat en contact électrique avec les lignes de réseau conductrices et permettant d'actionner le réseau de mémoire à points de croisement, le réseau à points de croisement étant en contact avec le substrat et étant fabriqué au-dessus du circuit actif de sorte que le circuit actif est positionné en dessous du réseau à points de croisement.

2. Mémoire non volatile selon la revendication 1, dans laquelle l'au moins une couche d'oxyde conducteur (5510) comprend une première couche d'oxyde métallique conducteur et une seconde couche d'oxyde métallique conducteur qui sont formées à partir du même type de matériau et les première et seconde couches sont dopées avec des concentrations différentes du même type de matériau dopant.

3. Mémoire non volatile selon la revendication 1, dans laquelle l'au moins une couche d'oxyde conducteur (5510) comprend une couche d'oxyde métallique conducteur, une couche d'oxyde métallique conducteur supérieure et une couche d'oxyde métallique conducteur inférieure qui sont formées à partir de matériaux sensiblement similaires, la couche d'oxyde métallique conducteur étant positionnée entre les couches d'oxyde métallique conducteur supérieure et inférieure, et les couches d'oxyde métallique conducteur supérieure et inférieure étant dopées avec des matériaux dopants ayant un type de support mobile opposé.

4. Mémoire non volatile selon la revendication 1, dans laquelle le circuit actif comprend en outre :

un circuit de programmation adaptatif (4000) comprenant un détecteur (4010) couplé à une fiche de mémoire sélectionnée pour une opération d'écriture et permettant de détecter un état résistif de la fiche de mémoire et de produire un signal indicatif indiquant l'état résistif, un dispositif de commande (4020) couplé au détecteur et permettant de détecter une commande d'écriture et une donnée d'écriture, le dispositif de commande comparant le signal indicatif avec la donnée d'écriture et générant un signal d'activation seulement lorsqu'il existe une non-correspondance entre le signal indicatif et la donnée d'écriture, et un actionneur (4030) couplé au dispositif de commande et à la fiche de mémoire et permettant d'actionner la fiche de mémoire vers un état résistif souhaité indiquant la donnée d'écriture en réponse au signal d'activation.

5. Mémoire non volatile selon la revendication 1, dans laquelle au moins une partie du circuit actif est positionnée en dessous du réseau à points de croisement.

**6.** Mémoire non volatile selon la revendication 5 et comprenant en outre :

une pluralité d'ensembles d'actionneurs dans la direction x (605, 610, 615) permettant d'actionner des lignes de réseau conductrices dans la direction x (425, 430, 435) spécifiques ;
et une pluralité d'ensembles d'actionneurs dans la direction y (620, 625) permettant d'actionner des lignes de réseau conductrices dans la direction y (440, 445) spécifiques.

**7.** Mémoire non volatile selon la revendication 6, dans laquelle les ensembles d'actionneurs dans la direction x et dans la direction y sont soit interdigités soit non interdigités.

**8.** Mémoire non volatile selon la revendication 1, dans laquelle le réseau à points de croisement est un réseau à points de croisement empilé qui comprend plusieurs couches de fiches de mémoire.

**9.** Mémoire non volatile selon la revendication 8, dans laquelle au moins deux couches de fiches de mémoire partagent la pluralité de lignes de réseau conductrices dans la direction y ou la pluralité de lignes de réseau conductrices dans la direction x.

**10.** Mémoire non volatile selon la revendication 1, dans laquelle le circuit actif comprend un circuit périphérique en contact électrique avec les lignes de réseau conductrices et permettant d'appliquer les première et seconde impulsions de tension d'écriture et l'impulsion de tension de lecture, et de sélectionner au moins une fiche de mémoire, appliquer l'impulsion de tension de lecture à la fiche de mémoire sélectionnée pour déterminer un état résistif de la fiche de mémoire, et appliquer les impulsions de tension d'écriture pour changer l'état résistif de la fiche de mémoire si une opération d'écriture sur la fiche de mémoire est souhaitée et si une donnée d'écriture associée à l'opération d'écriture doit changer l'état résistif de la fiche de mémoire sélectionnée.

**11.** Mémoire non volatile selon la revendication 10, dans laquelle le substrat sur lequel est formé le réseau à points de croisement comprend un microprocesseur fabriqué sur le substrat.

**12.** Mémoire non volatile selon la revendication 10 et comprenant en outre :

un bus de commande (3740) qui porte une impulsion de signal d'autorisation d'écriture lorsqu'une opération d'écriture sur le réseau à points de croisement est souhaitée, l'impulsion de signal d'autorisation d'écriture ayant une fin ;
un bus d'adresse (3730) qui porte des signaux indiquant une fiche de mémoire sélectionnée ou un groupe de fiches de mémoire sélectionnées ; et
un bus de données (3760) qui porte des signaux indiquant une donnée d'écriture relative à la fiche de mémoire sélectionnée ou au groupe de fiches de mémoire sélectionnées, et
dans laquelle le circuit périphérique n'applique les première et seconde impulsions de tension d'écriture permettant de changer l'état résistif de la fiche de mémoire sélectionnée ou du groupe de fiches de mémoire sélectionnées qu'après la fin de l'impulsion de signal d'autorisation d'écriture.

**13.** Mémoire non volatile selon la revendication 10, dans laquelle des données sont lues depuis ou écrites sur le réseau à points de croisement dans un mode sélectionné dans le groupe constitué par un mode page et un mode rafale.

**14.** Mémoire non volatile selon la revendication 1 ou 10, dans laquelle l'oxyde conducteur comprend une pérovskite.

**15.** Mémoire non volatile selon la revendication 1, dans laquelle le dispositif non ohmique comprend une paire de diodes placées dos à dos.

**16.** Mémoire non volatile selon la revendication 1, dans laquelle le dispositif non ohmique comprend une pluralité de couches de film mince comprenant au moins une couche isolante et au moins une couche conductrice.

**17.** Mémoire non volatile selon la revendication 16, dans laquelle la pluralité de couches de film mince comprend une structure métal-isolant-métal comprenant une première couche de film mince d'un matériau conducteur, une couche de film mince d'un matériau isolant, et une seconde couche de film mince d'un matériau conducteur.

**18.** Mémoire non volatile selon la revendication 1, dans laquelle les première et seconde électrodes comprennent au moins une couche de matériau sélectionné dans le groupe constitué par un métal, un métal réfractaire, un métal précieux, et un oxyde conducteur.

**19.** Mémoire non volatile selon la revendication 18, dans laquelle l'au moins une couche de matériau exécute fonctionnellement une fonction sélectionnée dans le groupe constitué par une barrière à la diffusion, une couche d'adhésion, une couche de colle, une couche de germe, et une couche de relaxation des contraintes.

FIG. 1

100

230    210    235    240

220

215

205

225

Unselected

SELECTED

Unselected

Unselected    SELECTED    Unselected    Unselected

FIG. 2

210

305

215

205

FIG.3

400

420

435

415

430

410

425

405

445

440

FIG. 4A

400

435

$X_2$

420

445

$ML_3$

415

$Y_1$

430

$ML_2$

$X_1$

410

440

$ML_1$

$Y_0$

405

425

$ML_0$

$X_0$

FIG. 4B

FIG. 5

FIG. 6A

FIG. 6B

$X_2$  $X_1$  $X_0$

400

615  610  605  $Y_0$

620

625

$Y_1$

FIG. 7A

400

| X2 | X1 | X0 | |
|---|---|---|---|

620

Y0

625

Y1

615  610  605

FIG. 7B

FIG. 8A

FIG. 8B

FIG. 9A

FIG. 9B

FIG. 10A

FIG. 10B

50

Y     810

X    100    X

805     805

Y     810

**FIG. 11A**

X    810    Y    X

805    X    100    X    805

X    810    Y    X

**FIG. 11B**

810    Y

X    Y

805    X    100    X    805

Y    X

Y    810

**FIG. 11C**

FIG. 12

FIG. 13A

FIG. 13B

FIG. 14A

FIG. 14B

FIG. 15A

FIG. 15B

FIG. 16

FIG. 17

FIG. 18A

FIG. 18B

FIG. 19

To Secondary Decoder
and/or Other Drivers

1915

2010

To Primary
Decoder

To Conductive
Array Line

2005

2015

To Secondary Decoder
and/or Other Drivers

## FIG. 20A

2005

1915

2010

2015

2035

2025

2030

2020

1925

## FIG. 20B

EP 1 743 340 B1

FIG. 21A

FIG. 21B

61

FIG. 22

FIG. 23A

FIG. 23B

EP 1 743 340 B1

FIG. 24

PERIPHERAL CIRCUITRY

400

435

420

445

415

410

440

405

2435

2410

2440

2430

2405    430

2425

2420

2415

425

EP 1 743 340 B1

64

FIG. 25A

FIG. 25B

FIG. 26A

FIG. 26B

FIG. 26C

FIG. 26D

FIG. 26E

FIG. 27

## Discharge at start of write select signal

Write Enable #

Address

Data

Internal Discharge Signal

## FIG. 28

## · Discharge at end of write select signal

Write Enable #

Address

Data

Internal Discharge Signal

## FIG. 29

## Discharge at end of write operation

Write Enable #

Address

Data

Internal Write
Timer Pulse

Internal Discharge
Signal

## FIG. 30

## Discharge at start of write select signal and end of write select operation

Write Enable #

Address

Data

Internal Discharge
Signal

Internal Write
Timer Pulse

## FIG. 31

## Discharge during signal transitions

Write Enable #

Address

Data

Internal Discharge
Signal

### FIG. 32

## Discharge with delayed addresses

Address

Transition Signal
for First Address

Transition Signal for
Second Address

Transition Signal
for Third Address

OR'd Transition
Signal

X, Y Lines
Discharge Signal

X, Y Lines

Delayed Address
Bus

X, Y Lines With
Delayed Addresses

### FIG. 33

3400

3410

3405

Input signal

output
signal

Inversion and delay

3415

3420

FIG. 34A

## Signal Transition Detection Timing Diagram

Input signal

Delayed inverted
signal

Output signal

FIG. 34B

FIG. 35

**FIG. 36**

EP 1 743 340 B1

3700

3705

3730

Address
<16:0>

Address <16:6>

Control
signals

3740

Power
Supplies:

Vwr1

Vwr0

Vread

Vcc, gnd

3750

| 3770 X Block | Array 512 x 256 (1/8 Mb) 3720 |

| 3710 Sense Amp | Y Block 3780 |

Address <5:0>

Data Bit In

DQ 7:0

Buffer / Driver

Data Bit Out

3760

3790

FIG. 37A

3705

3730

Address
<16:0>

Address <16:6>

Control
signals

Power
Supplies:

Vwr1
Vwr0
Vread

Vcc, gnd

3740

3750

DQ 7:0

Data Bit Out

3760

3770

X Block

3715

Sense
Amps

3720

Array
512 x 256
(1/8 Mb)

3780

Y Block

Address <5:0>

Data
Bits In

Page Register/Buffer / Driver

3795

. . .

FIG. 37B

**FIG. 38A**

**FIG. 38B**

| Page latch data | | During Wr. "1" cycle | During Wr. "0" cycle |
|---|---|---|---|
| 1 | Input of "1" driver: | 1 | 0 |
| | Input of "0" driver: | 0 | 0 |
| 0 | Input of "1" driver: | 0 | 0 |
| | Input of "0" driver: | 0 | 1 |
| Where "1" on the driver input signifies that the driver is enabled. | | | |

**FIG. 38C**

FIG. 39A

FIG. 39B

FIG. 40

4120

Program
Supply

4100

4125

Data driver with
current detector

4130

4105

Reference
driver

4115

A

B

Comparator

Memory Array

reference

4110

FIG. 41A

4120

4150

Program
Supply

4110

reference

B

4115

Comparator

A

Data driver with
voltage detector

4155

Memory Array

20

FIG. 41B

FIG. 42

FIG. 43

**FIG. 44**

**FIG. 45**

4600

4610          4625

4605

4615          4630

4620

4635          4640

FIG. 46

4700

4710          4725

4705

4715          4730

4720

4735          4740

FIG. 47

FIG. 48

FIG. 49

FIG. 50

FIG. 51

FIG. 52

5300

**FIG. 53**

5400

**FIG. 54**

5500

5520

5515

5510

5505

5415
W

5405

5335

5305

5420
W

5410

GATE

N+ 5330

N+ 5325

P-WELL

5320

N-WELL

5315

P-SUBSTRATE

5310

**FIG. 55**

5600

**FIG. 56**

5700

**FIG. 57**

FIG. 58

**FIG. 59A**

**FIG. 59B**

**FIG. 59C**

**FIG. 59D**

**FIG. 59E**

6000

5720

5715

5725

5710

5705

5610  5625

5620        5615  5605

5520

5515

5540      5510

5505

5415        5405        5335      5305      5420        5410

W                                        W

GATE

N+    5330                    N+    5325

P-WELL                            5320

N-WELL                            5315

P-SUBSTRATE                  5310

FIG. 60

FIG. 61 (Prior Art)

FIG. 62A

FIG. 62B

**FIG. 63**

**FIG. 64**

**FIG. 65**

**FIG. 66**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6204139 B, Liu
- US 6531371 B
- EP 1376598 A
- US 2003003675 A

### Non-patent literature cited in the description

- Electric-pulse-induced reversible resistance change effect in magnetoresistive films. *Applied Physics Letters,* 08 May 2000, vol. 76 (19
- Reproducible switching effect in thin oxide films for memory applications. *Applied Physics Letters,* 03 July 2000, vol. 77 (1
- Current-driven insulator-conductor transition and nonvolatile memory in chromium-doped SrTi03 single crystals. *Applied Physics Letters,* 04 June 2001, vol. 78 (23
- Electric current distribution across a metal-insulator-metal structure during bistable switching. *Journal of Applied Physics,* 15 September 2001, vol. 90 (6
- **J.G. Simmons ; R.R. Verderber.** New Conduction and Reversible Memory Phenomena in Thin Insulating Films. *Proc. Roy. Soc. A.,* 1967, vol. 301, 77-102
- **R E. Thurstans ; D. P. Oxley.** The Electroformed metal-insulator-metal structure: a comprehensive model. *J. Phys. D: Appl. Phys.,* 02 April 2002, vol. 35, 802-809
- **S.I. Khartsev et al.** Colossal magnetoresistance in ultrathin epitaxial La0.75Sr0.25MnO3 films. *Journal of Applied Physics,* 01 March 2000, vol. 87 (5
- **Y. G. Zhao et al.** Effect of oxygen content on the structural, transport, and magnetic properties of La1-δMn1-δO3 thin films. *Journal of Applied Physics,* 01 December 1999, vol. 86 (11
- **Guo-Qiang Gong et al.** Colossal magnetoresistance of 1000000-fold magnitude achieved in the antiferromagnetic phase of La1-xCaxMnO. *Applied Physics Letters,* 18 September 1995, vol. 67 (12
- **Sze S.M.** *Physics of Semiconductor Devices,* 1981, 537-539
- **P. Koidl et al.** Photochromism in Ni-doped SrTiO3. *Physical review B,* 07 October 1976, vol. 14 (7), 2703-2708
- **S. A. Basun et al.** Photoinduced Phenomina in Sr1-xCaxTi02, 0 <= x <= 0,12. *Ferroelectrics,* 1996, vol. 183, 255-264
- **Rainer Waser et al.** DC Electrical Degradation of Perovskite-Type Titanates (Ceramics, Single Crystal, A Model of the Mechanism): I, II & III. *J. Am. Ceram. Soc.,* 1990, vol. 73 (6), 1645-1663
- **J.G. Simmons ; R. R. Verderber.** New conduction and reversible memory phenomena in thin insulating films. *Proc. Roy. Soc. A.,* 1967, vol. 301, 77-102
- **S. M. Sze.** Physics of Semiconductor devices. John Wiley & Sons, 1981